(19) **Europäisches Patentamt** / **European Patent Office** / **Office européen des brevets**

(11) **EP 4 663 809 A2**

(12) **EUROPEAN PATENT APPLICATION**

(43) Date of publication:
**17.12.2025 Bulletin 2025/51**

(21) Application number: **25177466.7**

(22) Date of filing: **19.05.2025**

(51) International Patent Classification (IPC):
**C23C 16/40** (2006.01)   **C23C 16/448** (2006.01)
**C23C 16/452** (2006.01)

(52) Cooperative Patent Classification (CPC):
**C23C 16/401; C23C 16/403; C23C 16/407;
C23C 16/448; C23C 16/452**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.05.2024 US 202463651749 P
13.05.2025 US 202519206942**

(71) Applicant: **Silanna UV Technologies Pte Ltd
Singapore 049315 (SG)**

(72) Inventor: **ATANACKOVIC, Petar
Adelaide (AU)**

(74) Representative: **Haseltine Lake Kempner LLP
One Portwall Square
Portwall Lane
Bristol BS1 6BH (GB)**

(54) **BINARY-OXIDE VAPOR SOURCE AND METHOD AND SYSTEM FOR USING SAME**

(57) The techniques described herein relate to a method for generating a binary-oxide vapor precursor for a deposition process including: providing a binary-oxide vapor source; heating the binary-oxide vapor source to form an elemental vapor from an elemental component contained therein; and reacting the elemental vapor with solid binary-oxide members contained therein. The binary-oxide vapor source can include: a closed end and an open end; a first region located adjacent to the closed end including the elemental component; and a second region located between the first region and the open end, the second region including a contained aggregate structure including the solid binary-oxide members and spaces through which a vapor can pass. In some aspects, the techniques described herein relate to a material deposition system including the binary-oxide vapor source coupled to a growth chamber.

**FIG. 1**

**Description**

**RELATED APPLICATIONS**

This application claims the benefit of U.S. Non-Provisional Patent Application No. 19/206,942 filed on May 13, 2025, and entitled "BINARY-OXIDE VAPOR SOURCE AND METHOD AND SYSTEM FOR USING SAME", which claims the benefit of U.S. Provisional Patent Application No. 63/651,749 filed on May 24, 2024, and entitled "BINARY-OXIDE VAPOR SOURCE AND METHOD AND SYSTEM FOR USING SAME;" all of which are hereby incorporated by reference for all purposes.

**BACKGROUND**

Various deposition processes rely on the generation of precursor materials which together form a layer of a desired chemical compound when combined at a deposition surface. For the deposition of oxide layers, traditionally a first source provides the non-oxide component in vapor form and the other source provides an activated form of oxygen (e.g., oxygen plasma, ozone, atomic oxygen, etc.) able to donate single oxygen atoms to form the oxide layer at the deposition surface. Generating this activated form of oxygen is energy intensive which limits the scale at which these oxide deposition processes can operate.

**SUMMARY**

In some aspects, the techniques described herein relate to a method for generating a binary-oxide vapor precursor, including: containing an elemental component in an open-ended vessel including a closed end and a vessel wall that extends from the closed end to an open end; introducing solid binary-oxide members into the open-ended vessel to form a contained aggregate structure of the solid binary-oxide members within the vessel wall, wherein at least a portion of the solid binary-oxide members are between the elemental component and the open end of the open-ended vessel; and heating the elemental component to form an elemental vapor that travels towards the open end of the open-ended vessel, wherein on transiting towards the open end the elemental vapor reacts with the contained aggregate structure of the solid binary-oxide members to generate a binary-oxide vapor precursor.

In some aspects, the techniques described herein relate to a binary-oxide vapor source, including: a vessel having a closed end and an open end; a first region located adjacent to the closed end including or configured to include an elemental component; a first heater zone configured to heat the first region to produce an elemental vapor from the elemental component; and a second region located between the first region and the open end, the second region including or is configured to include: solid binary-oxide members; and spaces adjacent to the solid binary-oxide members through which the elemental vapor can pass, wherein a product of a reaction between the elemental vapor and the solid binary-oxide members is a binary-oxide vapor precursor, and wherein the solid binary-oxide members and the spaces are configured such that the binary-oxide vapor precursor formed in the spaces can exit the binary-oxide vapor source through the open end.

In some aspects, the techniques described herein relate to a method for generating a binary-oxide vapor precursor for a deposition process, including: providing a binary-oxide vapor source including: a closed end and an open end; a first region located adjacent to the closed end including an elemental component; and a second region located between the first region and the open end, the second region including a contained aggregate structure including solid binary-oxide members and spaces through which a vapor can pass; heating the binary-oxide vapor source to form an elemental vapor from the elemental component; and reacting the elemental vapor with the solid binary-oxide members, as the elemental vapor passes through the spaces in the second region, to produce a binary-oxide vapor precursor that exits the binary-oxide vapor source through the open end.

In some aspects, the techniques described herein relate to a material deposition system, including: a binary-oxide vapor source, including: a closed end and an open end; a first region located adjacent to the closed end including or configured to include an elemental component; a first heater zone configured to heat the first region to produce an elemental vapor from the elemental component; and a second region located between the first region and the open end, the second region including or is configured to include solid binary-oxide members and spaces adjacent to the solid binary-oxide members through which the elemental vapor can pass, wherein a product of a reaction between the elemental vapor and the solid binary-oxide members is a binary-oxide vapor precursor; and a growth chamber coupled to the open end of the binary-oxide vapor source; wherein the binary-oxide vapor precursor can exit the open end of the binary-oxide vapor source and enter the growth chamber.

## BRIEF DESCRIPTION OF DRAWINGS

Examples of the present disclosure will be discussed with reference to the accompanying drawings.

FIG. 1 is a figurative view of a binary-oxide vapor source for generating a binary-oxide vapor precursor in accordance with some embodiments.

FIG. 2 is a plot of the expected vapor partial pressures as a function of cell temperature for a selection of binary-oxide vapor precursors in accordance with some examples.

FIG. 3 is a figurative view showing the geometry for forming an aggregate structure comprised of substantially spherical granules having a predetermined size distribution in accordance with some examples.

FIG. 4 is a plot of two different probability distributions of granule or bead size as a function of bead radius for a given nominal radius in accordance with some examples.

FIG. 5A is a 3D plot of an aggregate structure comprising a close packed column of granules whose size varies in accordance with a Weibull distribution having a b parameter of 3 (see FIG. 4) showing the resulting packing density in accordance with some examples. The variation in greyscale depicts the possible wetting of a lower liquid material upward into the packed column thereby forming a plurality of regions.

FIG. 5B is a 3D plot of an aggregate structure comprising a close packed column of granules whose size varies in accordance with a Weibull distribution having a b parameter of 9 (see FIG. 4) showing the resulting packing density in accordance with some examples. The variation in greyscale depicts the possible wetting of a lower liquid material upward into the packed column thereby forming a plurality of regions.

FIG. 6A is a figurative sectional view of a binary-oxide vapor source indicating the ejected precursor angular emission distribution in accordance with some examples. The source cross-section depicts a plurality of regions or zones comprising the vessel that is further operably coupled to a precursor beam forming region along with thermal sources for heating the vessel.

FIGS. 6B-6C show various views of outlet configurations that may be used for the formation of a predetermined beam flux profile emanating from a binary-oxide vapor source of the present disclosure in accordance with some examples.

FIGS. 6D-6E show side views of example emission distribution profiles of binary-oxide vapor precursors from outlets in accordance with some examples.

FIG. 7 is a plot of the calculated Gibbs free energy activity (equilibrium coefficient) as a function of temperature for various active oxygen containing species in accordance with some examples.

FIGS. 8A and 8B show schematic examples of deposition systems comprising a binary-oxide vapor source and an active oxygen containing species source for depositing an oxide layer on a substrate in a growth chamber in accordance with some examples.

FIGS. 9A-9C show plots of the modelled partial pressures of $Ga_2O$, $GaO$ and $O_2$ at the exit aperture of a $Ga_2O$ precursor vapor cell as a function of function of growth chamber oxygen partial pressure for cell temperatures of 650°C, 750°C, and 850°C respectively in accordance with some examples.

FIGS. 10A-10C show plots of the modelled partial pressures of $Al_2O$, $AlO$ and $O_2$ at the exit aperture of a $Al_2O$ precursor vapor cell as a function of growth chamber oxygen partial pressure for cell temperatures of 975°C, 1050°C, and 1100°C respectively in accordance with some examples.

FIGS. 11A-11C show plots of the modelled partial pressures of $Ge$, $GeO$ and $O_2$ at the exit aperture of a $GeO$ precursor vapor cell as a function of growth chamber oxygen partial pressure for cell temperatures of 650°C, 700°C, and 750°C respectively in accordance with some examples.

FIGS. 12A-12C show plots of the modelled partial pressures of $Si$, $SiO$ and $O_2$ at the exit aperture of a $SiO$ precursor vapor cell as a function of growth chamber oxygen partial pressure for cell temperatures of 850°C, 900°C, and 950°C respectively in accordance with some examples.

FIGS. 13A-13C show plots of the modelled partial pressures of $B_2O_2$, $B_2O$ and $O_2$ at the exit aperture of a $B_2O$ precursor vapor cell as a function of growth chamber oxygen partial pressure for cell temperatures of 900°C, 950°C, and 1000°C respectively in accordance with some examples.

FIGS. 14A-14C show plots of the modelled partial pressures of $In_2O$, $In$ and $O_2$ at the exit aperture of a $In_2O$ precursor vapor cell as a function of growth chamber oxygen partial pressure for cell temperatures of 500°C, 550°C, and 600°C respectively in accordance with some examples.

FIGS. 15A-15C is phase diagram for $Li_2O$ decomposition in an oxygen environment.

FIGS. 16A-16B are modelled plots related to the expected oxide condensation at the exit of the binary-oxide vapor source operating in an oxygen environment as a function of exit temperature in accordance with some examples.

FIG. 16C shows a plot of a modelled thermodynamic process for $In_2O(gas)$ reacting with $O_2$ and the driving force ($\Delta P$) for forming $In_2O_3$ solid in accordance with some examples.

FIG. 16D shows a plot of a modelled thermodynamic driving force for three binary-oxide precursor specie $Me_2O$, where Me=(In, Ga, or Al) in accordance with some examples.

FIG. 17 is a figurative view of a binary-oxide vapor source comprising a multizone (2-zone) heating arrangement for differentially heating regions of the binary-oxide vapor source in accordance with some examples.

FIG. 18A is a figurative view of a binary-oxide vapor source comprising a multizone (3-zone) heating arrangement for differentially heating regions of the binary-oxide vapor source in accordance with some examples.

FIG. 18B shows a simplified schematic of a cross-section of an example of a binary-oxide precursor source in accordance with some examples.

FIG. 18C shows a simplified schematic of a cross-section of an example of a binary-oxide precursor source in accordance with some examples.

FIG. 19 is a figurative view of a binary-oxide vapor source comprising a condensation reduction arrangement in accordance with some examples.

FIG. 20 is a system overview diagram of a deposition system comprising a remote binary-oxide vapor source and a source of oxygen in accordance with some examples. The system further comprises, for example, a gas or precursor distribution system oriented with material flux toward an optionally rotating deposition plane. The deposition plane thermal coupled to a heater source that may be internal or external to the vacuum vessel.

FIG. 21 is a system overview diagram of another type of deposition system comprising a remote binary-oxide vapor source in accordance with some examples. The horizontal furnace system further comprises, for example, a gas or precursor distribution system oriented with material flux horizontally flowing toward a plurality of deposition planes. The precursor gas is optionally mixed with a carrier gas. The deposition planes are thermal coupled to a heater source that may be internal or external to the vacuum or pressure vessel.

FIG. 22 is a flowchart of a method for generating a binary-oxide vapor precursor for a deposition process.

FIGS. 23A-23D depict some examples of open-ended vessels including a body and an exit region that may be used for beam flux profile formation.

FIG. 24 illustrates a contained aggregate structure comprising a close-packed column of solid ellipsoid binary-oxide members.

FIG. 25 is a plot depicting the minimum amount of $Ga_2O_3$ required to react with an amount of Ga to completely convert the Ga and $Ga_2O_3$ into to $Ga_2O_{(vapor)}$ precursor.

FIGS. 26A-26C show an example of steps of loading a crucible with Ga and $Ga_2O_3$ granules for the generation of $GaO_{(vapor)}$.

FIG. 27 is a plot depicting the minimum amount of $GeO_2$ required to react completely with an amount of Ge to form $GeO_{(vapor)}$ precursor.

FIG. 28A is a sectional diagram of a binary-oxide vapor source in accordance with an illustrative embodiment, showing for example three material regions contained within the vessel.

FIG. 28B is a sectional diagram of a binary-oxide vapor source in accordance with another illustrative embodiment.

FIG. 28C is a sectional diagram of a binary-oxide vapor source in accordance with another illustrative embodiment.

FIG. 29 is a flowchart of a method for generating a binary-oxide vapor precursor according to an illustrative embodiment.

FIG. 30 is a sectional diagram of a binary-oxide vapor source in accordance with another illustrative embodiment.

FIG. 31 is a plot similar to FIG. 25 showing two example mass ratios of the solid binary-oxide component to the elemental component that were assessed for binary-oxide vapor source in accordance with the present disclosure.

FIG. 32 is a plot of the total volume of the $Ga/Ga_2O_3$ mixture as a function of the Ga mass for the crucible geometry illustrated in FIGS. 26A-26C in accordance with an illustrative embodiment.

FIG. 33 is a plot of measured $Ga_2O$ flux $\phi$ as a function of binary-oxide vapor source temperature for the two example mass ratios referred to in FIG. 31.

FIG. 34 is an Arrhenius plot of the $Ga_2O$ flux $\phi$ as a function of the absolute temperature T of the binary-oxide vapor source for the two example mass ratios referred to in FIG. 31.

FIG. 35 shows x-ray diffraction (XRD) 2q-w scans of a first single crystalline $Ga_2O_3$ film grown epitaxially on a 2 inch sapphire wafer of (0001) orientation and a second single crystalline $Ga_2O_3$ film grown on a 2 inch 4H-SiC substrate with (0001) orientation formed using a $Ga_2O$ precursor in accordance with the present disclosure.

FIG. 36 is a UV-visible light reflectometry thickness map of the b-$Ga_2O_3$ film grown on a c-plane sapphire substrate referred to in FIG. 35.

FIG. 37 is a UV-visible light reflectometry thickness map of the b -$Ga_2O_3$ film grown on the 4H-SiC(0001) substrate referred to in FIG. 35.

FIGS. 38 and 39 show modelled examples of using two binary-oxide vapor sources in combination with an active oxygen source to form a ternary oxide material, in accordance with some examples.

FIG. 40 shows a schematic of an example of system YY2400 with similar components as described with respect to system YY800 shown in FIG. 8A and further including an additional elemental or molecular source YY2410, in accordance with some examples.

In the following description, like reference characters designate like or corresponding parts throughout the figures.

## DETAILED DESCRIPTION

The present disclosure relates to generating a binary-oxide precursor. In one form, the present disclosure relates to generating a binary-oxide precursor for a deposition process.

The present disclosure describes systems and methods for producing binary-oxide vapor precursors using binary-oxide vapor sources. In some cases, a material deposition system includes a binary-oxide vapor source and an active oxygen source coupled to a growth chamber, and the binary-oxide precursors and the active oxygen can react to form an epitaxial film on a heated substrate in the growth chamber.

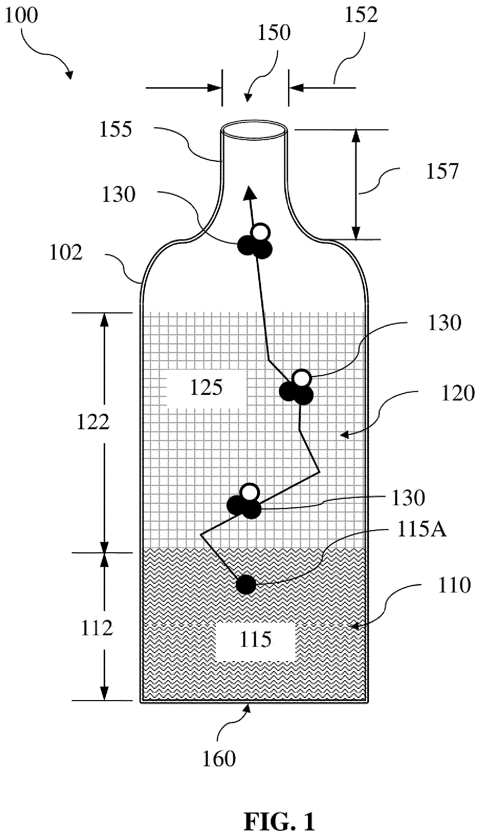

Referring now to FIG. 1, there is shown a binary-oxide vapor source 100 for generating a binary-oxide vapor precursor in accordance with some embodiments. In this example, vapor source 100 comprises an open end 150 and a closed end 160 and has a general bottle type configuration comprising in this embodiment a necked region 155. Necked region 155 can have a height 157 and open end 150 can have a width 152 that is approximately perpendicular to the height 157. In other examples, the binary-oxide vapor source can have different shapes, such as shapes without a neck, as described further below.

Vapor source 100 comprises a vessel 102 with a first region 110 (with a dimension or depth 112) located adjacent or proximal to the closed end 160 and includes or contains an elemental component 115. Vapor source further comprises a second region 120 (with a dimension or depth 122) located between the first region 110 and the open end 150 which in this example comprises solid binary-oxide members 125 configured so as to form spaces or gaps between the individual members to form a porous layer. For example, the solid binary-oxide members 125 can be beads or granules of binary-oxide materials (e.g., formed by sintering, or other production method). The beads or granules can be formed into a porous layer, for example, by packing the solid binary-oxide members 125 into the vessel 102 and heating it in the presence of elemental component 115. The porous layer of solid binary-oxide members 125 can allow elemental vapor, formed upon heating of elemental component 115, to enter and traverse the second region and react with the solid binary-oxide members 125 in the second region to form the binary-oxide vapor precursor. The formed binary-oxide vapor precursor can then exit the open end 150 of vapor source 100.

In FIG. 1 this is shown figuratively where a single atom 115A of elemental component 115 located in the first region 110 upon heating enters the second region 120 and reacts with the binary-oxide material comprising the solid binary-oxide members 125 to form a binary-oxide precursor gas molecule 130 in the second region 120. Due to the porous structure of the second region 120, the binary-oxide precursor gas molecule 130 is able to traverse this region and then exit by the open end 150.

For example, the binary-oxide precursor can be of the form $A_2O_{(gas)}$ and the solid binary-oxide members (e.g., 125 in region 120) can include binary-oxide material in the form $A_2O_{3(solid)}$.

More generally, the reaction to form a binary-oxide precursor in accordance with the present disclosure may be written as follows:

$$xA_{(solid\ or\ liquid)} + A_mO_{n(solid)} \rightarrow sA_rO_{(gas)} \qquad \text{Equation 1}$$

where A is selected from {Ga, Ge, Al, Si, B, Li, or In} and is the relevant elemental component, and $A_mO_{n(solid)}$ is the corresponding solid binary-oxide comprising this elemental component.

The following reactions (Equations 2-8) can be used to produce binary-oxides with different cations. The reactions provide examples of elemental components and solid binary-oxides which can form vapor or gaseous binary-oxide precursors when reacted together.

Ga:

$$4Ga_{(liquid)} + Ga_2O_{3(solid)} \rightarrow 3Ga_2O_{(gas)} \qquad \text{Equation 2}$$
$$Ga_{(liquid)} + Ga_2O_{3(solid)} \rightarrow 3GaO_{(gas)} \qquad \text{Equation 2b}$$

Ge:

$$Ge_{(solid\ or\ liquid)} + GeO_{2(solid)} \rightarrow 2GeO_{(gas)} \qquad \text{Equation 3}$$

Al:

$$4Al_{(solid)} + Al_2O_{3(solid)} \rightarrow 3Al_2O_{(gas)} \qquad \text{Equation 4}$$
$$Al_{(liquid)} + Al_2O_{3(solid)} \rightarrow 3AlO_{(gas)} \qquad \text{Equation 4b}$$

Si:

$$Si_{(solid\ or\ liquid)} + SiO_{2(solid)} \rightarrow 2SiO_{(gas)} \qquad \text{Equation 5}$$

(continued)

B:

$$4B_{(solid)} + B_2O_{3(solid)} \rightarrow 3B_2O_{(gas)} \qquad \text{Equation 6}$$
$$B_{(solid)} + B_2O_{3(solid)} \rightarrow 3BO_{(gas)} \qquad \text{Equation 6b}$$

In:

$$4In_{(solid)} + In_2O_{3(solid)} \rightarrow 3In_2O_{(gas)} \qquad \text{Equation 7a}$$
$$In_{(liquid)} + In_2O_{3(solid)} \rightarrow 3InO_{(gas)} \qquad \text{Equation 7b}$$

Li:

$$xLi_{(solid)} + Li_2O_{(solid)} \rightarrow sLi_rO_{(gas)} \qquad \text{Equation 8}$$

where $Li_rO_{(gas)}$ in Equation 8 refers to a mixture of species with different Li/O ratios, and "s" is the number of binary-oxide precursor gas molecules produced by the balanced reaction in Equation 8. Lithium oxide solid members (e.g., granules, powder, pieces, etc.) can react with the ambient oxygen environment and can be tuned to supply substantially Li or LiO precursors. For example, the Li/O ratio of the binary-oxide $Li_rO$ precursors produced at least partially depends on the type or composition (e.g., $Li_2O$, or $Li_2O_2$) of the solid lithium oxide members.

The reaction kinetics for Equation 1 may be modelled in accordance with the following thermodynamic principles.

Systems and methods of forming the binary-oxide precursors using the binary-oxide vapor sources described herein can be operated efficiently by adhering to the following relevant thermodynamics principles.

The Gibbs free energy of formation of a particular composition is a function of temperature and pressure. The change in Gibbs free energy for a particular reaction pathway can also be calculated with great accuracy. This change in Gibbs free energy for a given reaction can be used to calculate the equilibrium constant as a function of temperature which is equivalent to the partial pressure of distinct species comprising the reaction.

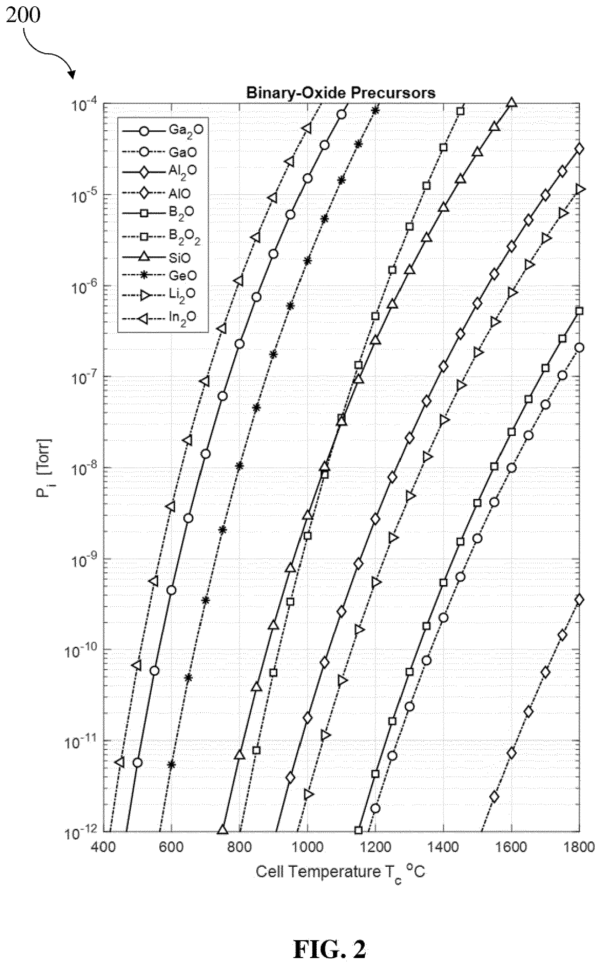

Referring now to FIG. 2, there is shown a plot 200 of the expected vapor partial pressures as a function of cell temperature for a selection of binary-oxide vapor precursors in accordance with some embodiments. As shown in Equations 1 to 8, in some cases different species will be present in the same environment. For example, $Ga_2O$ and $GaO$ gas can both be present in a cell reacting elemental Ga with $Ga_2O_3$, as described by Equations 2 and 2b. In this example, the expected product partial pressures or fluxes for each of the indicated binary-oxide vapor precursors have been determined based on a thermodynamic model comprising the reactants, as a function of temperature and the oxygen pressure of the environment. As can be seen from inspection of plot 200, the expected vapor pressure of the indicated binary-oxide vapor precursor will increase with increasing temperature of the binary-oxide vapor cell (i.e., "Cell Temperature").

In some cases, aggregate structures and granules can be used in the binary-oxide vapor sources to form the binary-oxide vapor precursors described herein.

As discussed above, the binary-oxide vapor source comprises a first region that includes an elemental component located at the closed end of the source. It also includes a second region located between the first region and the open end of the source that includes solid binary-oxide members and spaces between the solid binary-oxide members. The spaces allow elemental vapor (formed upon heating the first region) to pass through and react with the solid binary-oxide members to form the binary-oxide vapor. In one example, the solid binary-oxide members and associated spaces are formed as a contained aggregate structure in the vapor source. In a further example this aggregate structure is a close-packed column of the solid binary-oxide members in the form of granules or beads.

In some cases, the contained aggregate structure provides a stable structure with a density and porosity. Referring to Equation 1, in some examples it can be beneficial to pack as much $A_mO_{n(solid)}$ (i.e., solid binary-oxide members) as possible into the vapor source but still maintain a sufficient or desired porosity. This can be beneficial, for example, to produce more of the binary-oxide vapor precursor before having to reload the source. In one example, the contained aggregate structure is formed from solid binary-oxide members in the form of particles or granules having a predetermined size distribution selected to provide a large amount of solid binary-oxide members while maintaining porosity. A surface area of the solid binary-oxide members will also be related to the size distribution and shapes of the solid binary-oxide members in the form of particles or granules. Not to be limited by theory, the surface area can be beneficial to increase a reaction rate of the elemental component with the solid oxide members, and a high porosity can be beneficial to enable the produced binary-oxide vapor precursor to transit the region with the porous solid oxide members and exit the source.

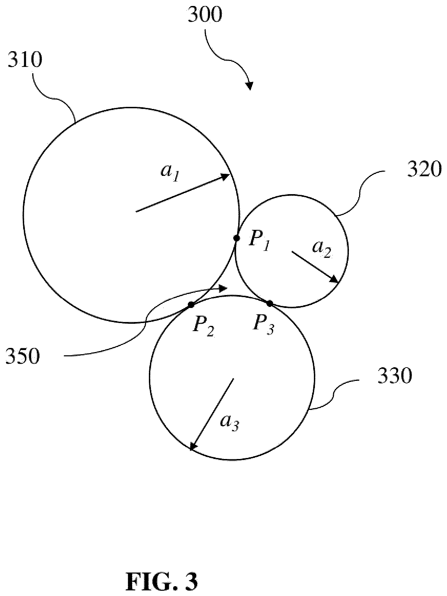

Referring now to FIG. 3, there is shown a figurative view 300 showing the geometry for forming an aggregate structure including granules having a predetermined size distribution in accordance with some embodiments.

In this example, there is shown three granules or beads 310, 320, 330 having a generally spherical configuration where each of the granules have differing radii of $a_1$, $a_2$, and $a_3$ respectively and contact each other at points $P_1$ (between granules 310 and 320), $P_2$ (between granules 310 and 330), and $P_3$ (between granules 320 and 330) to form a void or space 350 between granules 310, 320, 330. As would be appreciated, the size of the void or space 350 will be dependent on the size distribution of the granule radii of $a_1$, $a_2$ and $a_3$. As an example, the size of void 350 would decrease as the size of granule 320 decreases (and the size of granules 310 and 330 are held constant). In general, as the variation in size of the granule increases it would be expected that the voids between a contained aggregated structure formed of these granules would be smaller, since the granules would be more close-packed.

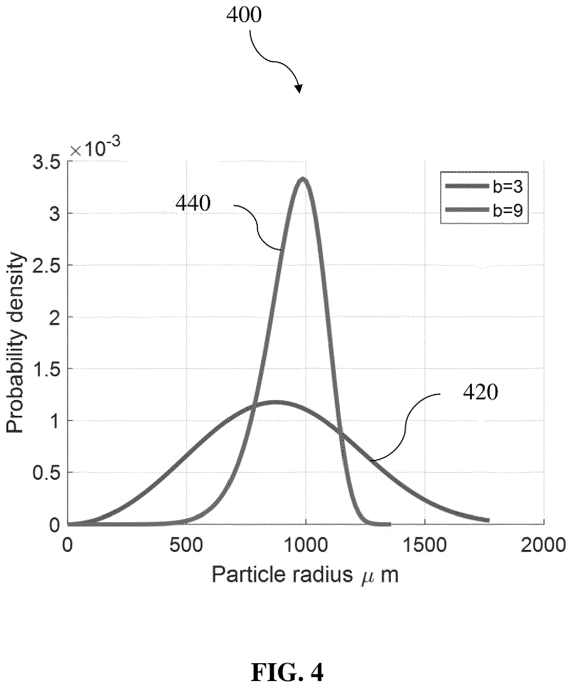

Referring now to FIG. 4, there is shown is a plot 400 of two different probability distributions (probability density) of granule or bead size as a function of bead radius (particle radius) each with a given nominal radius, in accordance with some embodiments.

In this example, the bead radius size is modelled in accordance with a Weibull distribution ($f(x,b) = -b \cdot e^{(-bx)}$, where "b" is the Weibull $b$ number) which is a flexible distribution function that may be used to characterise the distribution of granule or bead size. In this example, the granule size is characterised by the granule radius in microns.

As illustrated by this example, a collection of granules having higher Weibull $b$ number will have a narrower distribution of granules sizes as compared to a collection of granules having a lower Weibull $b$ number. Plot 400 compares distributions 420, 440 having Weibull $b$ numbers of 3 and 9 respectively.

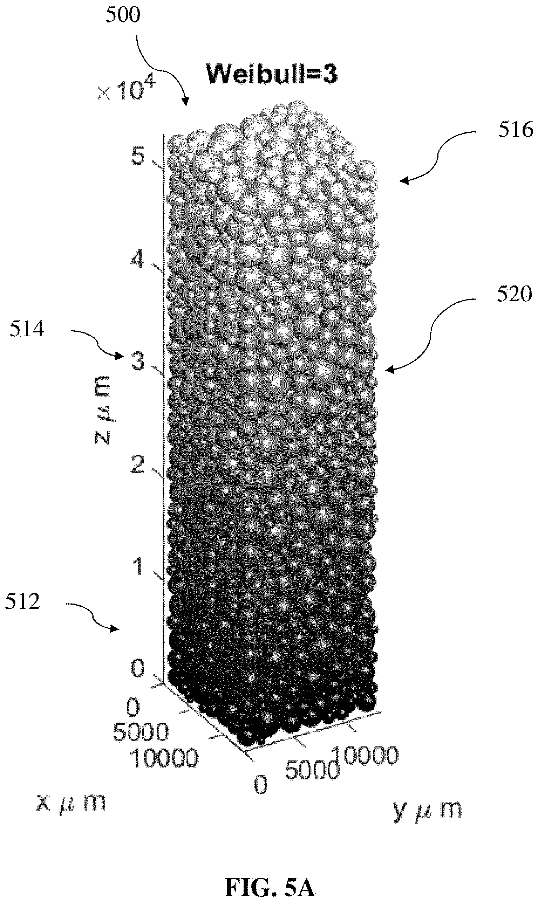

Referring now to FIG. 5A, there is shown a 3D plot 500 of an aggregate structure comprising a close packed column of granules 520 whose size varies in accordance with a Weibull distribution having a b parameter of 3 (see FIG. 4) showing the resulting packing density in accordance with some embodiments. In some cases, the column of granules 520 includes a first wetted region 512, a second semi-wetted region 514, and a third dry region 516. In some cases, the column of granules 520 includes a first wetted region 512, a second semi-wetted region 514, and a third semi-wetted region 516. In some such cases, the second semi-wetted region 514 can include more liquid than the third semi-wetted region 516.

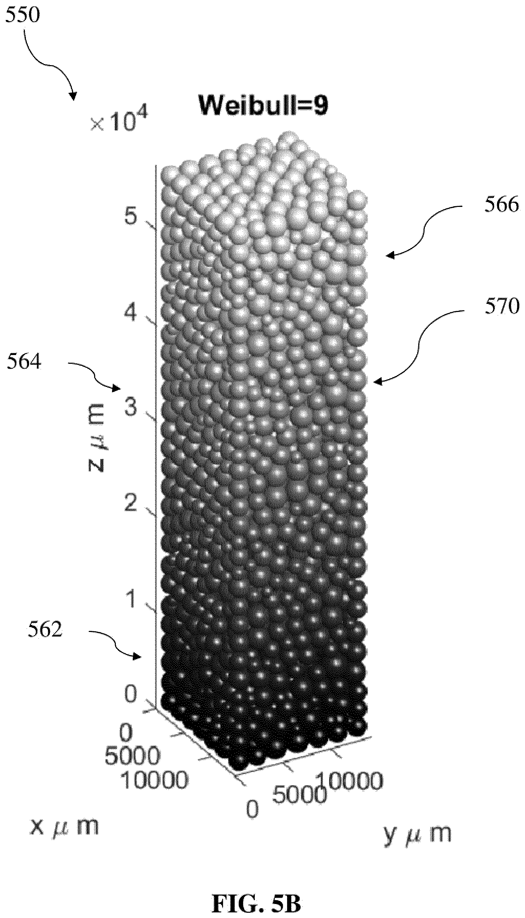

Referring now to FIG. 5B, there is shown a 3D plot 550 of an aggregate structure comprising a close packed column of granules 570 whose size varies in accordance with a Weibull distribution having a b parameter of 9 (see FIG. 4) showing the resulting packing density in accordance with some embodiments. In some cases, the column of granules 570 includes a first wetted region 562, a second semi-wetted region 564, and a third dry or semi-wetted region 566. In some cases, the second semi-wetted region 514 can include more liquid than the third dry or semi-wetted region 516.

In these examples, the close packed column of granules 520 corresponding to the lower Weibull $b$ number of 3 is more tightly packed than the column of granules 570 corresponding to the higher Weibull $b$ number of 9. The average pore size is also smaller in the close packed column of granules 520 corresponding to the lower Weibull $b$ number of 3 compared to that of the column of granules 570 corresponding to the higher Weibull $b$ number of 9. Accordingly, there is a larger amount (volume and mass) of the solid binary-oxide members in the close packed column of granules 520 corresponding to the lower Weibull $b$ number of 3 compared to that of the column of granules 570 corresponding to the higher Weibull $b$ number of 9.

Accordingly, using solid binary-oxide members with a specified (or tailored) size distribution will allow the interaction characteristics of the solid binary-oxide members with the elemental vapor to be modified by modifying the available surface area to interact with the elemental vapor as well as the effective porosity of column of granules which will affect the flow rate of the elemental vapor through the column of granules. The total amount (volume and mass) of solid binary-oxide members within a contained volume of a source can also be modified by the size distribution.

The size distributions of the solid binary-oxide members in the sources described herein can be Weibull distributions, as shown in FIG. 4, or can be other types of distributions such as Gaussian distributions, normal distributions, multi-modal distributions, or other types of irregular distributions. The average size and range of the size of the particles can also be different from those shown in the example distributions in FIG. 4. For example, a distribution of solid binary-oxide members (e.g., that are approximately spherical) can have an average size (or diameter) of about 1mm, a minimum (or first percentile, fifth percentile, or tenth percentile) size of about 0.5 mm, and a maximum (or ninetieth percentile, ninety-fifth percentile, or ninety-ninth percentile) size from 2mm to 3mm. In other cases, the solid binary-oxide members can have average sizes that are smaller than 0.5mm, or larger than 3mm. In some cases, the solid binary-oxide members are larger than about 1 micrometer, or larger than about 5 micrometers, or larger than about 10 micrometers. In some cases, if the solid binary-oxide members are too small, then they can solidify (e.g., over time as the source operates) to form a block of solid binary-oxide members without sufficient pores or spaces or with relatively few pores or spaces through which the elemental vapor can flow. In such cases, the source could become clogged and stop operating.

In one example, there will be a desired total mass of solid binary-oxide members available to react in the binary-oxide vapor source as well as a desired flow rate or pressure at the open end that will be dependent on the porosity of the packed column. In some applications, this combined requirement of both amount of material and porosity may be achieved by selecting an appropriate size distribution of granules. While the above discussion has been in the context of generally spherical granules, it would be appreciated that similar principles apply to other shaped solid binary-oxide members, i.e., that the size distribution may be selected to achieve desired properties of a close-packed column of these members including the use of bi-modal or multi-modal distributions. For example, the solid binary-oxide members can be shaped like oblate spheroids, prolate spheroids, rods, disks, platelets, or can be irregular shaped, or can have a mixture of different shapes. In the case of non-spherical solid binary-oxide members, the size distribution can describe a longest dimension of each solid binary-oxide member, or a representative dimension or aspect ratio between dimensions of the solid binary-oxide members.

Referring back to FIGS. 5A and 5B, in one example the density of the granules may be greater than the density of the elemental component in liquid form (e.g., Ga), and the close-packed column or contained aggregate structure 520, 570 of solid binary-oxide members may be divided into three regions moving from the closed end to the open end of the vapor source corresponding to a first wetted region 512, 562 where the granules are immersed in the liquid elemental component, a second semi-wetted region 514, 564 where the granules are partially immersed in the liquid elemental component and/or where on heating the elemental vapor from the liquid elemental component reacts with the granules, to a third dry region 516, 566 of granules which can act as a filter by reacting with any remnant elemental vapor able to transit semi-wetted region 514, 564 without reacting. In some cases, therefore the "dry" region 516, 566 can contain some liquid elemental component.

In FIGS. 5A and 5B, the degree of "wetness" is shown in greyscale where a darker region indicates a greater presence of the liquid elemental component or elemental vapor. As can be seen from comparing FIG. 5A and FIG. 5B, the semi-wetted region 512 of FIG. 5A extends further up the column of granules than the equivalent semi-wetted region 562 of FIG. 5B, reflecting effective greater packing density of column of granules 520.

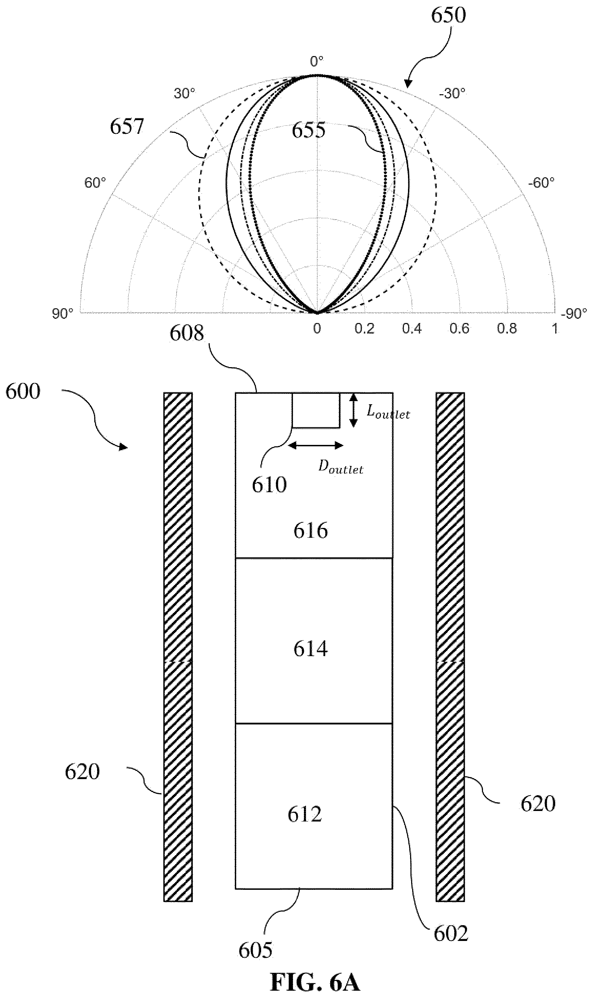

Referring now to FIG. 6A, there is shown a figurative sectional view of a binary-oxide vapor source 600 indicating the modelled emission distribution profile 650 in accordance with some embodiments.

Binary-oxide vapor source 600 comprises a vessel 602 with a closed end 605 and an open end 608. In one example, the open end comprises an outlet 610 configured so that the binary-oxide vapor precursor is emitted or exits the binary-oxide vapor source 600 with a modelled emission distribution profile 650 (e.g., with profiles 655 and 657) and at a desired working pressure (or having a certain flux, or emitting a desired partial pressure of, a binary-oxide precursor). Binary-oxide vapor source 600 further includes a heating arrangement comprising a heating zone 620 controllable to heat vapor source 600 along its length to a predetermined temperature.

In some examples, outlet 610 may have an effective outlet aperture diameter D (i.e., $D_{outlet}$) and a characteristic outlet length L in the direction of emission (i.e., $L_{outlet}$). The emission distribution profile characteristics of outlet 610 will primarily depend on $L_{outlet}$, and the outlet conductance, $Q_{outlet}$, will primarily depend on $D_{outlet}$ but will also generally reduce with increasing $L_{outlet}$.

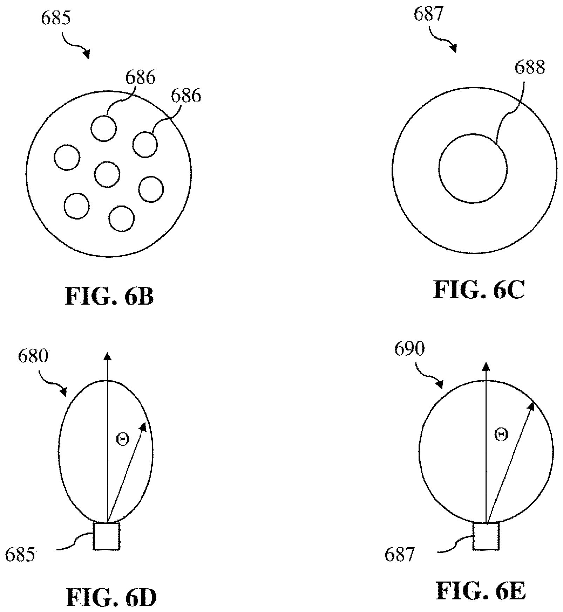

In some examples, outlet 610 may be configured as multiple smaller apertures (each having an associated aperture size) or a single aperture. FIG. 6B shows a top-down schematic of an example of an outlet 685 of a source with apertures 686, and FIG. 6C shows a top-down schematic of an example of an outlet 687 of a source with a single aperture 688. In some cases, the outlet may be configured to have multiple apertures 686 each of which has a diameter $D_n$ and then the effective outlet aperture diameter $D_{outlet}$ can be calculated from the individual diameters $D_n$, combining them in a manner that accounts for losses due to using multiple apertures instead of one large aperture of equivalent size. This may be contrasted to outlet 687 having a single aperture 688. In some cases, apertures 686 and 688 have larger diameters than conventional apertures for epitaxial deposition systems (e.g., MBE). Larger apertures can be beneficial in some cases to prevent clogging due to solid binary-oxide deposition clogging the aperture. For example, aperture 686 and/or 688 can be from about 0.1 mm to about 10 cm, or from about 1 mm to about 10 cm, or from about 10 mm to about 10 cm, or from about 0.1 mm to about 10 mm, or from about 1 mm to about 10 mm, or from about 10 mm to about 10 mm, or larger than 10 mm, or larger than 10 cm. For example, the apertures 686 can be from 1 mm to 10 mm. In another example, aperture 688 can be about 10 cm or larger. In some cases, it is advantageous to heat the outlet 685 and 687 to prevent or reduce the rate of solid binary-oxide deposition clogging the aperture.

In some examples, an aspect ratio defined generally as L/D for an aperture is configured to produce a desired beam or emission distribution profile, working pressure (or flux), and outlet working pressure difference across the aperture (i.e., between a space inside the vapor source and a space outside of the open end of the vapor source) in accordance with requirements of the deposition process to which the binary-oxide vapor precursor is being delivered to.

In some examples, the outlet is configured to provide a cosine $n\theta$ flux distribution to any receiving chamber into which the binary-oxide vapor precursor is being delivered. For example, the outlet aspect ratio L/D may be selected to provide an angular emission distribution profile at some deposition surface at a distance "d" from the outlet. This distribution may be generally in the form of a cosine $n\theta$ flux distribution with $n$ increasing with the outlet aspect ratio to form a more directed beam (e.g., compare emission distribution profile 657 with profile 655 in FIG. 6A).

This effect may be seen in FIGS. 6D and 6E which depict figuratively the angular emission distribution profiles 680 and 690 (shown in sideview) of the binary-oxide vapor precursor from outlets 685 and 687, respectively. As can be seen, the effect of the higher aspect ratio of individual apertures 686 of outlet 685 results in a more directed angular emission distribution profile 680 (i.e., the $n$ is greater in the cosine $n\theta$ flux distribution) for the emitted binary-oxide vapor precursor from the combination of apertures 686 when compared to the angular emission distribution profile 690 of the emitted binary-oxide vapor from the single aperture 688 of outlet 687.

FIG. 6A also shows indicative locations of a first wetted region 612 where the solid binary-oxide members are immersed in the liquid elemental component, a second semi-wetted region 614 where the solid binary-oxide members are partially immersed in the liquid elemental component and/or where elemental vapor from the liquid elemental component reacts with the solid binary-oxide members, and a third dry region 616 of solid binary-oxide members. For example, the solid binary-oxide members in the source in FIG. 6A can be similar to those shown in the close-packed columns of solid binary-oxide members (granules) in FIGS. 5A and 5B.

In some cases, the solid binary-oxide members can be less dense than an elemental component in the binary-oxide vapor sources described herein. In such cases, the solid binary-oxide members can fully or partially float on top of the elemental component, and region 612 (or a lower portion of region 612) can include only the elemental component. In other cases, the solid binary-oxide members can be denser than the elemental component and region 612 (including the lower portion of region 612) can include a mixture of the elemental component and the solid binary-oxide members.

Binary-oxide vapor source 600 in this example utilizes a heater zone 620 extending along the length of vapor source 600 to heat (e.g., uniformly heat) the regions 612, 614, 616 of the vapor source 600. Heater zone 620 can include a resistive heater, a radiative heater, or any type of heater capable of providing heat to the source 600. For example, in some cases, the crucible is at least partially in a vacuum chamber such that there is a vacuum gap between at least a portion of heater zone 620 and vessel 602. In such cases, at least a portion of heater zone 620 is a radiative heater that transfers heat to the vessel 602 radiatively through the vacuum gap. In some cases, the heater of source 600 can be controlled using a processor, for example, coupled to a temperature measurement sensor (e.g., thermocouple) configured to measure a temperature of the outside or the inside of the source (or adjacent to the source).

The binary-oxide vapor precursors and sources described herein can be used to form an oxide layer within a deposition environment. Methods of growing oxide films using the binary-oxide vapor precursors and sources described herein can be performed in accordance with the following thermodynamics.

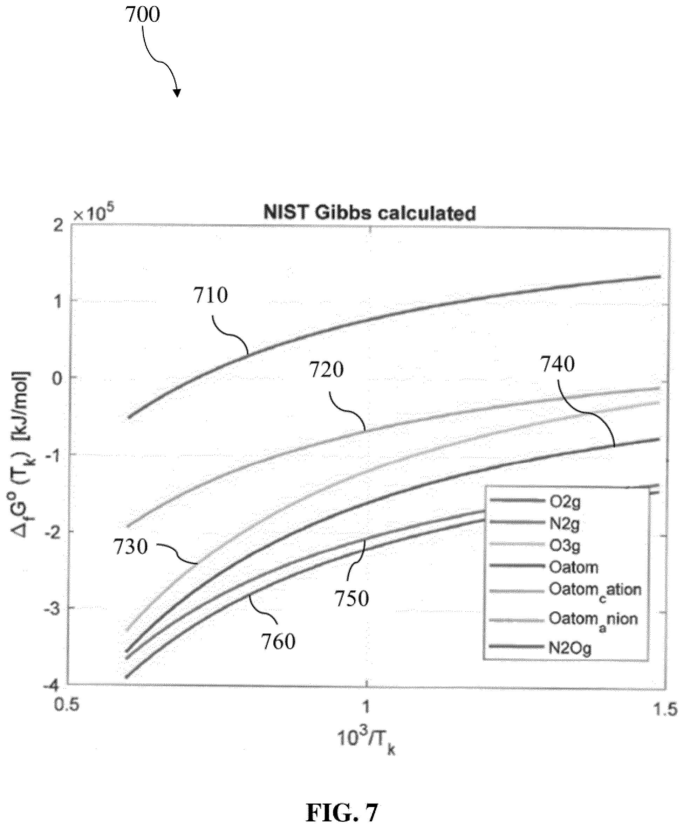

Referring now to FIG. 7, there is shown a plot 700 of data, from National Institute of Standards and Technology Joint Army Navy Air Force (NIST JANAF), of the calculated Gibbs free energy activity (equilibrium coefficient) as a function of temperature for various active oxygen containing species in accordance with some embodiments.

A higher Gibbs free energy indicates that the active oxygen containing species is more reactive. Shown in plot 700 in order from most reactive to least reactive species are atomic oxygen O* 710, O atom anion 720, ozone $O_3$ 730, nitrous oxide $N_2O$ 740, molecular nitrogen $N_2$ 750 (shown for comparison purposes), and molecular oxygen $O_2$ 760. The curve for the O atom cation is out of the range of Gibbs free energy plotted on the y-axis of plot 700.

As can be seen from the plot in FIG. 7, atomic oxygen O* (see 710) is a particularly reactive active oxygen containing species making it suitable for reacting with binary-oxide precursor to form an oxide layer in a deposition or growth system. In various examples, a radio frequency (RF) source is used to form a plasma and "crack" molecular oxygen $O_2$ to form O*. While an RF plasma source is especially convenient in being able to generate atomic oxygen on demand, in some cases this process is relatively inefficient resulting in the generation of an oxygen species mixture with an approximately 1% partial pressure of O* and a 99% partial pressure of $O_2$ in a beam generated by the plasma source.

As can also be seen from FIG. 7, another potential active oxygen containing species that is suitable for forming an oxide layer is ozone $O_3$ (see 730), however, similar to atomic oxygen O*, the use of $O_3$ is generally associated with a relatively higher partial pressure of $O_2$ given that $O_3$ rapidly decays to $O_2$. While $O_3$ can be a good source of an active oxygen containing species for oxide deposition processes, it is highly reactive, which can require enhanced safety handling procedures and as a result an RF plasma source is generally preferred in most conventional oxide deposition applications.

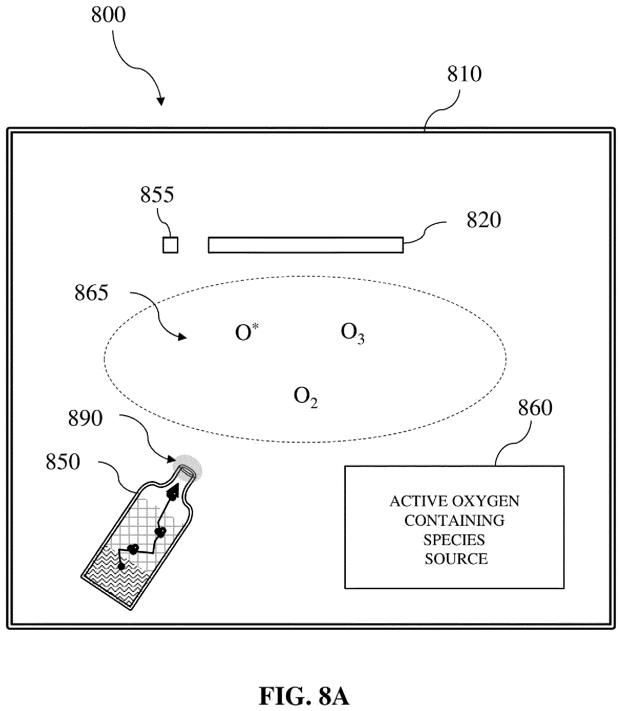

Referring now to FIG. 8A, there is shown a system overview diagram of a deposition system 800 including a binary-oxide vapor source 850 and an active oxygen containing species source 860 for depositing an oxide layer on a substrate 820 in accordance with some embodiments. Deposition system 800 further comprises a vacuum growth chamber 810 and is generally configured so that a binary-oxide precursor reacts with an active oxygen containing species to form an oxide layer on substrate 820. Substrate 820 can be a single crystal substrate and the oxide layer can be epitaxially deposited on the single crystal substrate. Substrate 820 can also be a composite substrate with a base layer (e.g., a polycrystalline layer) and a single crystal layer on the surface, and the oxide layer can be epitaxially deposited on the surface of the single crystal layer of the composite substrate. In some cases, a polycrystalline oxide layer can be deposited on the substrate 820, and the substrate 820 can have a crystalline, single-crystal, polycrystalline, or amorphous material at the surface.

System 800 also includes sensor 855, which measures the type(s) and/or flux(es) of species in the chamber 810. In some cases, sensor 855 is a residual gas analyzer (RGA), which can measure the types and amounts of species in the environment using a mass spectrometer. In some cases, sensor 855 is a beam flux monitor (BFM), which can measure a flux of species in the chamber by ionizing the species in an electric field and measuring the resulting current. Sensor 855 can be other types of sensors that indicate the type(s) and/or flux(es) of species in the chamber 810, such as a quartz crystal microbalance (QCM), or other type of pressure gauge. In some cases, more than one sensor 855 can be present. For example, system 800 can include an RGA and a BFM.

Additionally, system 800 can also include other sensors (not shown), such as pressure sensors to measure the pressure in the chamber 810, and temperature sensor(s) to measure the substrate temperature.

In some cases, the binary-oxide sources described herein (e.g., binary-oxide source 850) can be coupled to one or more sensors (e.g., sensor 855) and the binary-oxide source can be controlled using closed-loop feedback based on information from the sensor(s). The binary-oxide source can be coupled to a processor which is used to control the source. The processor can also be coupled to the one or more sensors and can be used to control the binary-oxide source using the information from the sensor(s). For example, the sensor can be an RGA or a BFM, and the processor can control a temperature setpoint of the binary-oxide source to maintain or target a binary-oxide precursor flux measured by the sensor. In this example, the processor would use information from the RGA and/or BFM sensor(s) to control the temperature setpoint, and the processor can also control one or more heaters of the binary-oxide source using information from a thermocouple. This can be advantageous since the flux of the precursor species can drift over time, and the active closed-loop feedback described above can improve the stability of the flux which can enable improved control over the composition, thickness, and/or material quality of the growing films.

In addition to atomic oxygen, sources of other oxidants, such as carbon monoxide (CO), nitrous oxide ($N_2O$), and nitric oxide (NO) sources, can also be used in addition to or instead of active oxygen containing species source 860 in system 800. These other oxidants can be used to deposit an oxide layer on substrate 820, and offer opportunities for functional doping. However, these other oxidants introduce additional complexity into the thermodynamic modelling. For example, CO and NO can oxidize $M_2O(g)$ to $M_2O_3(s)$ while incorporating C or N atoms into the film. In another example, $N_2O$ acts as a powerful oxidizer and nitrogen source simultaneously.

For example, in the case of group-III metals ("M") such as Ga, In, or Al, when these other oxidants are used, the following general reaction forms apply:

$$M_2O(g) + 2 N_2O(g) \rightarrow M_2O_3(s) + 2 N_2(g) \qquad \text{Equation 9a}$$

$$M_2O(g) + 2 NO(g) \rightarrow M_2O_3(s) + N_2(g) \qquad \text{Equation 9b}$$

$$M_2O(g) + 2 CO(g) \rightarrow M_2O_3(s) + 2 C(s) \qquad \text{Equation 9c}$$

$$M_2O(g) + CO_2(g) \rightarrow M_2O_3(s) + C(s) \qquad \text{Equation 9d}$$

The incorporation of nitrogen and carbon during oxide layer growth provides an effective strategy to introduce deep acceptors into the oxide material. These acceptors can compensate for oxygen vacancies (which otherwise contribute to n-type conductivity), enabling the realization of semi-insulating films, or p-type films in some cases.

This methodology provides a thermodynamic framework to model the equilibrium growth of ternary oxide systems using suboxide sources in an MBE environment. It is extensible to ternary and quaternary systems, and can be calibrated using fitted equilibrium constant (K(T)) values (e.g., derived from NIST JANAF or National Aeronautics and Space Administration (NASA) thermochemical data). The use of alternative oxidants such as CO, $N_2O$, and NO opens additional pathways for doping control, enabling the synthesis of semi-insulating or compensated oxide materials.

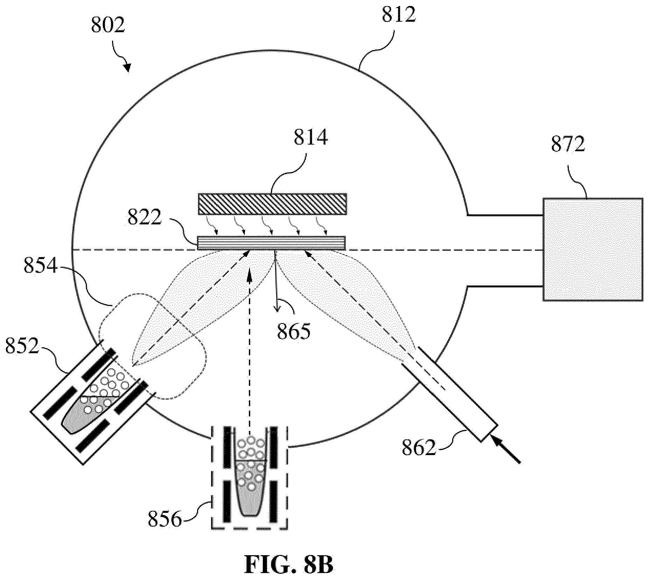

Referring now to FIG. 8B, there is shown a system overview diagram of a deposition system 802 comprising a binary-oxide vapor source 852 and an active oxygen containing species source 862 for depositing an oxide layer on a substrate 822 in accordance with some embodiments. Substrate 822 is heated using radiative heater 814 in this example. Substrate 822 can be rotating, in some cases, to improve uniformity. Binary-oxide vapor source 852 and active oxygen containing species source 862 are shown oriented such that they are pointed off-center from the substrate 822 in this example. The incident directions of the sources 852 and 862 (shown by dotted arrows in FIG. 8B) intersect with a surface of the substrate 822 at positions that are significantly offset from the center of the substrate 822. The center of the substrate 822 is shown in FIG. 8B at the intersection of the substrate 822 and the normal direction arrow 865. Such an arrangement can be beneficial, in some cases, such as in combination with a rotation of substrate 822. Deposition system 802 further comprises a vacuum growth chamber 812 and is generally configured so that a binary-oxide precursor reacts with an active oxygen containing species to form an oxide layer on substrate 822. In this vacuum chamber configuration (e.g., such as in an MBE system) an open end of the binary-oxide vapor source 852 is inside or at a boundary of the growth chamber 812. Region 854 is also shown in FIG. 8B, which is a region in which species (e.g., active oxygen) in the chamber can react with the materials at, on, or in the binary-oxide vapor source 852. For example, solid binary-oxide material can undesirably be deposited on the open end or lip of the binary-oxide vapor source 852 in some cases. Pump 872 is coupled to the growth chamber 812 and is used to form a vacuum.

In some cases, system 802 includes a binary-oxide source 856 that is oriented vertically. System 802 can include one binary-oxide source 852 or 856. In other cases, system 802 can include two binary-oxide sources 852 and 856, for example, to form ternary oxide materials from two different binary-oxide precursors (e.g., $Al_2O$ and $Ga_2O$ to form $(Al_xGa_{1-x})_2O_3$). In some cases, system 802 includes a binary-oxide source 856 that is oriented vertically and has an incident direction (shown by the dotted line) that is significantly offset from the center of the substrate 822.

As would be appreciated, while deposition systems 800 and 802 in FIGS. 8A and 8B are directed to molecular beam epitaxy (MBE) system arrangements, the deposition system may be any type of epitaxial layer-based deposition system including, but not limited to, chemical vapor deposition (CVD) based systems (e.g., molecular-organic chemical vapor deposition (MOCVD)), atomic layer deposition (ALD) based systems, or others.

As discussed above, for commonly used active oxygen containing species such as ozone $O_3$ and atomic oxygen $O^*$ there is often associated a relatively high partial pressure of $O_2$ relative to $O^*$ and/or $O_3$, that is proximal or near to the open end or exit aperture of any binary-oxide vapor source. This proximity results in a reaction of the binary-oxide vapor with the molecular oxygen to form an oxide "condensate" 890 (shown in FIG. 8A) at the exit aperture of the source 860 instead of at the substrate 820. This build-up of condensate will first function to reduce the binary-oxide vapor source flux and in some examples may even substantially block the exit aperture.

The expected condensate buildup from the reaction between the binary-oxide vapor source and molecular oxygen may be modelled as a function of cell temperature and growth chamber oxygen partial pressure based on thermodynamic considerations and parameters such as the temperatures, Gibbs free energy (G), equilibrium constant (K), and oxygen pressure.

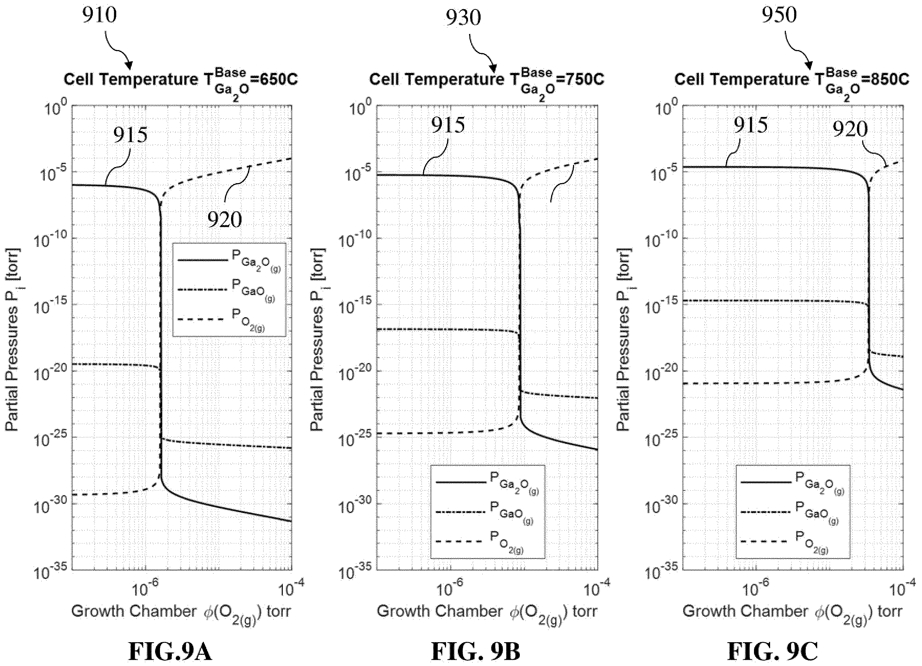

Referring now to FIGS. 9A-9C there are shown plots of the modelled partial pressures of $Ga_2O$, $GaO$, and $O_2$ at the exit aperture of a $Ga_2O$ precursor vapor cell as a function of growth chamber oxygen partial pressure (e.g., from a separate oxygen source) for cell temperatures of 650°C (shown in plot 910), 750°C (shown in plot 930), and 850°C (shown in plot 950) in accordance with some embodiments.

Consider plot 910 for a cell temperature of 650°C, as can be seen from inspection at a growth chamber oxygen partial pressure of between $1 \times 10^{-6}$ Torr and $2 \times 10^{-6}$ Torr, the $Ga_2O$ precursor partial pressure drastically reduces and the growth chamber oxygen partial pressure 920 suddenly increases and then tracks the growth chamber oxygen partial pressure. This indicates that even though the molecular oxygen has a relatively low reactivity compared to atomic oxygen (as an example), its presence in the growth chamber at enough pressure can overwhelm the production of $Ga_2O$ precursor resulting in the formation of a $Ga_2O_3$ condensate at the exit aperture of the source. In summary, the presence of molecular oxygen overwhelms the produced binary-oxide precursor resulting in the formation of the oxide condensate prior to any oxide deposition on the substrate.

Considering plots 930 and 950, which correspond to plot 910 but for higher cell temperatures of 750°C and 850°C respectively, it can be seen that the effect of higher cell temperature is to increase the tipping point for growth chamber oxygen partial pressure above which there is a runaway reaction of oxygen with the $Ga_2O$ precursor forming the $Ga_2O_3$ condensate.

As would be appreciated, and as can be seen from FIG. 7, this effect would even be more pronounced where atomic oxygen $O^*$ is present at the exit aperture of the source given its higher reactivity as compared to molecular oxygen.

FIGS. 9A-9C and 10A-15C show examples of modelled partial pressures of species at the exit apertures of precursor vapor cells used to produce different types of binary vapor precursors (e.g., $Ga_2O$, $AL_2O$, $GeO$, $SiO$, $B_2O$, $In_2O$, and $Li_2O$). The species can be produced in binary-oxide vapor sources described herein, for example, according to the reactions shown in Equations 1-8. The y-axes of FIGS. 9A-15C are the partial pressure of oxygen input into the systems or chambers (in units of Torr). In FIGS. 9A-15C the oxygen curves in the plots correspond to expected oxygen partial pressures in the chamber in the vicinity of the source, taking into account reactions that may occur between the oxygen and species generated by the source.

In some cases of the examples shown in FIGS. 9A-15C, the pressure in the chamber is low enough (e.g., below 1e-4 Torr) that a mean free path of species generated by the binary-oxide vapor sources is longer than a source to substrate distance (e.g., in a vacuum system, or an MBE system configuration). In other examples described herein, the pressure in the chamber is higher (e.g., above 1e-4 Torr) and the mean free path is shorter than a source to substrate distance (e.g., in a flow-through furnace, or an MOCVD system configuration). In systems that use such higher pressures, there is a greater chance for gas phase reactions to occur, for example, between a binary-oxide vapor precursor and an active oxygen source to form a solid binary-oxide particulate (or powder) in the growth chamber. In such short mean free path (e.g., flow-through furnace, or MOCVD system) configurations where gas phase reactions can occur, the temperature of the substrate can be increased to form high-quality films. Alternatively or additionally, in systems that use such higher pressures, the introduction of the reactants (e.g., one or more binary-oxide precursors and active oxygen) can be spatially controlled to reduce or minimize the regions within the chamber where gas phase reactions can occur. This can be useful to prevent solid oxide material from depositing on surfaces within the chamber or system other than the substrate. For example, the aperture of the active oxygen source can be positioned away from the aperture of the binary-oxide source within the chamber, and/or the active oxygen source can be oriented such that the beam of active oxygen species is directed to intersect with an opposite side of the substrate compared to the incident beam of binary-oxide precursors from the binary-oxide source, as shown in FIG. 8B.

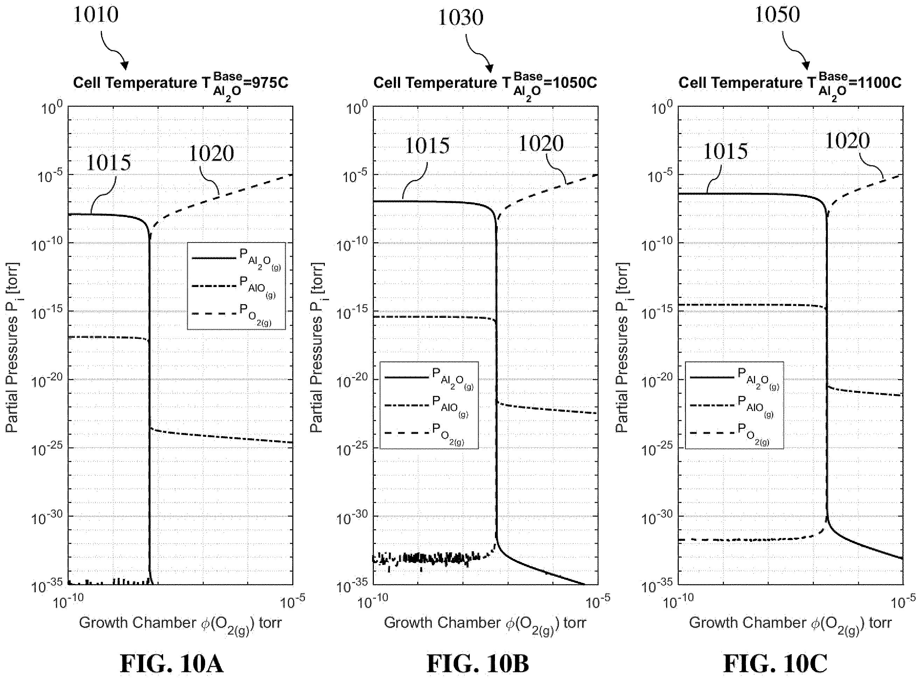

Referring now to FIGS. 10A-10C there are shown plots of the modelled partial pressures of $Al_2O$, $AlO$ and $O_2$ at the exit aperture of an $Al_2O$ precursor vapor cell as a function of growth chamber oxygen partial pressure for cell temperatures of 975°C (shown in plot 1010), 1050°C (shown in plot 1030), and 1100°C (shown in plot 1050) respectively in accordance with some embodiments. The $Al_2O$ precursor can be used to grow $Al_2O_3$ or $(Al_xGa_{1-x})_2O_3$ films, for example.

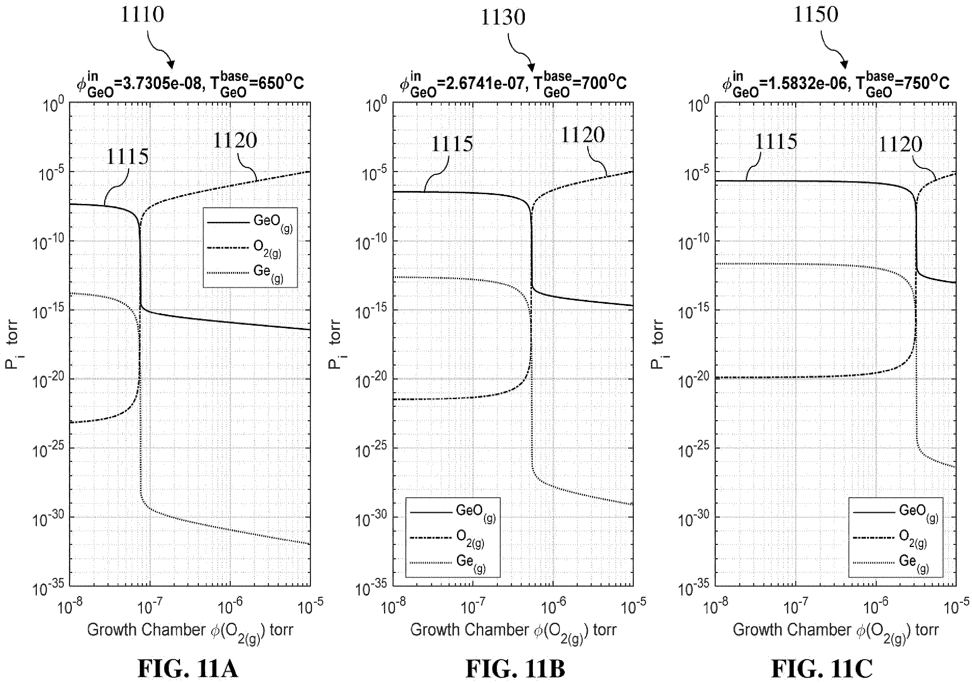

Referring now to FIGS. 11A-11C there are shown plots of the modelled partial pressures of Ge, GeO and $O_2$ at the exit aperture of a GeO precursor vapor cell as a function of growth chamber oxygen partial pressure for cell temperatures of 650°C (shown in plot 1110), 700°C (shown in plot 1130) and 750°C (shown in plot 1150) respectively in accordance with some embodiments. The GeO precursor can be used to grow $GeO_2$ or $(Si_xGe_{1-x})O_2$ films, for example.

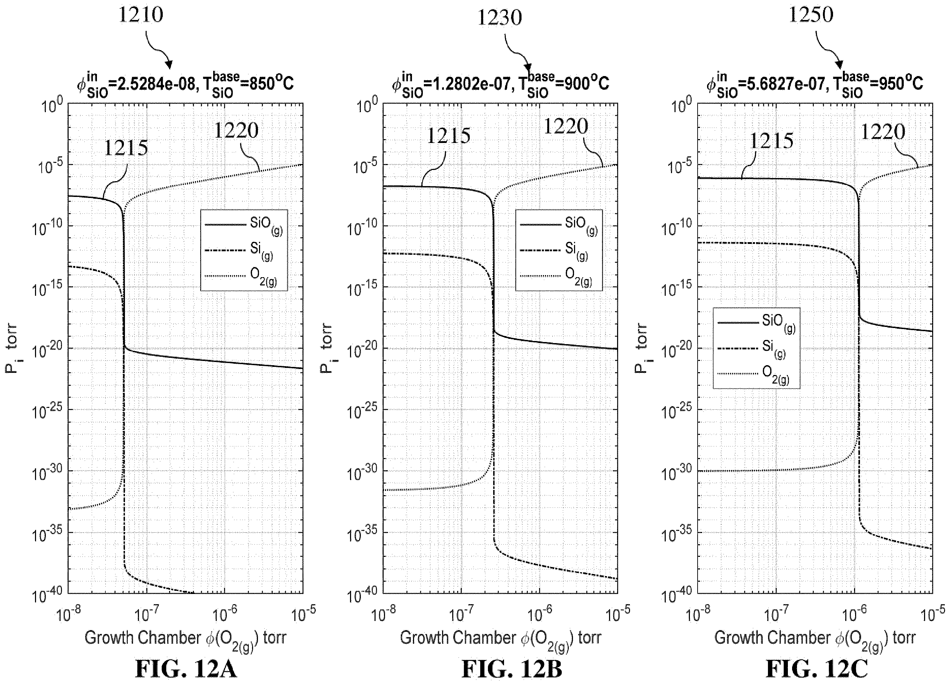

Referring now to FIGS. 12A-12C there are shown plots of the modelled partial pressures of Si, SiO and $O_2$ at the exit aperture of a SiO precursor vapor cell as a function of growth chamber oxygen partial pressure for cell temperatures of 850°C (shown in plot 1210), 900°C (shown in plot 1230) and 950°C (shown in plot 1250) respectively in accordance with some embodiments. The SiO precursor can be used to grow $SiO_2$ or $(Si_xGe_{1-x})O_2$ films, for example.

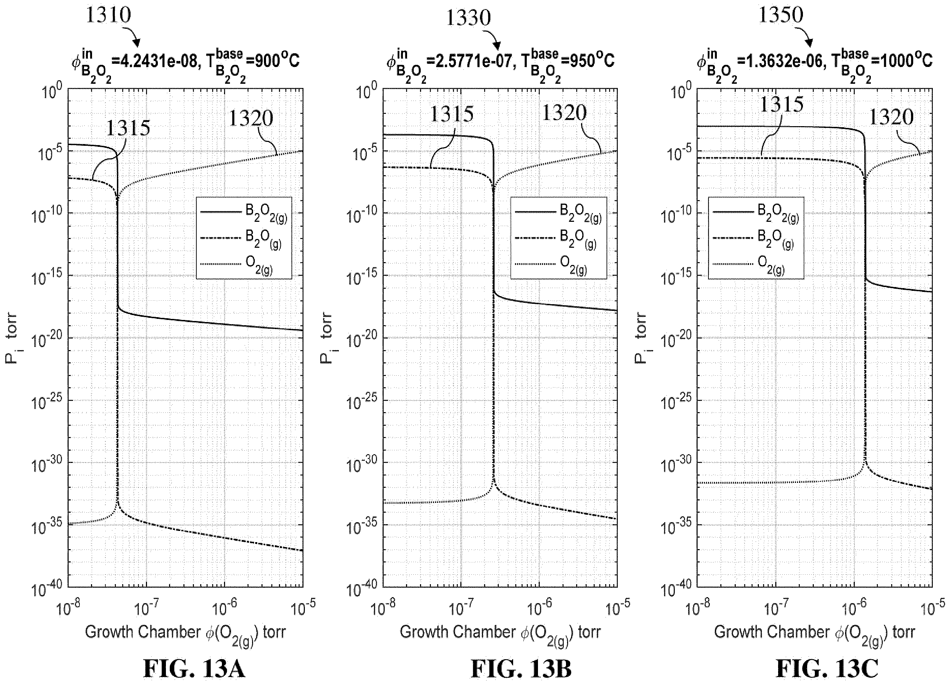

Referring now to FIGS. 13A-13C there are shown plots of the modelled partial pressures of $B_2O_2$, $B_2O$ and $O_2$ at the exit aperture of a $B_2O$ precursor vapor cell as a function of growth chamber oxygen partial pressure for cell temperatures of 900°C (shown in plot 1310), 950°C (shown in plot 1330) and 1000°C (shown in plot 1350) respectively in accordance with some embodiments. The $B_2O$ precursor can be used to grow $B_2O_3$ or $(B_xGa_{1-x})_2O_3$ films, for example.

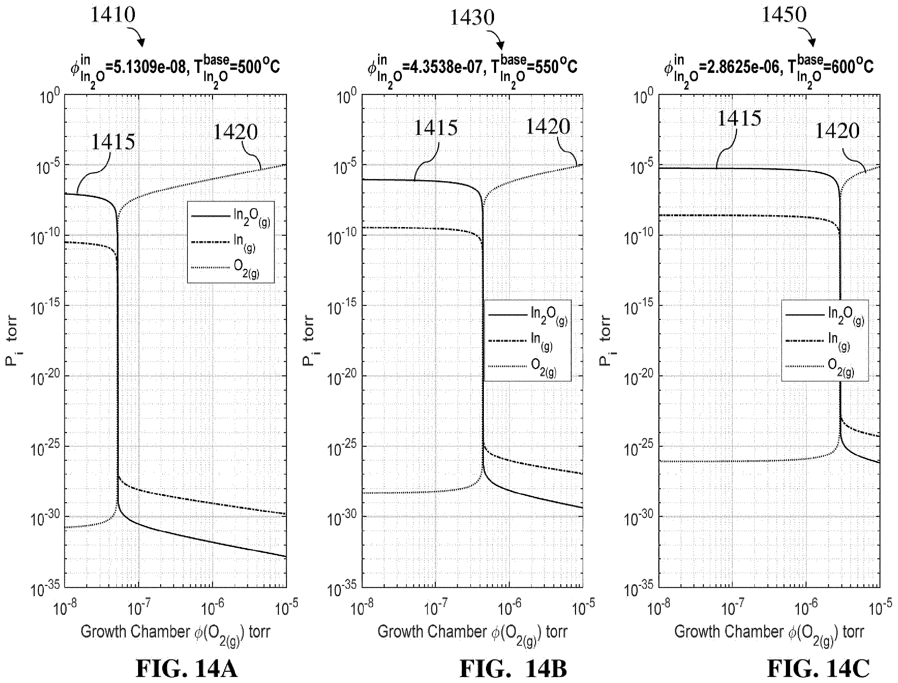

Referring now to FIGS. 14A-14C there are shown plots of the modelled partial pressures of $In_2O$, In and $O_2$ at the exit aperture of a $In_2O$ precursor vapor cell as a function of growth chamber oxygen partial pressure for cell temperatures of 500°C (plot 1410), 550°C (plot 1430) and 600°C (1450) respectively in accordance with some embodiments. The $In_2O$ precursor can be used to grow $In_2O_3$ or $(In_xGa_{1-x})_2O_3$ films, for example.

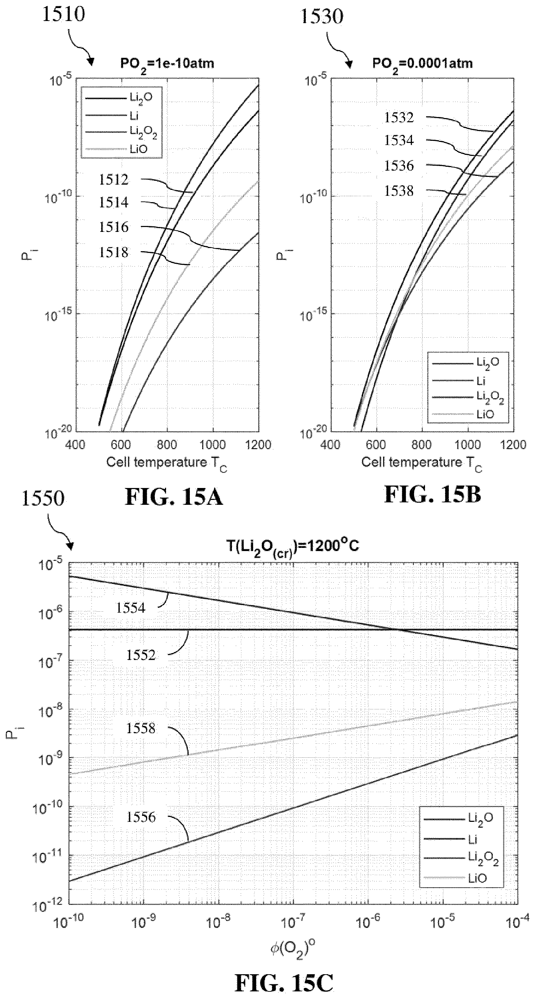

FIG. 15A-15B show plots of the modelled partial pressures of Li, LiO, $Li_2O$, and $Li_2O_2$ at the exit aperture of a $sLi_rO$ precursor vapor cell as a function of the cell temperature. Plot 1510 in FIG. 15A models a growth chamber oxygen partial pressure ($PO_2$) of 1e-10atm, and plot 1530 in FIG. 15B models a growth chamber oxygen partial pressure of 1e-4atm.

FIG. 15C shows a plot Y1550 of the modelled partial pressures of Li (1554), LiO (1558), $Li_2O$ (1552), and $Li_2O_2$ (1556) at the exit aperture of a $sLi_rO$ precursor vapor cell as a function of the growth chamber oxygen partial pressure ($\phi(O_2)^0$) at a temperature of 1200°C. At an oxygen partial pressure below about 2e-6 Torr, the source produces more elemental Li than $Li_2O$, and at an oxygen partial pressure above about 2e-6 Torr, the source produces more $Li_2O$ than elemental Li. As discussed further herein, high oxygen partial pressures can cause problems with condensation of solid lithium oxide species, however, in the case of lithium, it may be advantageous to operate at an oxygen partial pressure above about 2e-6 Torr in order to preferentially generate more $Li_2O$ than elemental Li. In some cases, it may be advantageous to operate at an oxygen partial pressure above about 2e-6 Torr and use one or more techniques to reduce the amount and/or impact of condensation (e.g., using a source with a heated open end or lip, as described further herein). The $sLi_rO$ precursor can be used to grow $Li_2O$ or $LiGaO_2$ films, for example.

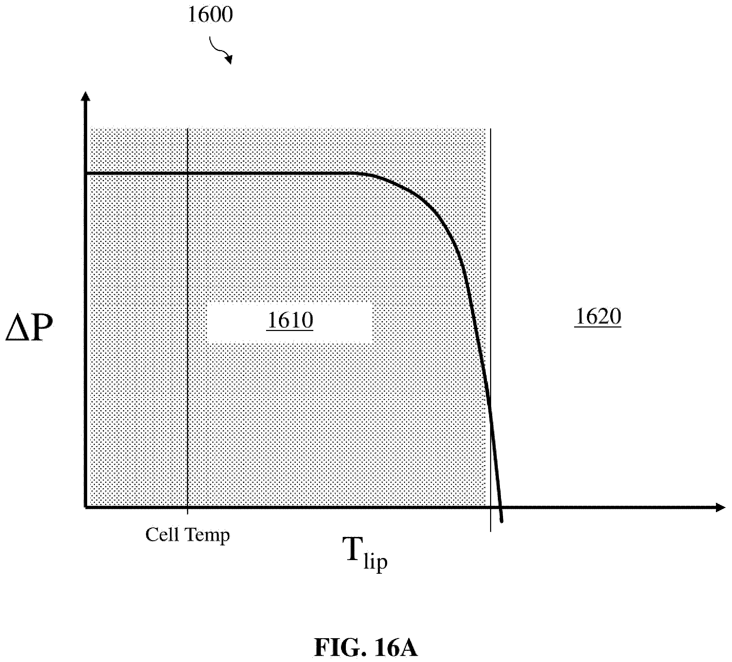

Referring now to FIG. 16A, there is shown a plot 1600 of the expected oxide condensation at the exit of the binary-oxide vapor source operating in a molecular oxygen containing environment as a function of exit temperature in accordance with some embodiments. The y-axis, $\Delta P$, is a difference in partial pressure that represents the sum of the equilibrium partial pressures of all Ga-containing (or group III containing) gas-phase species in the environment. $\Delta P$ is thus a measure of the loss of Ga vapor (or group III vapor) to the solid phase. In other words, $\Delta P$ is a measure of the driving force for the $Ga_2O_3$ (or group III oxide, e.g., $(Al_xGa_{1-x})_2O_3$) to form (or condense) from an input $Ga_2O$ precursor (or group III precursor) in the presence of oxygen reactants. A positive $\Delta P$ indicates that the group III element (e.g., Ga or Al) is being removed from the vapor and incorporated into solid binary oxde (e.g., $\beta$-$Ga_2O_3$). In contrast, a negative $\Delta P$ describes a condition where the vapor-phase Ga exceeds solid incorporation, which indicates an etching condition of the group III element (e.g., Ga or Al) from a solid group III oxide layer, or liquid Ga droplet formation. $\Delta P$ acts like a chemical potential imbalance, wherein the greater the difference between the incoming Ga supply and equilibrium vapor-phase retention, the stronger the driving force to grow the solid binary-oxide crystal.

The x-axis in FIG. 16A shows the temperature of a lip, or proximate to an open end, or at an open end, of a binary-oxide vapor source. Plot 1600 shows that if the lip is above a certain temperature, then there is less of a driving force for the solid oxide material to condense on the source. A binary-oxide source with a heated lip (as described herein) can be beneficial to limit or prevent the deposition or formation of the solid oxide material at the lip, thereby limiting or preventing material clogging the aperture of the source.

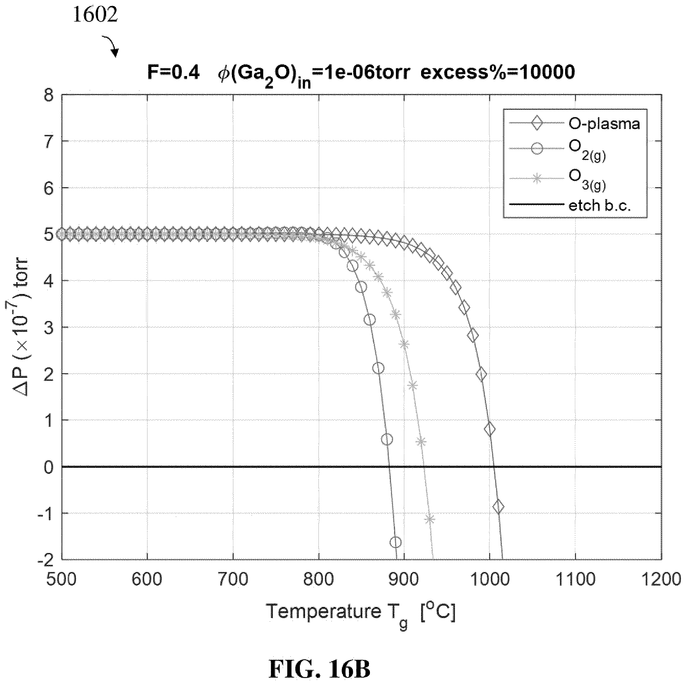

Referring now to FIG. 16B, there is shown a plot 1602 of the modelled expected $Ga_2O_3$ condensation at the exit of a $Ga_2O$ binary-oxide vapor source operating in different oxygen environments as a function of exit temperature in accordance with some embodiments. The y-axis is $\Delta P$, and the x-axis shows the temperature of the lip (or open end) of the binary-oxide vapor source. In this example, the input $Ga_2O$ precursor partial pressure is 1e-6 Torr. Plot 1602 shows that if the lip is above about 880°C for $O_{2(gas)}$ reactant, or 930°C for $O_{3(gas)}$ reactant, or 1010°C for oxygen plasma reactant, then there is less of a driving force for the solid oxide material to condense at the exit aperture of the source.

Plot 1602 is a plot of the thermodynamic reaction at the lip or exit aperture of the source and shows that for a certain lip temperature then material formation at the tip will be inhibited, since the elevated temperature will limit to stop the binary-oxide precursor from reacting with the molecular oxygen. Therefore, in some cases the lip is heated, for example at a temperature that is hotter than other regions of the source (as described further herein), so that it is thermodynamically unfavourable for the oxide condensate to be formed at or near the lip or exit aperture. Plot 1602 shows that heating the exit aperture (or lip) of the source to a different (e.g., hotter) temperature than a base (or bulk) of a source is one way of increasing the partial pressure of the binary-oxide precursor at the exit of the binary-oxide vapor source, which can limit the solid binary-oxide deposition given an oxygen partial pressure in the chamber.

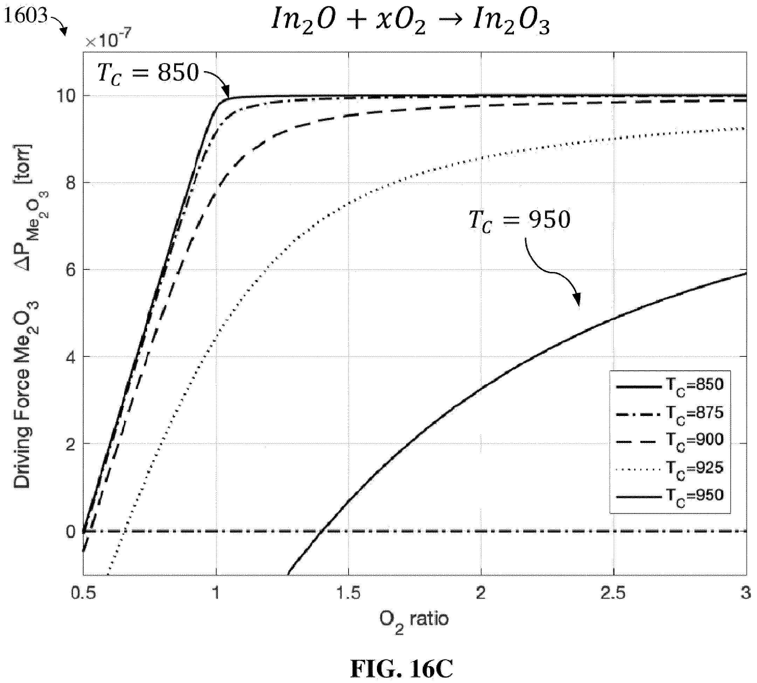

Referring now to FIG. 16C, there is shown a plot 1603 of the modelled thermodynamic process for $In_2O$(gas) reacting with $O_2$ and the driving force ($\Delta P$) for forming $In_2O_3$ solid. In the model. The driving force is shown on the y-axis, and the $O_2$ ratio, which is the partial pressure of $O_2$ divided by the partial pressure of $In_2O$(gas), is plotted on the x-axis. $In_2O$ gas is consumed according to the reaction $In_2O + xO_2 = In_2O_3$. The plot 1603 shows thermodynamic calculations for the driving force for forming a solid oxide material at an input pressure of $In_2O$ equal to 1e-6 Torr compared to the "$O_2$ ratio" and the temperature. At low temperatures, up to about 800°C, and at or below an $O_2$ ratio equal to one (i.e., the stoichiometric $O_2$ ratio, where x=1) all of the incident $In_2O$ gas is consumed according to the reaction above. When the $O_2$ ratio is increased to a value greater than 1 (e.g., when x>1), then there is an excess, or overpressure, or background, of $O_2$ and no further increase in deltaP (or growth rate of $In_2O$; film) occurs.

Plot 1603 shows a series of modelled curves representing temperature (e.g., of an output aperture of a binary-oxide source, or of a substrate upon which an oxide layer is deposited) from 850°C to 950°C, in 25°C increments. The curves in plot 1603 show that there is a dramatic decline in the driving force for $In_2O_3$ solid creation with increasing temperature. The curves in plot 1603 also show that higher $O_2$ ratios can significantly increase the driving force for solid oxide formation, especially at higher temperatures. In some cases, the temperature at the output aperture of a binary oxide source can be increased in order to prevent or limit solid oxide deposition, especially in cases when higher $O_2$ ratios are used (e.g., greater than 1, or greater than 2). In some cases, the $O_2$ ratio can be increased to values greater than 1 (e.g., to greater than about 1.5, greater than about 2, or greater than about 2.5), in order to increase the driving force and growth rate for solid $In_2O_3$ layer creation, especially when higher temperatures are used (e.g., greater than 850°C).

In some cases, an $In_2O$ suboxide source can be placed within an $O_2$ ambient environment, and $In_2O_3$ solid creation can be inhibited by selecting a sufficiently large temperature at the exit orifice or aperture to reduce the deposition and build-up of solid $In_2O_3$ thereupon. For example, the suboxide sources (i.e., binary-oxide sources) described herein can be utilized with an active oxygen species such as atomic O or $O_3$ (which produces atomic O by decomposition) to deposit a solid oxide material (e.g., a solid oxide layer upon a substrate). The cracking efficiency of atomic oxygen (e.g., of RF generated atomic oxygen) is low and can be from about 1% to about 10%. Thus, a large amount of $O_2$ can be present within the deposition chamber in addition to the active oxygen species needed for growth. The large background of $O_2$ within the chamber can interact with the suboxide source and deposit solid oxide on the source, potentially changing the beam profile and/or uniformity, and in some cases clogging one or more exit apertures of the source.

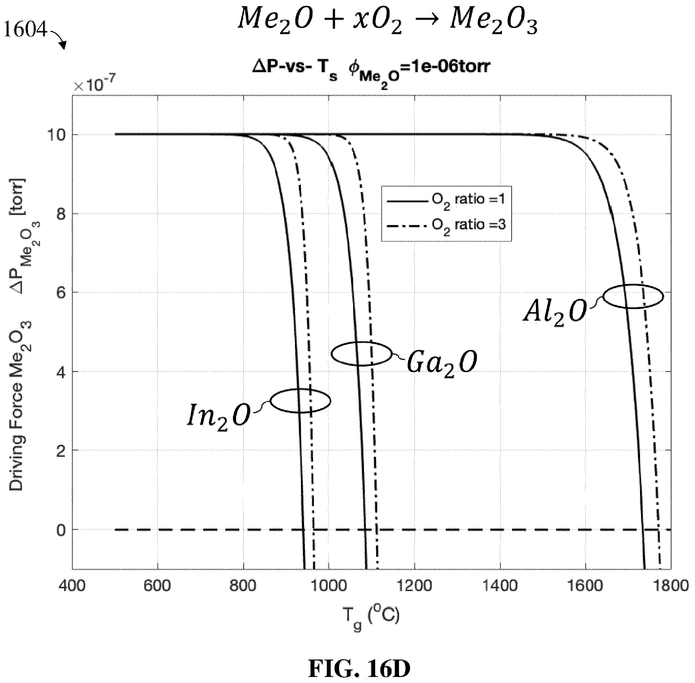

Referring now to FIG. 16D, there is shown a plot 1604 of the modelled thermodynamic driving force for three suboxide, or binary-oxide precursor, specie $Me_2O$, where Me=(In, Ga, or Al). Plot 1604 shows cases of forming $Me_2O_3$ solid as a function of temperature (on the x-axis) for two cases of "$O_2$ ratio," a stoichiometric $O_2$ ratio equal to 1 (solid curves), and $O_2$-rich conditions where the $O_2$ ratio equals 3 (dot-dashed curves). Plot 1604 show that an excess $O_2$ forces the high temperature roll off (or reduction in driving force) to occur at higher temperatures. Similar calculations can also be performed and curves similar to those shown in plot 1604 can be drawn for the other suboxide, or binary-oxide precursor, species described herein, for example, GeO, BO, $BO_x$, and SiO. Similar modeling can also be done to simulate etching conditions, wherein the driving force ($\Delta P$) is less than zero.

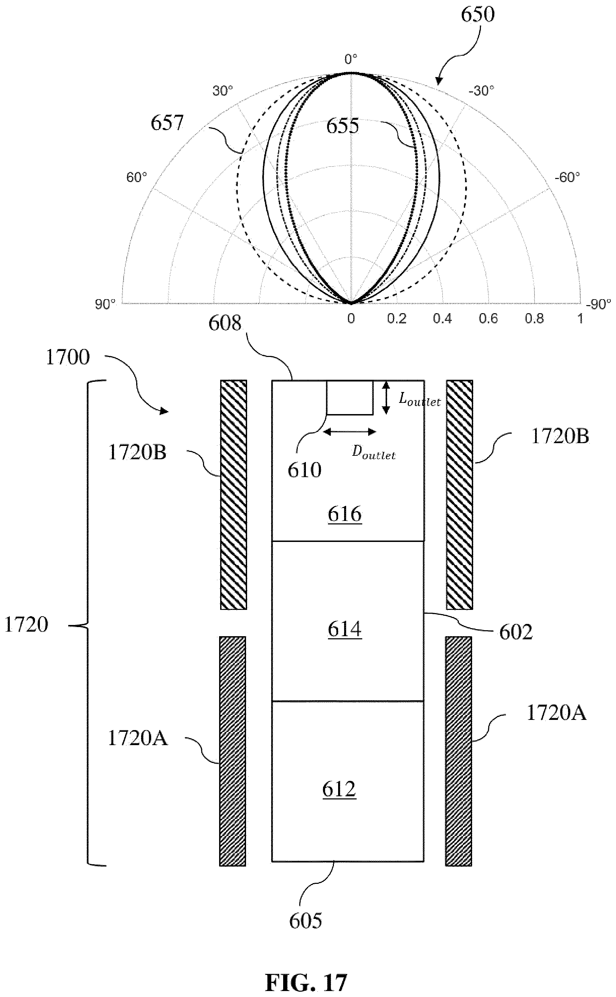

Referring now to FIG. 17, there is shown a figurative view of a binary-oxide vapor source 1700 comprising a multizone (2-zone) heating arrangement 1720 for differentially heating regions of the binary-oxide vapor source in accordance with some embodiments.

In this example, vapor source 1700 is similar to vapor source 600 shown in FIG. 6A except that instead of a heating arrangement comprising a single heating zone 620 (see FIG. 6A), vapor source 1700 includes a heating arrangement comprising two-zone heating arrangement 1720 comprising two separately controllable heater zones 1720A, 1720B to differentially heat vapor source 1700 to different temperatures at different locations along the length of vapor source 1700. Heater zones 1720A, 1720B can include resistive heaters, radiative heaters, or any type of heaters capable of providing heat to the source 1700. For example, in some cases, the crucible is at least partially in a vacuum chamber such that there is a vacuum gap between at least a portion of heater zones 1720A, 1720B and vessel 602. In such cases, at least a portion of heater zones 1720A, 1720B are radiative heaters that transfer heat to the vessel 602 radiatively through the vacuum gap.

In this example, the heating arrangement comprises two zones. The first heater zone 1720A heats the base region comprising the majority of the wetted and semi-wetted regions to drive the thermodynamics reaction to create the binary-oxide precursor while the second heater zone 1720B heats the tip region (e.g., in accordance with the modelling results shown in FIG. 16) to reduce or prevent condensation of solid oxide material.

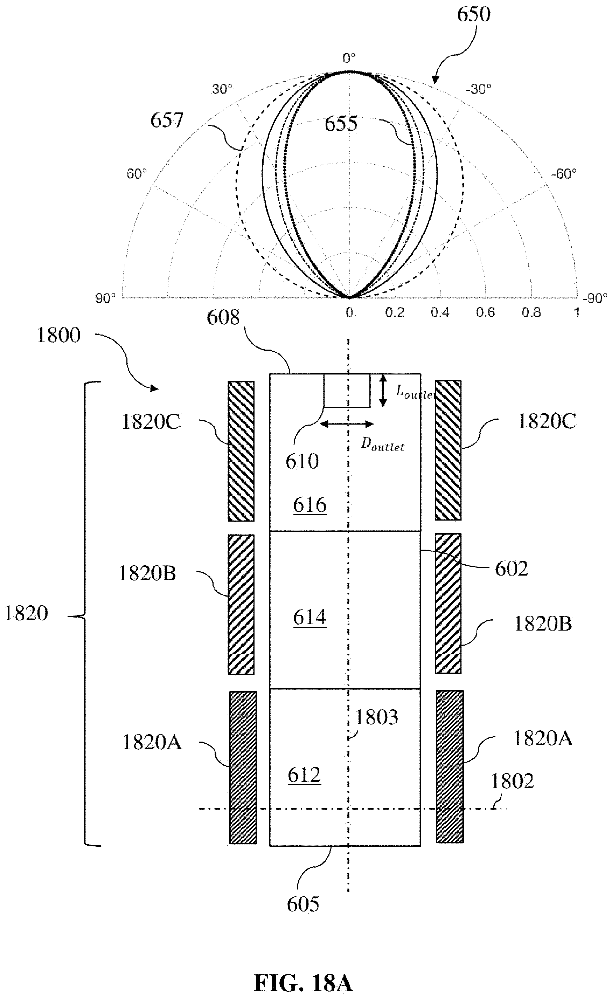

FIG. 18A is a figurative view of a binary-oxide vapor source 1800 comprising a multizone heating arrangement 1820 for differentially heating regions of the binary-oxide vapor source in accordance with some embodiments. This example includes three heating zones.

In this example, vapor source 1800 is equivalent to vapor source 600 shown in FIG. 6A or vapor source 1700 shown in FIG. 17 except that instead of a heating arrangement comprising a single heating zone 620 (see FIG. 6A) or two heating zones 1720A, 1720B, vapor source 1800 includes a heating arrangement comprising three-zone heating arrangement 1820 involving three separately controllable heaters 1820A, 1820B, 1820C to differentially heat vapor source 1800 at different locations along the length of vapor source 1700 to respective predetermined temperatures for even better control of the thermodynamic reactions driving the creation of the binary-oxide precursor. The additional control provided by the three separately controllable heaters 1820A, 1820B, 1820C can be beneficial, for example, to independently control the temperature of the elemental material in region 612 and the reaction (e.g., semi-wetted) region 614. For example, the elemental material temperature can be controlled using heater 1820A to be a solid or a liquid, and to evaporate or sublime at a certain rate, while the heater 1820B can be used to independently control the temperature in the reaction region 614 to drive the formation of particular species of binary-oxide precursors. The heater 1820C can again be used to heat the open end or tip of the source, for example, to prevent condensation and clogging. Heaters 1820A, 1820B, 1820C can include resistive heaters, radiative heaters, or any type of heaters capable of providing heat to the source 1800. For example, in some cases, the crucible is at least partially in a vacuum chamber such that there is a vacuum gap between at least a portion of heaters 1820A, 1820B, 1820C and vessel 602. In such cases, at least a portion of heaters 1820A, 1820B, 1820C are radiative heaters that transfer heat to the vessel 602 radiatively through the vacuum gap.

In some cases, heaters 1820A, 1820B, 1820C are shaped like collars arranged concentrically around the regions of the source 1800. For example, the source 1800 could have an approximately cylindrical geometry and heaters 1820A, 1820B, 1820C can have annular cross-sections. In another example, the source 1800 could be shaped like a prism with approximately rectangular cross-sections and heaters 1820A, 1820B, 1820C can have approximately rectangular annular cross-sections.

In some cases, the binary-oxide sources can include more than three zones (e.g., four zones, six zones, or ten or more zones). For example, separate heating zones can be arranged in layers (e.g., as shown in FIG. 18A) and there can be four, or six, or more than six layers to provide finer control of the temperatures and temperature gradients in each region 612, 614 and 616 of source 1800. In some cases, separate heating zones can be arranged in layers (e.g., as shown in FIG. 18A) where each layer includes separately controllable heating zones around a circumference of the source 1800.

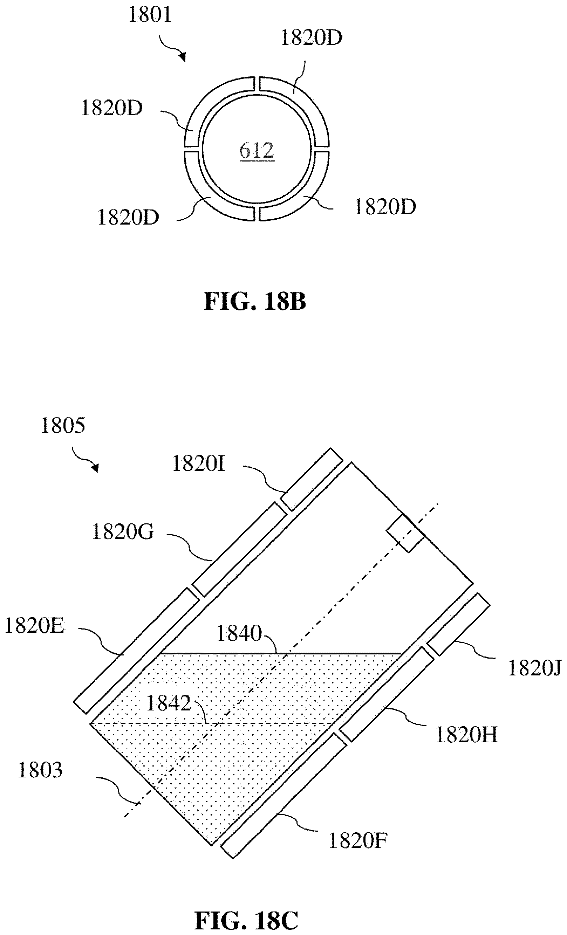

FIG. 18B shows a simplified schematic of a cross-section 1801 of source 1800 at plane 1820 in accordance with some embodiments. Inset 1820 shows an example where the first wetted region 612 (where the solid binary-oxide members are immersed in the liquid elemental component) includes four heaters 1820D distributed circumferentially around a source 1800 with a cylindrical geometry. In some cases, source 1800 can include more than three heating zone layers, and each layer can include separately controllable heaters. Such arrangements can be beneficial, for example, when source 1800 is mounted in a system at an angle (e.g., as shown in FIG. 8B). In such cases, the liquid level of the elemental component can be at an angle relative to the central axis 1803 of the source. Therefore sources 1800 with arrangements including separately controllable heaters (both in depth and circumferentially) can beneficially be used to heat certain the areas of the source 1800 that include certain components (e.g., those with liquid elemental component at an angle relative to the central axis) to a first temperature, and second regions (e.g., those without liquid elemental component) can be heated to a different second temperature, and yet other third regions (e.g., regions at or near the lip) can be heated to yet another third temperature.

FIG. 18C shows a simplified schematic of a cross-section of an example of a binary-oxide precursor source 1805 in accordance with some embodiments. Source 1805 is shown installed at an angle, e.g., as shown in the system in FIG. 8B, and therefore has a liquid level 1840, 1842 that is at an angle with respect to the central axis 1803 of the source. The heaters 1820E-1820J are arranged in three layers similar to heaters 1820A-1820C shown in FIG. 18A. The heaters 1820E-1820J only cover half of the source 1805 rather than wrapping all the way around, and are independently controllable. The heaters in source 1805 have different lengths, where the heaters 1820E and 1820F are longer than the heaters 1820G and 1820H. As the liquid elemental component is consumed through forming the binary-oxide precursor, then the liquid level will drop from level 1840 to 1842. In some cases, the temperature of the heaters can be adjusted over time, for example, to account for a changing amount and level of the liquid elemental component. For example, when the liquid level is high, e.g., as shown by liquid elemental component level 1840, then heaters 1820E, 1820F, and 1820H can be set at a temperature corresponding to that of the liquid elemental component. When the liquid elemental component level falls to 1842, then heater 1820F, or heaters 1820E and 1820F, can be set at a temperature corresponding to that of the liquid elemental component.

Each heater for the binary-oxide sources shown herein (e.g., in FIGs. 6A and 17-18C) can have its own thermocouple such that it can be separately controlled using a controller coupled to the thermocouple and the heater. The thermocouple can be mounted inside the region 612, 614, 616, or between the heater 1820A, 1820B, 1820C, and optionally 1820D, and the vessel 602, or on a surface towards or away from the vessel 602 and the and the controller can use a feedback loop to keep the temperature heater 1820A, 1820B, 1820C, and optionally 1820D.

In some cases, the binary-oxide sources described herein (e.g., binary-oxide sources 850, 1700, 1800, 1805, and 1900) can be coupled to one or more sensors (e.g., sensor 855 in FIG. 8A) and the binary-oxide source can be controlled using closed-loop feedback based on information from the sensor(s). The binary-oxide source can be coupled to a processor which is used to control the source. The processor can also be coupled to the one or more sensors and can be used to control the binary-oxide source using the information from the sensor(s). For example, the sensor can be an RGA or a BFM, and the processor can control a temperature setpoint of one or more heater zones of the binary-oxide source to maintain or target a binary-oxide precursor flux measured by the sensor. In this example, the processor would use information from the RGA and/or BFM sensor(s) to control the temperature setpoint, and the processor can also control one or more heaters of the binary-oxide source using information from a thermocouple. This can be advantageous since the flux of the precursor species can drift over time, and the active closed-loop feedback described above can improve the stability of the flux which can enable improved control over the composition, thickness, and/or material quality of the growing films.

In some cases, the heater zones of the binary-oxide sources described herein can be controlled to target a particular composition or ratio of species emitted from the source using closed-loop feedback based on one or more sensors. For example, an RGA can be used to determine the ratio of elemental species to binary-oxide precursor species in an environment by controlling heaters in a zone containing the liquid elemental component and heaters in zones where the reactions between the elemental component vapor reacts with the solid material within the source.

The vapor sources 600, 1700 and 1800 in FIGS. 6A, 17, 18A, and 18B show side-view cross sections of the sources, which can be cylindrically shaped or shaped like rectangular prisms, in different examples. In such cases, the heaters 620, 1720A, 1720B, 1820A, 1820B, and 1820C can be shaped like cylindrical or rectangular annuluses around the sources. Additionally, the heaters 1720A, 1720B, 1820A, 1820B, and 1820C in the multi-zone systems of FIGS. 17, 18A, and 18B can be longer or shorter than the examples shown, such that the temperature zones of the vapor sources are longer or shorter than those shown.

In another example, differential pumping of the growth chamber may be employed where an inlet for the vacuum pumping system is positioned proximal to the exit aperture of the binary-oxide precursor source to reduce the $O_2$ partial pressure in this region to be lower than that of the average oxygen partial pressure in the growth chamber.

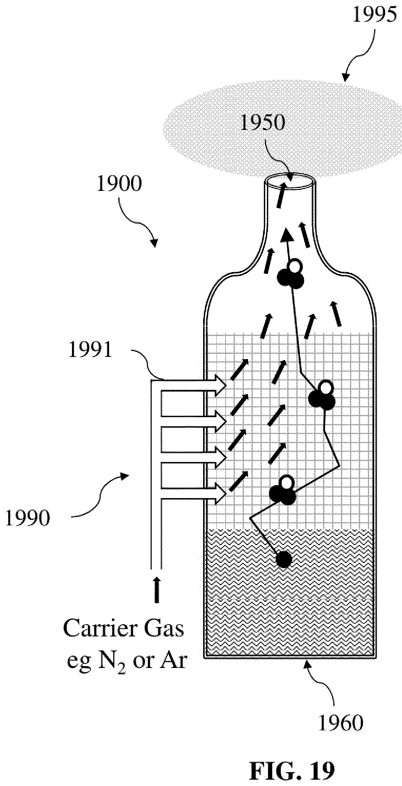

Referring now to FIG. 19, there is shown a binary-oxide vapor source 1900 comprising a condensation reduction arrangement 1990 in accordance with some embodiments. In this example, condensation reduction arrangement 1990 is configured to introduce an inert carrier gas into vapor source 1900 at a partial pressure sufficient to flow out of the open end 1950 of vapor source 1900 and form a curtain or region 1995 of inert gas at the open end 1950 to displace molecular oxygen or any other active oxygen species that will react with the binary-oxide precursor to form an oxide condensate. As a result, condensation reduction arrangement 1990 can prevent or substantially reduce the formation of any oxide condensate. Such a carrier gas curtain can also prevent species (e.g., molecular oxygen or any other active oxygen species) from entering the source through the aperture(s) at the open end 1950. In this example, the inert carrier gas is introduced by an inlet manifold 1991 comprising one or more inlets to deliver the inert gas into vapor source 1900 at the required partial pressure. In some cases, the inlets of the condensation reduction arrangement 1990 can be located in the second and/or third regions of the source (as described herein) above a level of a liquid elemental component, to introduce the carrier gas into the voids of the solid binary-oxide members.

In some cases, the inert gas is nitrogen ($N_2$). In another example, the inert gas is Argon (Ar). As would be appreciated, any other suitable non-reactive or inert gas or inert gas mixture may be used as the carrier gas depending on requirements. As an example, the use of Ar may be beneficial given the relative heaviness of this gas resulting in an inert gas curtain or region 1995 which remains near to the open end 1950 of vapor source 1900, in some embodiments.

The one or more inlets of inlet manifold 1991 are shown in the side wall of vapor source 1900 in FIG. 19. In other cases, the inlets can be arranged in other locations of the vapor source 1900. For example, one or more inlets can be positioned at or closer to the otherwise closed end 1960, or closer to open end 1950, of vapor source 1900.

In some cases, the binary-oxide vapor sources described herein can be used as remote sources in physical vapor deposition (e.g., MBE) systems or chemical vapor deposition (e.g., MOCVD) systems. In such cases, it may be beneficial to use a carrier gas (e.g., an inert gas like nitrogen or argon) to transport a generated binary-oxide vapor precursor from a binary-oxide vapor source to a growth chamber (e.g., a vacuum chamber, or a quartz tube furnace). The inlet manifold 1991 in FIG. 19 could be used to introduce the carrier gas to the source 1900 to transport the generated binary-oxide vapor precursor out of the open end 1950 of the source 1900 to a growth chamber (e.g., coupled to the source using a conduit).

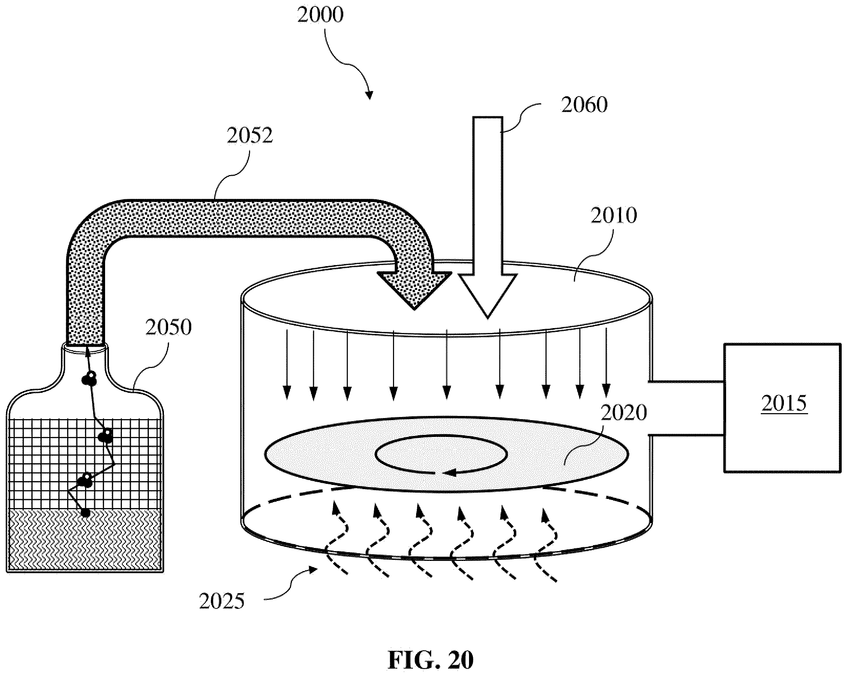

Referring now to FIG. 20, there is shown a system overview diagram of a deposition system 2000 comprising a remote binary-oxide vapor source 2050 and an active oxygen containing species 2060 for depositing an oxide layer on a substrate 2020 in accordance with some embodiments. Substrate 2020 may be rotating in some cases, as shown by the arrow in the figure. At higher pressures (e.g., above 1e-4 Torr), the precursor produced from the binary-oxide vapor source 2050 and the active oxygen containing species 2060 will mix together in growth chamber 2010. Growth chamber 2010 can be configured so that a binary-oxide precursor 2052 (optionally mixed with a carrier gas) reacts with the active oxygen containing species 2060 to form an oxide layer on substrate 2020 which is typically heated as shown by arrows 2025 during the deposition process. For example, a resistive heater or a radiative heater can be used to heat substrate 2020. Pump 2015 is coupled to growth chamber 2010 to remove unreacted species, the carrier gas, and other gases from the chamber.

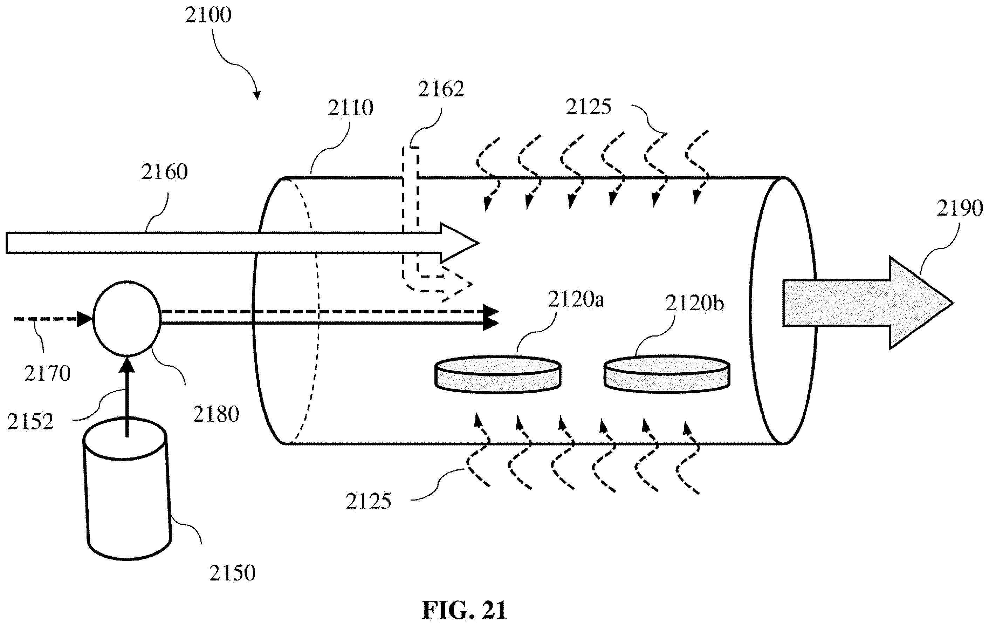

Referring now to FIG. 21, there is shown a system overview diagram of a flow-through furnace type of a deposition system 2100 comprising a remote binary-oxide vapor source 2150 and an active oxygen containing species 2160 for depositing an oxide layer on substrates 2120a and 2120b in accordance with some embodiments. Deposition system 2100 further comprises a growth chamber 2110, which can be at a pressure less than, approximately equal to, or greater than atmospheric pressure. In some cases, growth chamber 2110 can be or include a quartz tube. In this example, carrier gas 2170 is mixed with a binary-oxide precursor 2152 using mixer 2180, and the carrier gas 2170 is used to convey (or transport) the binary-oxide precursor 2152 from the remote binary-oxide vapor source 2150 to the growth chamber 2110. In the growth chamber 2110, the binary-oxide precursor 2152 reacts with the active oxygen containing species 2160 to form oxide layers on substrates 2120a, 2120b, which are typically heated (arrows 2125) during the deposition process. In some cases, source 2150 can be similar to source 1900 shown in FIG. 19, wherein the carrier gas is input into the source 2150 to convey the binary-oxide precursor from the source 2150 to the chamber 2110, and in such cases, mixer 2180 can be omitted. A pump can be coupled to growth chamber 2110 to remove unreacted species, the carrier gas, and other gases 2190 from the chamber. In this example, binary-oxide vapor source 2150 is configured to be remote from growth chamber 2110 (i.e., located outside and/or spaced from the growth chamber) and in this example includes a carrier gas arrangement to assist in conveying the binary-oxide precursor 2152 from the binary-oxide vapor source 2150 to the growth chamber 2110.

In some cases, a relatively high pressure (e.g., above 1e-4 Torr) is used in the growth chamber 2110. In some cases, the high pressure causes gas phase reactions to occur, where solid oxide particulates (or powder) are formed in the growth chamber 2110. The temperature of the substrates 2120a and 2120b can be increased in such cases to accommodate for the particulate (or powder) formation and grow high quality binary-oxide films.

In some cases, the binary-oxide precursor 2152 and the active oxygen containing species 2160 are input into the chamber 2110 at different locations that are spatially separated from one another to limit their interaction in the gas phase environment of the chamber. For example, active oxygen containing species 2162 can be input into the chamber closer to the substrates 2120a, 2120b, than the binary-oxide precursor 2152 to limit the reactions between them.

In some cases, the binary-oxide precursors described herein can be used as replacements for conventional metal organic precursors, for example, in MOCVD and ALD systems and methods. This can be advantageous, since the binary-oxide precursors described herein can enable the growth of epitaxial layers with lower impurity levels than conventional (e.g., carbon-containing) metal organic precursors. Not to be limited by theory, conventional metal organic precursors tend to incorporate some of their non-metal elements (e.g., carbon) into a growing layer, while the binary-oxide precursors described herein will only contribute metal and oxygen to the growing crystal.

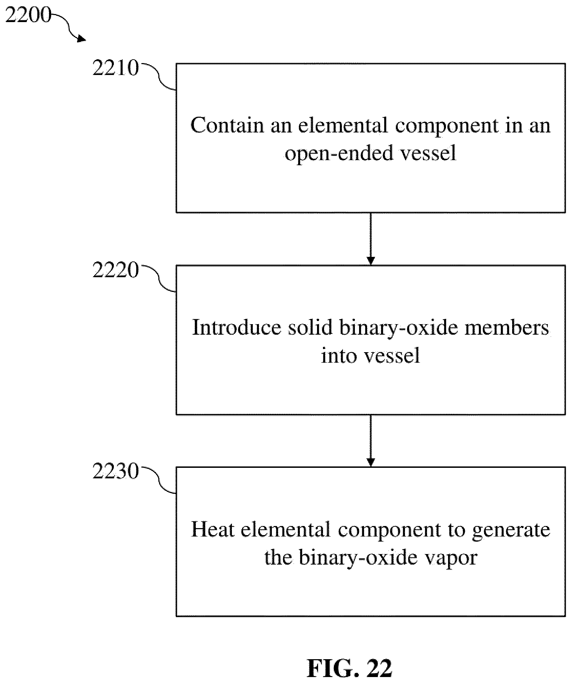

FIG. 22 is a flowchart of a method 2200 for generating a binary-oxide vapor precursor. The binary-oxide precursor can be used for a deposition process where a layer of an oxide material is deposited on a heated substrate by reacting the binary-oxide vapor precursor with active oxygen containing species (e.g., an oxygen plasma containing atomic oxygen and/or one or more activated forms of oxygen) to form the solid binary-oxide layer on the substrate. In some cases, the deposited oxide material is the corresponding solid binary-oxide form of the binary-oxide. For example, the deposition process can be performed using a molecular beam epitaxy (MBE) machine and the binary-oxide vapor precursor can be generated using a source of the MBE machine. In other examples, the binary-oxide vapor precursor can be used in a deposition process performed by another epitaxial growth technique, such as molecular-organic chemical vapor deposition (MOCVD), atomic layer deposition (ALD), or others.

The present articles, systems, and methods utilizing the binary-oxide vapor precursors described herein can be advantageous, for example, to increase the growth rate of a material being deposited. For example, the deposition rate of an epitaxial oxide material (e.g., in an MBE, MOCVD or ALD process) can be increased using the binary-oxide vapor precursors described herein. Conventional epitaxial oxide deposition in an MBE system utilizes one or more elemental beams and an activated oxygen source (e.g., an oxygen plasma source). In contrast, the binary-oxide vapor precursors described herein can provide a higher flux of oxygen than a conventional activated oxygen source (e.g., an oxygen plasma source). The oxygen flux is the limiting reactant to form the epitaxial oxide materials in conventional epitaxial growth systems (e.g., MBE), and therefore, the higher flux of oxygen enabled by the binary-oxide vapor precursors described herein can enable a higher growth rate of the epitaxial oxide material (e.g., in MBE systems, and other epitaxial growth systems).

In some cases, the present articles, systems, and methods can be used in a deposition system (e.g., an MBE system) where the binary-oxide vapor precursors described herein are utilized in combination with one or more elemental beams, and optionally an activated oxygen source (e.g., an oxygen plasma source), to grow the epitaxial oxide materials described herein. For example, the one or more elemental beams can be a metallic elemental beam, or a beam of another element, that will react with oxygen to form the oxide material.

Method 2200 for generating a binary-oxide vapor precursor includes blocks 2210, 2220, and 2230. At block 2210, an elemental component corresponding to a non-oxide component of the binary-oxide vapor precursor to be generated is contained with an open-ended vessel including a closed end and a vessel wall that extends from the closed end to an open end.

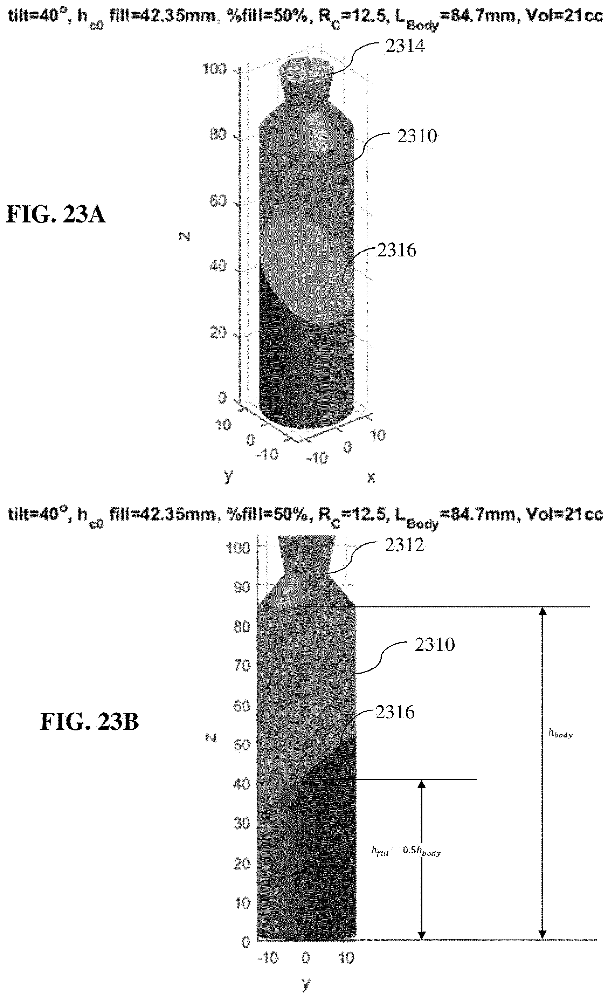

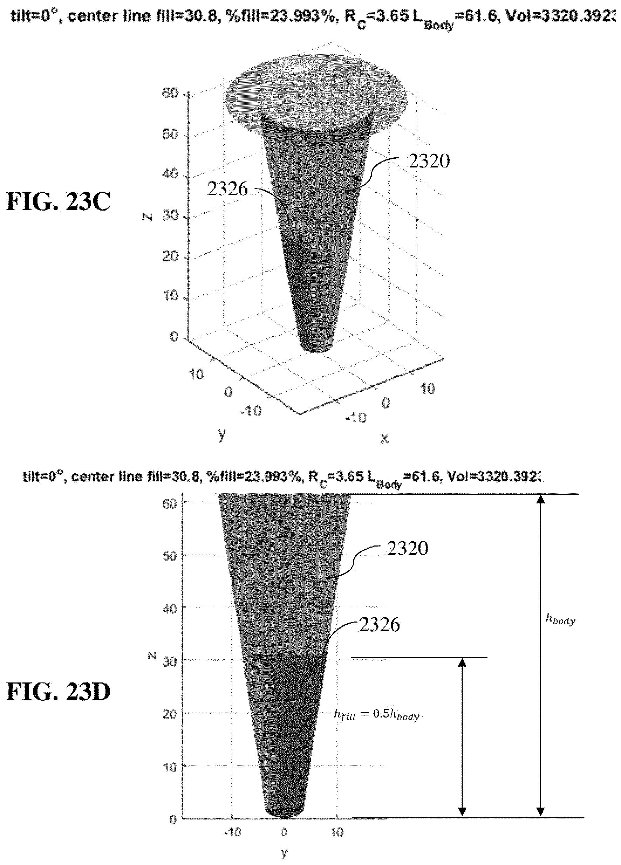

FIGS. 23A-23B illustrate an example of a vessel 2310 (alternatively referred to as a crucible or container) with a geometry that may be used in a binary-oxide vapor source of the present disclosure, in accordance with some embodiments. A component 2316 (e.g., a liquid component, an elemental component, or a mixture of an elemental component and solid binary-oxide members) is shown in the figures with a level that is at an angle (approximately 40°). For example, the source can be integrated into a vacuum chamber (as described further herein) and be positioned at an angle to direct an emitted beam at a substrate in the chamber (e.g., in systems such as system 802 in FIG. 8B). In other cases, vessel 2310 can be used as a vessel in a remote source (as described further herein), and in such cases the vessel can be oriented vertically or at an angle. The vessel 2310 has an approximately cylindrical shape, with a closed end (approximately at z=0) and an open end (approximately at z=100). Vessel 2310 also has a constriction region 2312 towards the open end, which then flares out into a cone 2314 at the open end. In other cases, the vessel for the binary-oxide precursor sources described herein can be taller or shorter, and wider or narrower, than the vessel 2310 shown in FIGs. 23A-23B.

FIGS. 23C-23D illustrate another example of a vessel 2320 (or crucible) with a geometry that may be used in a binary-oxide vapor source of the present disclosure, in accordance with some embodiments. A component 2326 (e.g., a liquid component, an elemental component, a mixture of an elemental component and solid binary-oxide members) is shown in the figures with a level that is horizontal which would occur when the vessel is used upright as shown in the figure. For example, the source can be integrated into a vacuum chamber (as described further herein) or be used as a vessel in a remote source (as described further herein) and be positioned upright. The vessel 2320 is approximately cone shaped with a rounded (rather than pointed) bottom at a closed end (at approximately z=0). Vessel 2320 has a wide opening towards an open end (approximately at z=100).

Both vessels 2310 and 2320 in FIGS. 23A-23D have shapes that have relatively wide openings at the open end, which can be beneficial, for example, to prevent clogging. The geometry of the vessel can also contribute to (or determine) a beam flux spatial distribution emitted from the sources described herein. In some cases, the binary-oxide vapor sources of the present disclosure can include vessels 2310 and 2320 and an aperture plate, for example, as shown in FIGS. 6B and 6C.

Vessels 2310 and 2320 are just two examples of vessel geometries that can be used in the binary-oxide vapor sources described herein, and in some embodiments other vessel geometries can be used. For example, geometries like that of vessel 2310 with wider or narrower constriction regions and openings at the open end may be used.

Continuing with method 2200, at block 2220, one or more solid binary-oxide members are introduced into the open-ended vessel to form a contained aggregate structure of binary-oxide members within the vessel wall and closed end of the open-ended vessel. Each of the one or more solid binary-oxide members corresponds to a solid binary-oxide stoichiometric form of the binary-oxide vapor precursor to be generated.

In an example, the binary-oxide members are in the form of elongate rods that extend part way or fully along the vessel.

In an example, the binary-oxide members are in the form of spheres of constant diameter.

In an example, the binary-oxide members are in the form of spheres of varying diameter.

In an example, the binary-oxide members are in the form of cylinders or pellets of constant diameter and length.

In an example, the binary-oxide members are in the form of cylinders or pellets of varying diameter and/or length.

In an example, the binary-oxide members are in the form of solid ellipsoids of constant dimensional size.

In an example, the binary-oxide members are in the form of solid ellipsoids of varying dimensional size.

In an example, the binary-oxide members are in the form of non-regular shaped solids of substantially constant dimensional size.

In an example, the binary-oxide members are in the form of non-regular shaped solids of varying dimensional size.

In some cases, the binary-oxide members can be in the form of one or more of: elongate rods that extend part way or fully along the vessel; spheres of constant diameter; spheres of varying diameter; cylinders or pellets of constant diameter and length; cylinders or pellets of varying diameter and/or length; solid ellipsoids of constant dimensional size; solid ellipsoids of varying dimensional size; non-regular shaped solids of substantially constant dimensional size; and non-regular shaped solids of varying dimensional size.

For those examples where the binary-oxide members vary in size, in another example the sizes of the binary-oxide members are selected from a predetermined size distribution. For example, the size distribution can be approximately normal, Gaussian, unimodal, or multimodal. In some cases, the binary-oxide members comprise a plurality of members (e.g., particles, granules, spheres, rods, etc.) having a bi-modal or multi-modal size distribution (e.g., small particles mixed with large particles to improve packing density).

In another example, individual binary-oxide members may be selected from any of the examples referred to above.

In an example, the elemental component is in liquid form, the density of the binary-oxide members is greater than the density of the elemental component in liquid form, and the contained aggregate structure is fully or partially immersed in the liquid elemental component.

In an example, the elemental component is in liquid form, and the contained aggregate structure comprises binary-oxide members dispersed through the liquid elemental component.

In an example, the density of the binary-oxide members is less than the density of the elemental component in liquid form, and the contained aggregate structure comprises binary-oxide members dispersed over the surface of the liquid elemental component.

In an example, the contained aggregate structure is a close-packed column of binary-oxide members extending along a portion of the length (along the closed end to the open end) of the open-ended vessel.

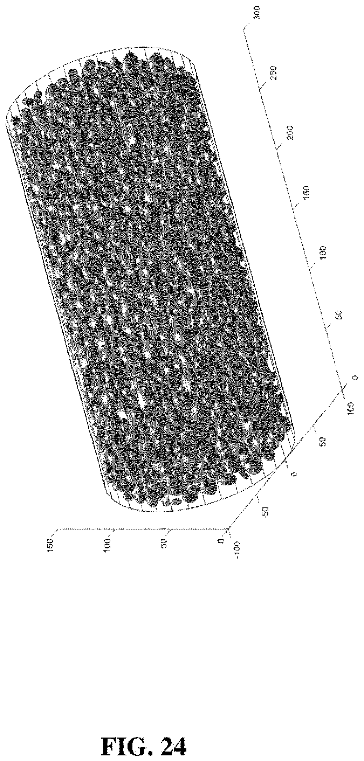

FIG. 24 illustrates a contained aggregate structure comprising a close-packed column of solid ellipsoid binary-oxide members whose sizes are selected from a predetermined size distribution, which can be used in vessel 2310 in FIG. 23A, for example. The size distribution and shape(s) of the binary-oxide members will impact various attributes, such as porosity and interaction length.

In another example, the contained aggregate structure is a single binary-oxide member (e.g., that is porous, or that has holes or spaces through which a gas can pass).

In an example, the contained aggregate structure is configured to have a predetermined packing density.

In an example, the contained aggregate structure is configured to have a surface area (e.g., a predetermined and/or specific surface area) characterising the total surface area of the contained aggregate structure.

In an example, the amount of elemental component introduced relative to the amount of binary-oxide members is selected to satisfy the minimum amount required for the one or more solid binary-oxide members to react completely with the elemental component to generate the binary-oxide precursor. In another example, the amount of elemental component introduced relative to the amount of binary-oxide members is selected to satisfy the minimum amount required for the elemental component to react completely with the one or more solid binary-oxide members to generate the binary-oxide precursor.

Referring again to FIG. 22, at block 2230 the elemental component is heated to a liquid form in the vessel. An elemental component vapor will evaporate from the liquid and it can travel (e.g., via diffusion, or transported by a carrier gas) towards the open end of the open-ended vessel. As the elemental component vapor transits towards the open end, the elemental component vapor can react with the contained aggregate structure of the one or more solid-binary-oxide elements to generate the binary-oxide vapor.

In FIG. 22, block 2210 can occur before block 2220 in time, or block 2220 can occur before block 2210 in time. In other words, the elemental component can be added to the open-ended vessel either before or after the binary-oxide members. In general, upon heating, the relative densities, as well as the geometries of the binary-oxide members, will affect the buoyancy of the binary-oxide members in the elemental component.

### $Ga_2O_{(vapor)}$

In an example application, the methods for generating a binary-oxide vapor precursor described herein (e.g., method 2200 in FIG. 22) may be adopted to generate $Ga_2O_{(vapor)}$ by reacting $Ga_{(vapor)}$ (i.e., the elemental component vapor) with solid $Ga_2O_3$ members (i.e., the solid binary-oxide stoichiometric form of $Ga_2O_{(vapor)}$) in accordance with the following chemical reaction:

$$Ga_2O_{3(solid)} + 4Ga_{(vapor)} \rightarrow 3Ga_2O_{(vapor)} \qquad \text{Equation 2}$$

In the example referred to above, Ga has a low melting temperature and will form a liquid upon heating. Upon further heating, $Ga_{(vapor)}$ will form from the liquid (e.g., by evaporation), and the vapor elemental component will travel towards the open end of the vessel and react with the $Ga_2O_3$ members that are contained within the vessel to form $Ga_2O_{(vapor)}$.

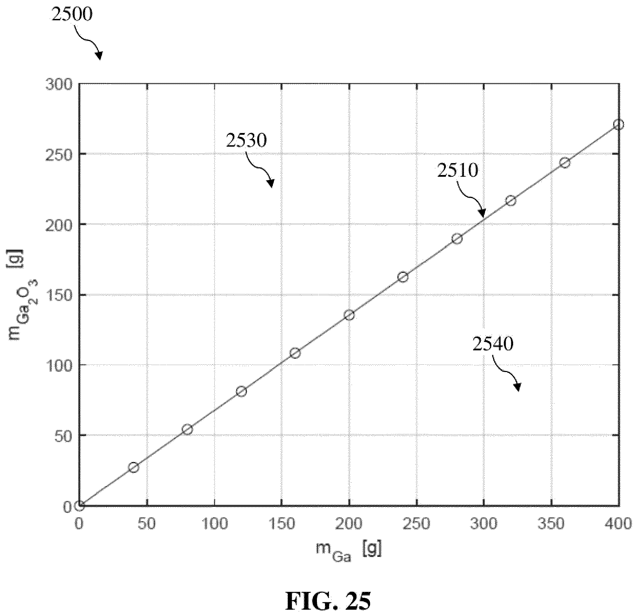

Referring now to FIG. 25, there is shown a plot 2500 depicting an amount of $Ga_2O_3$ required to react completely with a corresponding amount of Ga (in grams) to form $Ga_2O_{vapor}$ as indicated by line 2510. Accordingly, in some cases, for a given amount of Ga, choosing an amount of $Ga_2O_3$ above line 2510 (i.e., in region 2530) will result in an excess of $Ga_2O_3$ in the vessel compared to elemental Ga. On the other hand, if the amount of $Ga_2O_3$ is chosen from below the line 2510 (i.e., in region 2540) then there would be an excess of elemental Ga in the vessel compared to $Ga_2O_3$. In this example, upon heating, $Ga_2O$ and Ga vapor would be produced in the vessel. The geometry of the open-ended vessel, the interaction time and available surface area of the binary-oxide members, and other factors, can affect the concentration of Ga versus $Ga_2O$ in the vapor within the vessel and of the vapor exiting (or emitted from) the vessel. In some cases, the concentration of $Ga_2O$ vapor is much higher than the concentration of Ga vapor in the vessel and of the vapor exiting (or emitted from) the vessel upon heating. The vapor pressure of elemental Ga is much lower than that of $Ga_2O_3$, and therefore in many cases, the concentration of $Ga_2O$ in the vapor is much higher than the concentration of Ga vapor (e.g., 10 times or 100 times, or 1000 times, or more than 1000 times higher). If the amount of elemental Ga in the crucible were much larger (e.g., 10 times, or 100 times, or 1000 times, or more than 1000 times larger) then the concentration of elemental Ga in the vapor could be similar to or higher than the concentration of $Ga_2O$ in the vapor.

The solid binary-oxide members can be of various densities depending on their formed configuration. TABLE 1 below shows some example densities for different forms of solid $Ga_2O_3$. However, at elevated temperatures, such as those used during the operation of the source, the densities can be different.

TABLE 1

| Example Densities for Various Forms of Solid $Ga_2O_3$ | | |
|---|---|---|
| $Ga_2O_3$ Form | Purity | Density [g/cm$^3$] |
| Granules | 5N | 2.5 |
| Rods | 5N | 5.5 |
| Single Crystal Wafer | 5N | 6.4 |

In this example, and noting that $Ga_{(liquid)}$ can have a density of 6.095 g/cm$^3$, in some cases $Ga_2O_3$ in the form of either granules or rods would "float" on the $Ga_{(liquid)}$ while $Ga_2O_3$ in the form of chunks of single crystal wafer in the absence of any supporting arrangement would be submerged in the $Ga_{(liquid)}$.

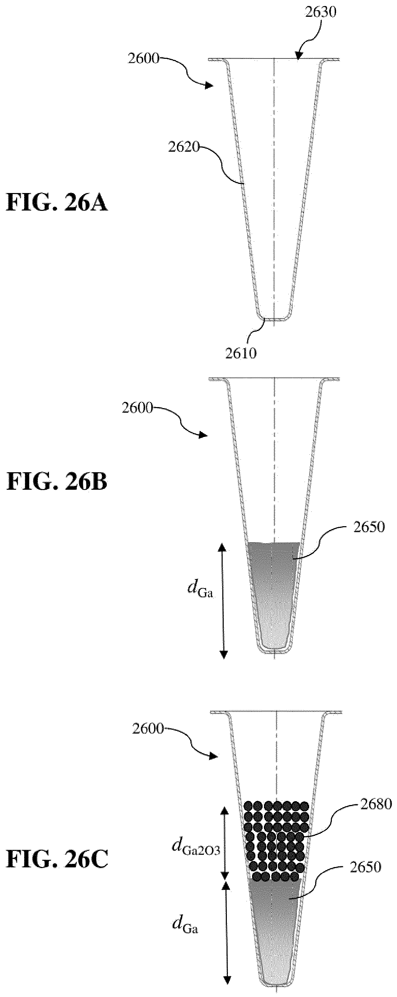

FIGS. 26A-26C, show an example of loading a crucible with Ga and $Ga_2O_3$ granules for the generation of $GaO_{(vapor)}$ in accordance with an illustrative embodiment.

FIG. 26A shows an open-ended vessel in the form of a conically shaped crucible 2600 comprising a closed end 2610, a vessel wall 2620 extending from closed end 2610 towards an open end 2630. In some cases, the crucible 2600 can have an open end or orifice diameter from about 10 mm to about 100 mm, a lip diameter from about 12 mm to about 120 mm, a length from about 20 mm to about 500 mm, and a closed end radius from about 2 mm to about 20 mm resulting in a volume from about 10 cc to about 1000 cc.

In FIG. 26B, the Ga 2650 is contained in the crucible 2600. In this example, 50 g of Ga in the form of 8 mm diameter spheres can be used, which can be initially heated to form $Ga_{(liquid)}$ 2650 with a volume of about 8.2 cc. Depending on the geometry of crucible 2600, the depth $d_{Ga}$ of the $Ga_{(liquid)}$ as contained in crucible 2600 in this example is from about 10 mm to about 100 mm.

In FIG. 26C, solid $Ga_2O_3$ members 2680 in the form of granules (optionally having a distribution of sizes) are introduced into crucible 2600. By reference to $Ga_2O_{vapor}$ / $Ga_{(vapor)}$ dividing line 2510 shown in FIG. 25, for the 50 g of Ga contained in crucible 2600, the amount of $Ga_2O_3$ is selected to be 33.9 g. This translates to a calculated fill volume of 13.5 cc and a depth $d_{Ga_2O_3}$ from about 10 mm to about 100 mm (depending on the geometry of the vessel) located on $Ga_{(liquid)}$. In this manner, the $Ga_2O_3$ granules form an aggregate structure in the form of a close-packed column that will have an associated packing density and specific surface area of $Ga_2O_3$ available to react with $Ga_{(vapor)}$. In some cases, the fill volume can be chosen to be less than 100% of the volume capacity of a vessel. For example, the fill volume can be chosen to be about 75% so that the source can be positioned at a 45° angle (see for example, FIGS. 23A-23B).

As will be appreciated, in another example the Ga spheres and solid $Ga_2O_3$ (optionally having a distribution of sizes) may initially be mixed together. Upon initial heating, the Ga will form a liquid and the solid $Ga_2O_3$ members 2680 in the form of granules can settle on the Ga layer in the crucible.

As would be appreciated, in operation the crucible may be installed at a tilt angle with respect to the axis of any associated growth chamber (for example, of an MBE machine). In general, for this example where the solid binary-oxide component floats on an upper surface of the elemental component an increase in tilt angle will generally result in a reduction of the amount of total material that may be loaded into the binary-oxide vapor source.

Following loading of the crucible 2600 as described above, the crucible may be further heated in order to form a $Ga_{(vapor)}$ which will travel towards the open end 2630 of crucible and react with the (packed column of) $Ga_2O_3$ granules to form $Ga_2O_{(vapor)}$ (see Equation 2).

## $GeO_{2(vapor)}$

In another example application, the methods for generating a binary-oxide vapor precursor described herein (e.g., method 2200 in FIG. 22) may be adopted to generate $GeO_{(vapor)}$ by reacting $Ge_{(vapor)}$ (i.e., the elemental component vapor) with solid $GeO_2$ members (i.e., the solid binary-oxide stoichiometric form of $GeO_{(vapor)}$) in accordance with the following chemical reaction:

$$GeO_{2(solid)} + Ge_{(vapor)} \rightarrow 2GeO_{(vapor)} \qquad \text{Equation 10}$$

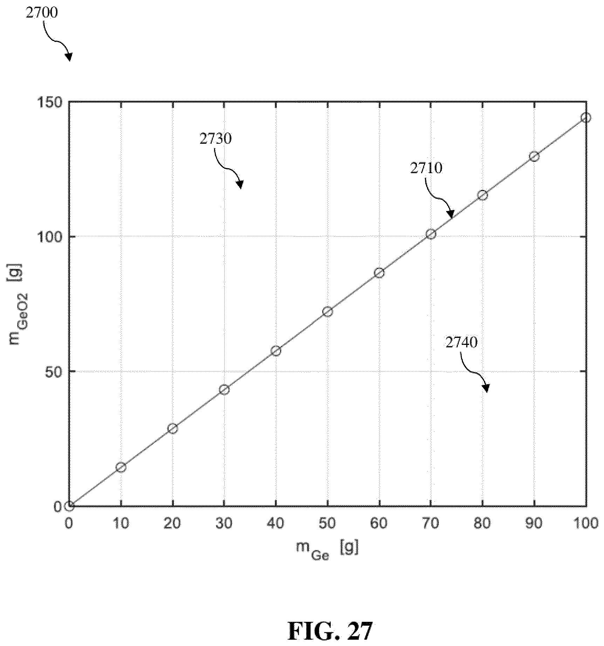

Referring now to FIG. 27, there is shown a plot 2700 depicting the minimum amount of $GeO_2$ required to react completely with a corresponding amount of Ge to form $GeO_{(vapor)}$ as indicated by line 2710. Accordingly, in some cases, for a given amount of Ge, choosing an amount of $GeO_2$ above line 2710 (i.e., in region 2730) will result in an excess of elemental Ge in the vessel compared to $GeO_2$. On the other hand, if the amount of $GeO_2$ is chosen from below the line 2710 (i.e., in region 2740) then there would be an excess of $GeO_2$ in the vessel compared to elemental Ge.

To form liquid Ge, it is necessary to initially heat solid Ge to a temperature of 938°C (or higher) where it has a density of approximately 5.6 $g/cm^3$. It is also notable that $GeO_2$ itself has a melting point of 1115°C. This will set an approximate upper limit to which the interior of any vessel may be heated to form the $GeO_{(vapor)}$ using solid $GeO_2$. In this example, the solid $GeO_2$ members are once again in the form of granules (similar to FIG. 26A, with $GeO_2$ members instead of $Ga_2O_3$ members) having a size of approximately 6 mm and a density of approximately 4.3 $g/cm^3$.

Adopting the crucible 2600 illustrated in FIG. 26A, for 50 g of Ge the expected volume is 8.9 cc upon melting resulting in a depth $d_{Ge}$ for the $Ge_{(liquid)}$ of 37.8 mm. By reference to $GeO_{vapor}/Ge_{(vapor)}$ dividing line 2710 shown in FIG. 27, for the 50 g of Ge contained in crucible 2600, the amount of $GeO_2$ is selected to be 72 g. This translates to a calculated fill volume of about 17 cc and a depth $d_{Geo2}$ from about 10 mm to about 100 mm (depending on the geometry of the vessel) located on the $Ge_{(liquid)}$. In this manner, the $GeO_2$ granules form an aggregate structure in the form of a close-packed column that will have an associated packing density and specific surface area of $GeO_2$ available to react with $Ge_{(vapor)}$.

## $Al_2O_{(vapor)}$ and $SiO_{(vapor)}$

In another example application, the methods for generating a binary-oxide vapor precursor described herein (e.g., method 2200 in FIG. 22) may be adopted to generate $Al_2O_{(vapor)}$ by reacting $Al_{(vapor)}$ (i.e., the elemental component vapor) with solid $Al_2O_3$ members (i.e., the solid binary-oxide stoichiometric form of $Al_2O_{(vapor)}$). For example, see Equations 4 and 4b.

In this example, Al has a melting point of approximately 665°C and a density of 2.375 $g/cm^3$ in its liquid form. This may be contrasted with $Al_2O_3$ (sapphire) having a density of approximately 4.0 $g/cm^3$ meaning that, in some cases, and depending on the amount of $Al_2O_3$ members, a certain proportion of them may be submerged in the liquid Al.

In another example, the method for generating a binary-oxide vapor precursor described herein (e.g., method 2200 in FIG. 22) may be adopted to generate $SiO_{(vapor)}$ by reacting $Si_{(vapor)}$ (i.e., the elemental component vapor) with solid $SiO_2$ members (i.e., the solid binary-oxide stoichiometric form of $SiO_{(vapor)}$. For example, see Equation 5.

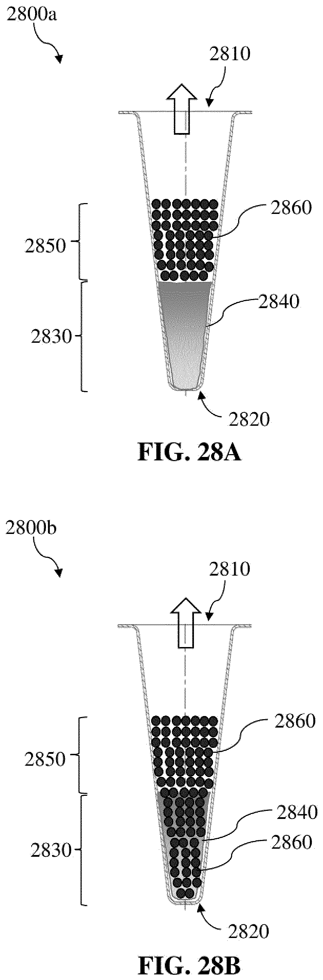

Referring now to FIG. 28A, there is shown a binary-oxide vapor source 2800a according to an illustrative embodiment. Binary-oxide source 2800a comprises a closed end 2820 and an open end 2810; a first region 2830 located adjacent to the closed end 2820 including an elemental component 2840 and a second region 2850 located between the first region 2830 and the open end 2810, the second region 2850 including a solid binary-oxide component 2860, and spaces through which an elemental vapor from the first region 2830 can pass. The elemental vapor reacts with the binary-oxide material 2860 to produce a binary-oxide vapor, which exits the binary-oxide vapor source 2800a through the open end 2810. In this example, the solid binary-oxide component 2860 of the second region 2850 comprises an aggregate structure configured in this embodiment as granules of the solid binary-oxide component. In this example, the density of the solid binary-oxide component 2860 is less than that of the elemental component 2840 and as such will be substantially or mostly distributed above the elemental component 2840. The solid binary-oxide component 2860 can be granules, powder, or a porous solid material. In some cases, the solid binary-oxide component 2860 has high surface area.

Referring now to FIG. 28B, there is shown a binary-oxide vapor source 2800b according to another illustrative embodiment. This example is similar to binary-oxide vapor source 2800a illustrated in FIG. 28A except that density of the solid binary-oxide component 2860 is greater than that of the elemental component 2840 and as such the solid binary-oxide component 2860 sinks into elemental component 2840. In this case, the solid binary-oxide component 2860 is distributed both in the second region 2850 and throughout the elemental component 2840 in the first region 2830.

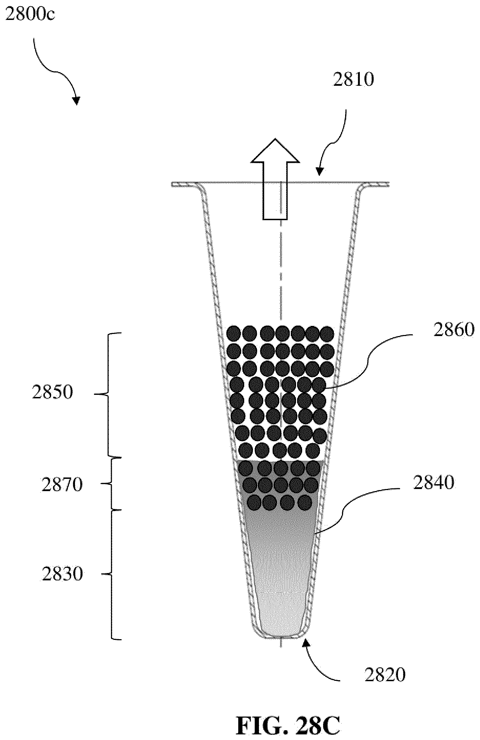

Referring now to FIG. 28C, there is shown a binary-oxide vapor source 2800c according to another illustrative embodiment. This example is similar to binary-oxide vapor sources 2800a and 2800b illustrated in FIGS. 28A and 28B, except that there is also an intermixing region 2870 between the first region 2830 and the second region 2850. For example, the first region 2830 can include the elemental component 2840 (and not the binary-oxide component 2860), the second region 2850 can contain the binary-oxide component 2860, and the intermixing region 2870 can contain both the elemental component 2840 and the binary-oxide component 2860. In some examples, the first region 2830 can include both the elemental component 2840 and the binary-oxide component 2860, the second region can only contain the binary-oxide component 2860, and the intermixing region can contain both the elemental component 2840 and the binary-oxide component 2860. Such cases can arise, for example, where the densities of the elemental component 2840 and the binary-oxide component 2860 are similar, or where geometric constraints prevent the binary-oxide component 2860 from sinking to the bottom of the crucible.

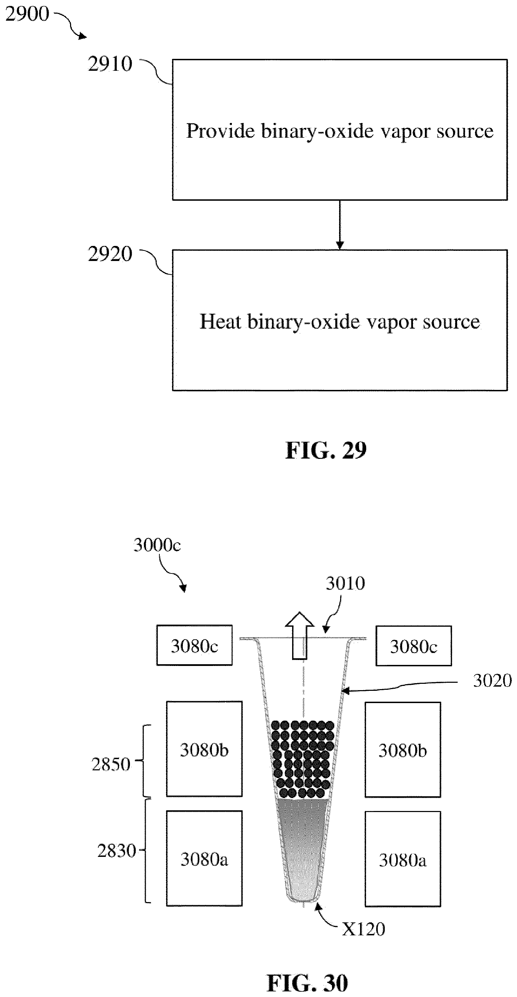

Referring now to FIG. 29, there is shown a is a flowchart of a method 2900 for generating a binary-oxide vapor precursor according to an illustrative embodiment. In one example, method 2900 may employ a binary-oxide vapor source in accordance with FIGS. 28A-28C and other examples described in the present disclosure.

At block 2910, method 2900 includes providing a binary-oxide vapor source with a closed end and an open end. The binary-oxide vapor source also includes a first region located adjacent to the closed end that includes an elemental component and a second region located between the first region and the open end where the second region includes a solid binary-oxide component with one or more spaces through which a vapor can pass and react with the solid binary-oxide component.

At block 2920, method 2900 includes heating the binary-oxide vapor source to form an elemental vapor, wherein the elemental vapor passes through the spaces in the second region and can react with the binary-oxide material to produce a binary-oxide vapor that exits the binary-oxide vapor source through the open end. In some cases, the heating may be done in multiple steps. For example, the elemental component can be added to the source, and then a first heating can be done to melt the elemental component. The solid binary-oxide component can be subsequently added to the source (e.g., after the source has cooled), and the source can be heated for a second time.

In one example, the binary-oxide vapor source is preloaded with the elemental component in solid form and the solid binary-oxide component is loaded in particulate or granular form. For example, the binary-oxide vapor source may be loaded with an elemental Ga component in the form of ingots (or pieces, or similar forms) and with a solid binary-oxide component in the form of granules (or rods, or pieces, or powder) of $Ga_2O_3$. In some cases, different sizes of Ga and/or $Ga_2O_3$ members can be used in the crucible together. Additionally, in some cases, different forms of Ga and/or $Ga_2O_3$ can be added to the crucible together. For example, rods of $Ga_2O_3$ can be added and then $Ga_2O_3$ powder (i.e., smaller and differently shaped members compared to the rods) can be added to fill in the spaces between the rods. Using different sizes and/or different forms of Ga and/or $Ga_2O_3$ members can be advantageous, for example, to increase the packing density (or the overall mass density) of the material in the crucible. More material in the source allows the source to operate for a longer period of time before becoming depleted.

In some cases, following initial heating of the binary-oxide vapor source, the first region comprising molten Ga will be formed and the $Ga_2O_3$ will "float" on the molten Ga and form a second region comprising the $Ga_2O_3$ located between the first region and the open end. In other examples, the density of the solid binary-oxide component may be comparable or less than the molten elemental component, and may "sink" or partially sink into the molten elemental component. However, in accordance with the present disclosure, due to the form and amount of solid binary-oxide component there can in any case be a second region located between the first region and the open end comprising at least a portion of the solid binary-oxide component extending into the second region from the first region. In some cases, there can be an intermediate region between the first region and the second region, wherein the first region contains the molten elemental component, the second region contains the solid binary-oxide component, and the intermediate region contains both the molten elemental component and the solid binary-oxide component.

FIG. 30 shows an example of a binary-oxide vapor source 3000c including a heating arrangement having first heater zone 3080a and a second heater zone 3080b which transfer heat to the crucible 3020. The first and second heater zones 3080a, 3080b substantially correspond to the first and second regions 2830 and 2850 of the vapor source, and can be separately controllable to heat the different zones at different temperatures. FIG. 30 shows a cross-section of the binary-oxide vapor source 3000c, and the heater zones 3080a-c can each be shaped like an annulus (e.g., an approximately circular annulus, or a square or rectangular annulus). In one example, the second heater zone 3080b corresponding to the second region 2850 is heated at an elevated temperature compared to the first heater zone 3080a to control condensation to reduce clogging. Condensation and clogging can be detrimental to the binary-oxide vapor source, since it can obstruct the opening and change the beam profile. In extreme cases condensation and clogging may substantially affect the beam flux. FIG. 30 also shows an optional third heating zone including third heater zone 3080c, which is located closer to the open end 3010 of binary-oxide vapor source 3000c than the first and second heater zones 3080a and 3080b. The third heater zone 3080c can be used to heat the crucible 3020 near the open end 3010 to a high temperature (e.g., above those in the first and second zones 2830 and 2850) to help prevent condensation of the vapor near the open end 3010 of the crucible 3020.

In other cases, the heater can have one heater zone 3080a, and not have a second heater zone 3080b or a third heater zone 3080c. In such cases, the first heater zone 3080a can be in the first region 2830, as shown in FIG. 30, or it can be taller and extend into the second region 2850. In some cases, the first heater 3080a can extend through all of the first region 2830 and all of the second region 2850. In some cases, the first heater zone 3080a (as described above) can be used in conjunction with a third heater zone 3080c (and heater zone 3080b can be omitted), for example, to prevent condensation of the vapor near the open end 3010 of the crucible 3000c.

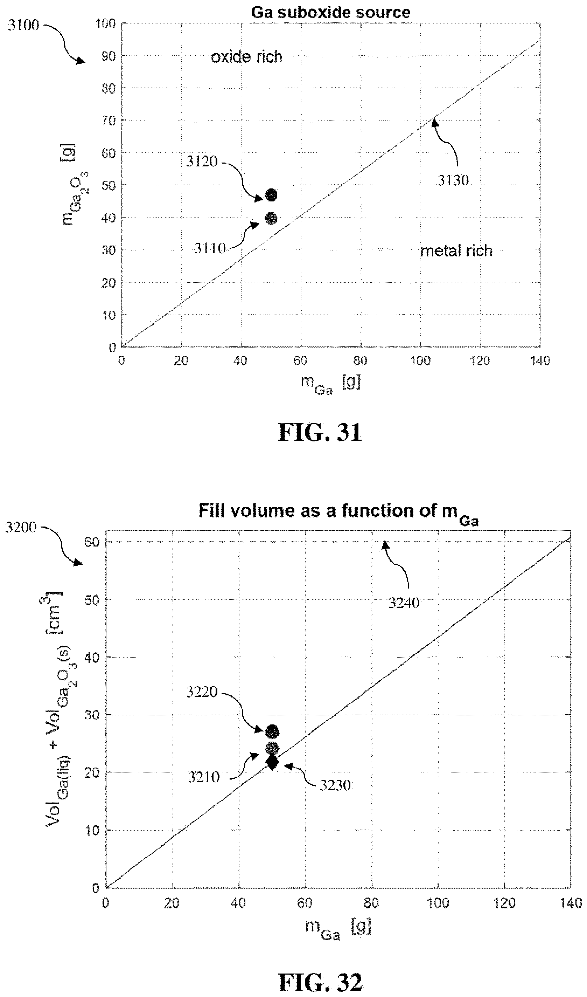

Referring now to FIG. 31, there is shown a plot 3100 similar to FIG. 25 showing two example mass ratios 3110, 3120 of the solid binary-oxide component to the elemental component that were assessed for a binary-oxide vapor source in accordance with the present disclosure that will be discussed below.

In this example, the solid binary-oxide component comprises $Ga_2O_3$ and the elemental component comprises Ga and the $Ga_2O_3$/Ga mass ratio on the boundary line 3130 is 0.678.

**Binary-Oxide Vapor Source with Elemental Ga and Ga$_2$O$_3$ Solid Granules**

In a first experimental of this example, the binary-oxide vapor source was loaded with elemental Ga and $Ga_2O_3$

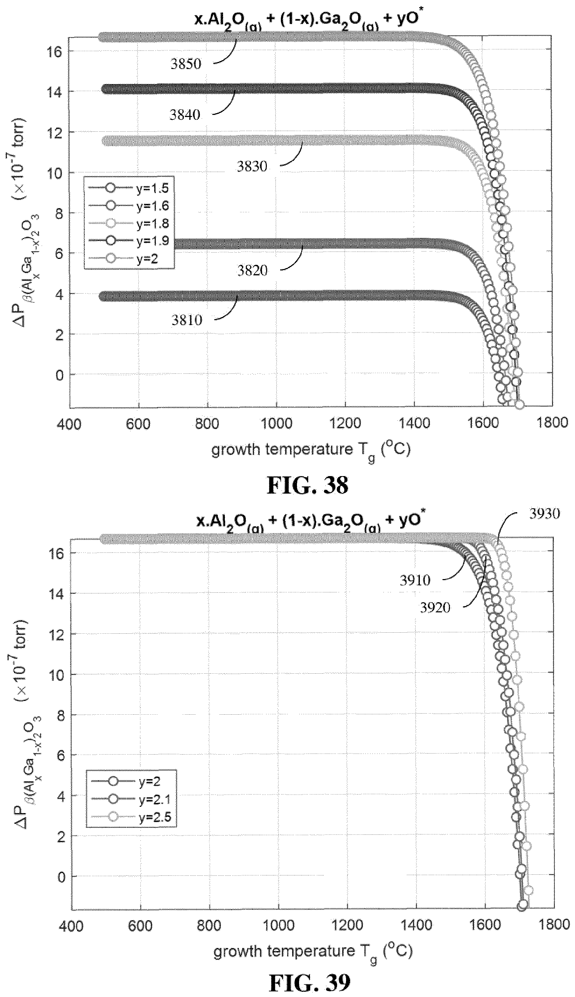

solid granules (e.g., as shown in FIGS. 26A-26C, 28A, 28B and/or 28C). FIG. 31 shows the mass ratio 3110 of 0.793 for this example. This was achieved by initially inserting two Ga ingots or rods weighing 25 grams each for a total of 50 grams of Ga. Added to this was a total of 39.66 grams of $Ga_2O_3$ granules that were poured in multiple steps on top and around the Ga ingots. As can be seen from FIG. 31, 39.66 grams is above the 33.9 g of $Ga_2O_3$ (i.e., $\Delta Ga_2O_3$ = 5.76 grams) that would be necessary for the complete conversion of the elemental Ga into volatile $Ga_2O$.

In a second experiment of this example, the binary-oxide vapor source was loaded with elemental Ga and $Ga_2O_3$ solid particles (e.g., as shown in FIGS. 26A-26C, 28A, 28B and/or 28C) with an equivalent mass ratio 3120 of 0.938 as shown in FIG. 31. This was achieved by initially inserting two Ga ingots or rods weighing 25 grams each for a total of 50 grams of Ga. Added to this was a total of 46.9 grams of $Ga_2O_3$ granules that were poured in multiple steps on top and around the Ga ingots. As can be seen from FIG. 31, this amount of 46.9 grams is above the 33.9 g of $Ga_2O_3$ (i.e., $\Delta Ga_2O_3$ = 13.0 grams) that would be necessary for the complete conversion of the elemental Ga into volatile $Ga_2O$. By contrast to the first experiment, the second experiment had a higher ratio of $Ga_2O_3$ to Ga.

In both experiments of this example, the Ga ingots or rods were cylindric with diameter of 8 mm and length of 6 mm, and the $Ga_2O_3$ granules were approximately spherical with about 3 mm diameter, however, a portion of the $Ga_2O_3$ granules had diameters up to about 8 mm. In other words, the $Ga_2O_3$ granules had a distribution of diameters with a range from below about 3 mm to above about 8 mm, with a median (or average) diameter of approximately 3 mm. Given that Ga melts at ~30°C and the mass density of liquid Ga is 6.095 g/cm$^3$, the $Ga_2O_3$ granules, whose melting point is ~1900°C, are expected to remain solid at the temperatures used in most deposition processes. As discussed previously, the mass density of the $Ga_2O_3$ granules is about 2.5 g/cm$^3$, and in some cases, the $Ga_2O_3$ granules can float on the surface of the molten Ga.

FIG. 32 is a plot 3200 of the total volume of the Ga/$Ga_2O_3$ mixture as a function of the Ga mass for the crucible geometry illustrated in FIGS. 26A-26C (i.e., a 60 cc crucible) according to an illustrative embodiment. Also shown on plot 3200 are the total volumes 3210 and 3220 corresponding to the two example filling regimes 3110 and 3120, respectively, referred to above. The total volume is the sum of the volume of molten Ga and the volume of solid $Ga_2O_3$ granules. Volume 3230 corresponds to the mixture of 50 g of metallic Ga and 33.9 g of $Ga_2O_3$ granules corresponding to the boundary line 3130.

The total volume 3230 of this mixture is approximately 22 cc, which amounts to ~ 37.5% of the capacity of the 60 cc conical crucible. The dashed line 3240 indicates the full theoretical capacity of the crucible but as noted previously, the installed configuration of the crucible (e.g., if it is installed at an angle) may need to be taken into account when determining the actual total filled volume fraction.

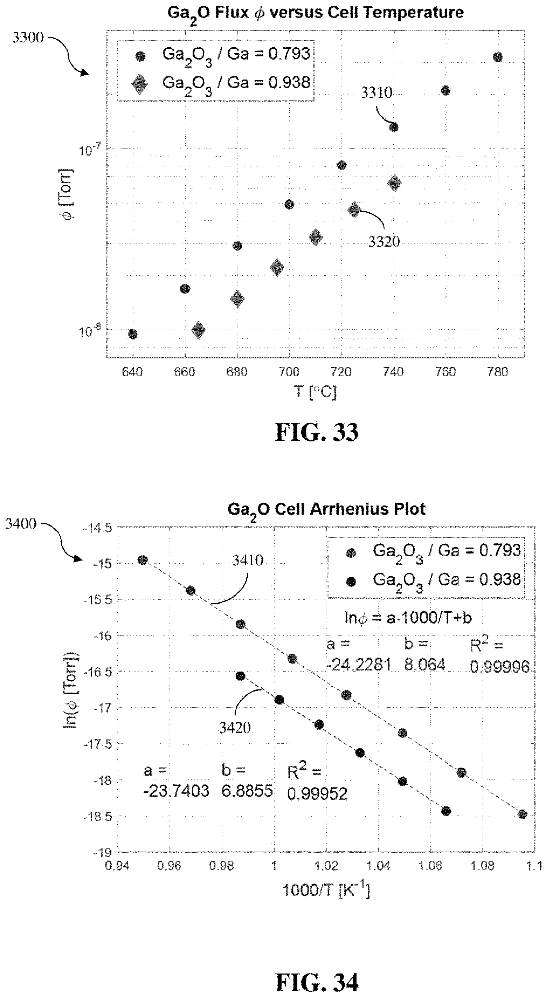

FIG. 33 is a plot 3300 of measured $Ga_2O$ flux $\phi$ as a function of binary-oxide vapor source temperature (single zone heater) for the two examples from different sources and using the different mass ratios referred to above in FIG. 31. Example data 3310 corresponds to a $Ga_2O_3$ / Ga ratio of 0.793, and example data 3320 corresponds to a $Ga_2O_3$ / Ga ratio of 0.938. In this example, the flux is measured by a beam flux monitor (BFM) following initial loading. The data shows that the fitted $\alpha$-coefficients of the Arrhenius plots (related to the activation energy of the reactions) are similar. The different vapor source configurations of the two experiments in this example could have caused some offset in the pressure-temperature curves in FIG. 33.

FIG. 34 is an Arrhenius plot 3400 of the natural logarithm of the $Ga_2O$ flux $\phi$ as a function of the inverse of the absolute temperature T (multiplied by 1000) of the binary-oxide vapor source for the experiments of this example referred to above, and in accordance with some embodiments. Example data 3410 corresponds to a $Ga_2O_3$ / Ga ratio of 0.793, and example data 3420 corresponds to a $Ga_2O_3$ / Ga ratio of 0.938. Fitting coefficients and goodness of the fitting are shown for both datasets. Arrhenius plot 3400 confirms the exponential dependence of the beam flux species which occurs at relatively low temperatures and accordingly is exclusively $Ga_2O$ vapor (or almost all $Ga_2O$ vapor), due to the much higher vapor pressure of $Ga_2O$ compared to Ga in this example. Elemental Ga flux would become more appreciable at temperatures approximately 150 °C higher. This confirms the thermodynamic reaction of Ga vapor functioning to react or etch solid $Ga_2O_3$ to form a pure $Ga_2O$ emanating flux.

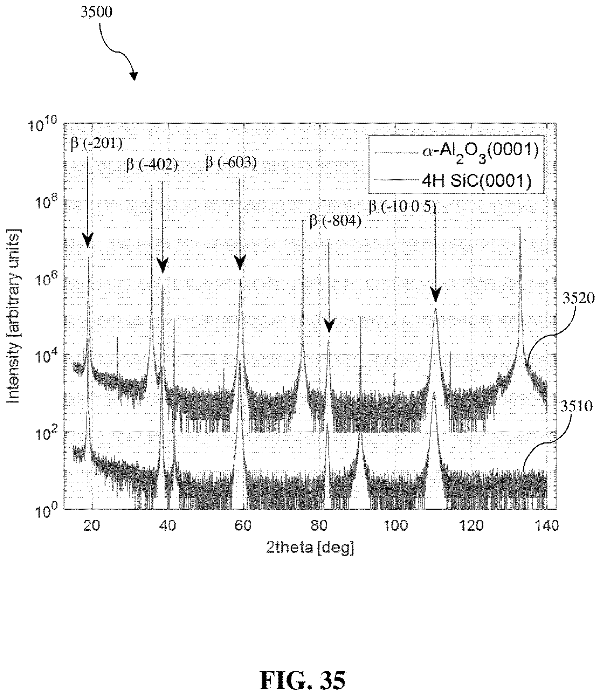

FIG. 35 shows x-ray diffraction (XRD) 2q-w scans, with example embodiments of the present disclosure. Scan 3500 is from a first $Ga_2O_3$ film grown on a 2 inch sapphire wafer of (0001) orientation 3510, and scan 3520 is from a second $Ga_2O_3$ film grown on a 2 inch 4H-SiC substrate with (0001) orientation. In this example, both films were gown using the binary-oxide vapor source loaded with a mixture with a $Ga_2O_3$/Ga mass ratio of 0.793. An oxygen plasma was used to generate atomic oxygen. Both films are single crystal b-phase $Ga_2O_3$ with (-2 0 1) orientation along the growth direction, as deduced from the presence of the Bragg peaks marked by the arrows.

The arrows indicate the Bragg peaks corresponding to the family of planes n(-2 0 1) of the b-$Ga_2O_3$ structure, where n is an integer from 1 to 5. The other reflections in FIG. 35 stem from the substrates. The data in plot 3500 indicates that the $Ga_2O_3$ films have grown with a single phase and a single orientation along the normal to the substrate surface.

The thicknesses of the b-$Ga_2O_3$ films referred to in FIG. 35 were measured by means of UV-visible light reflectometry across the 2 inch substrates. Both films have thicknesses in the micrometer range with a thickness uniformity over the 2 inch wafer area of better than 5%.

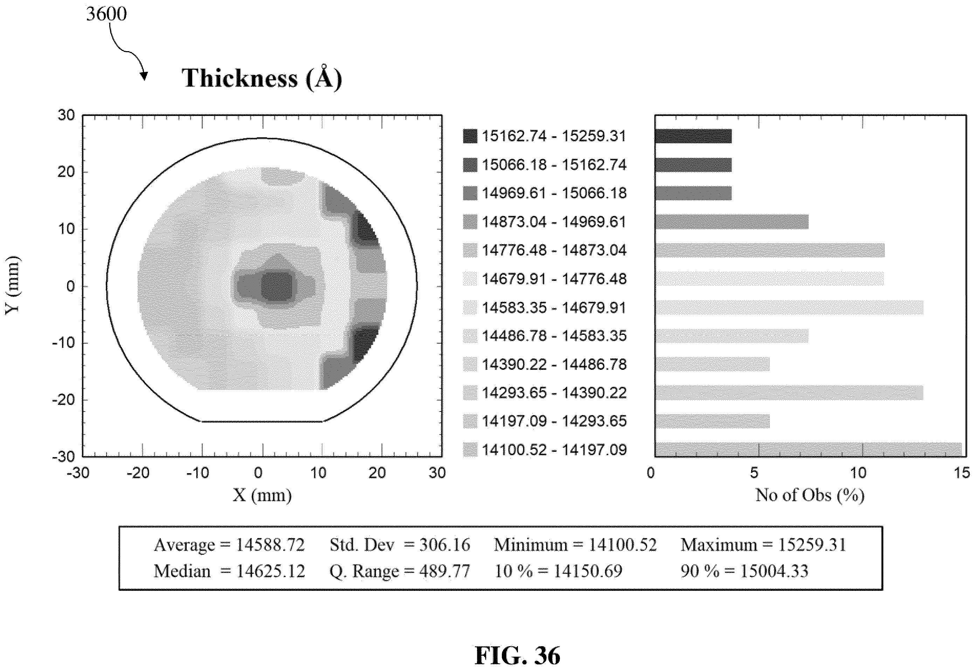

FIG. 36 is a UV-visible light reflectometry thickness map 3600 of the b-$Ga_2O_3$ film grown on the c-plane sapphire substrate. This data shows that the thickness uniformity over the 2 inch substrate (excluding an edge of 5 mm width) is better than 4%.

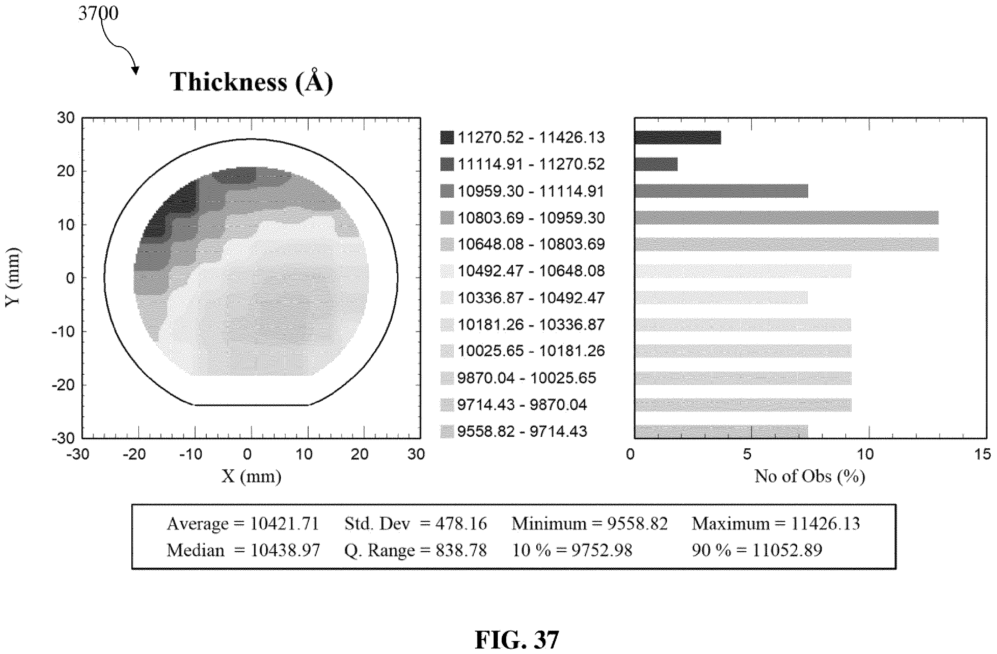

FIG. 37 is a UV-visible light reflectometry thickness map 3700 of the b -$Ga_2O_3$ film grown on the 4H-SiC(0001) substrate. This data shows that the thickness uniformity over the 2 inch (excluding an edge of 5 mm width) is better than 5%.

The thickness uniformity, or a standard deviation in thickness divided by an average thickness, of the epitaxial oxide layers (or films) described herein can be from about 1% to about 10%, less than about 1%, less than about 2%, less than about 3%, less than about 4%, less than about 5%, or less than about 10%.

**Growth of Binary, Ternary, and Multinary Oxides from Binary-Oxide Precursor** Sources

In some embodiments, two of the binary-oxide vapor sources described herein can be used along with an active oxygen source to produce two binary-oxide precursors, which can be used to form a ternary oxide material. For example, a first binary-oxide vapor source can be used to produce $Ga_2O(vapor)$, and a second binary-oxide vapor source can be used to produce $Al_2O(vapor)$. The $Ga_2O_{(vapor)}$ and the $Al_2O(vapor)$ can be introduced from the two binary vapor sources to a growth chamber, along with active oxygen species from the active oxygen source to form an epitaxial film of $(Al_xGa_{1-x})_2O_3$ on a heated substrate in the growth chamber. In such cases, the reaction would be:

$$(x)Al_2O_{(gas)} + (1-x)Ga_2O_{(gas)} + 2O \rightarrow (Al_xGa_{1-x})_2O_{3(solid)} \qquad \text{Equation 11}$$

Similarly, other ternary oxide materials can be formed by combining different binary-oxide vapor sources described herein, such as $In_xGa_yO_z$, $Ga_xSi_yO_z$, $Al_xSi_yO_z$, $Ga_xGe_yO_z$, $Al_xGe_yO_z$, etc, where x > 0, y > 0, and z > 0. As described above, the growth chamber can be a vacuum chamber or can be at atmospheric pressure. Some examples of deposition systems that can use two binary-oxide vapor sources to produce ternary materials are molecular beam epitaxy, CVD (e.g., MOCVD), and ALD.

In some cases, more than two of the binary-oxide vapor sources described herein can be used along with an active oxygen source to produce more than two binary-oxide precursors, which can be used to form a multi-element oxide material (e.g., a binary, ternary, quaternary, or quinary oxide, or an oxide material with more than more than 5 elements) in a growth chamber of a deposition system.

In some cases, the deposition systems and associated sources and growth chambers are configured such that the binary-oxide precursors preferentially react to form the multi-element oxide material on a heated substrate in the growth chamber rather than reacting in the growth chamber before they reach the substrate, as described herein.

In some cases, the binary-oxide precursors react to form intermediate products in the growth chamber before they reach the heated substrate. The intermediate products can form a multi-element oxide material on the heated substrate (e.g., by reacting with active oxygen, another binary-oxide precursor, and/or an intermediate product).

FIGS. 38 and 39 show modelled examples where two binary-oxide vapor sources are used in combination with an active oxygen source to form a ternary oxide material, in accordance with some embodiments. The composition of the ternary is $(Al_{0.5}Ga_{0.5})_2O_3$ in this example, and the reaction modelled is similar to Equation 11 but with a varying concentration of active oxygen "y" (instead of fixing the value of the active oxygen at 2, as in Equation 11). The plots in FIGS. 38 and 39 have a y-axis $\Delta P$ that is a change in partial pressure for the formation of the ternary oxide compound according to the reaction. As described herein, $\Delta P$ is a measure of the driving force of the formation of the ternary oxide material, and can also be a measure of the growth rate of the ternary oxide material. Example data 3810 corresponds to a "y" value of 1.5, example data 3820 corresponds to a "y" value of 1.6, example data 3830 corresponds to a "y" value of 1.8, example data 3840 corresponds to a "y" value of 1.9, and example data 3850 corresponds to a "y" value of 2.0. These plots show that the amount of active oxygen provided directly impacts the $\Delta P$, the driving force, and/or the growth rate of the ternary oxide material. The $\Delta P$, which is related to the driving force, or growth rate of the ternary oxide material, can be increased by increasing the amount of oxygen available up to the stoichiometric value of 2 (y=2). Above y=2, and when the temperature is from about 500°C to about 1400°C or 1600°C, the $\Delta P$ (related to the driving force, or growth rate of the ternary oxide material) remains approximately constant with increasing oxygen concentration or partial pressure. Additionally, when the temperature is above about 500°C, the $\Delta P$, driving force, or growth rate of the ternary oxide material is relatively constant with temperature until the temperature reaches about 1400°C to 1600°C. At temperatures above about 1400°C to 1600°C the conditions start to become unfavorable for the formation of the ternary oxide material from the binary-oxide reactants, and the $\Delta P$, driving force, or growth rate of the ternary oxide material, is reduced. The modelled scenarios in plot in FIG. 39 illustrate that a higher partial pressure of oxygen (above y=2) can push the reaction to remain favorable at higher temperatures (e.g., at about 1500°C or 1600°C), and therefore enable high growth rates of the ternary oxide material at higher temperatures. Forming the ternary oxide material at higher temperatures can be advantageous, for example, to improve the crystal quality (e.g., to reduce a concentration of defects, such as point defects) of the ternary oxide material. Example data 3910 corresponds to a "y" value of 2.0, example data 3920 corresponds to a "y" value of 2.1, and example data 3930 corresponds to a "y" value of 2.5.

In some cases, the binary-oxide vapor sources described herein can be used to form oxide materials by reacting one or more of the binary-oxide vapor precursors with active oxygen and with an elemental or molecular beam from another type of source, such as an evaporation source, a gas source, or other type of source that can be used with materials deposition systems.

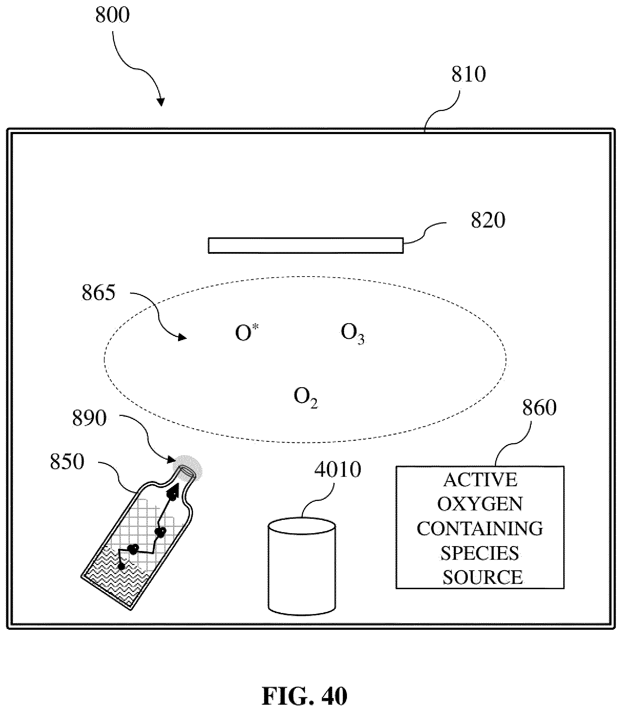

FIG. 40 shows a schematic of an example of system 2400 with similar components as described with respect to system 800 shown in FIG. 8A and further including an additional elemental or molecular source 4010, in accordance with some embodiments. Elemental or molecular source 4010 can be coupled to growth chamber 810 or be configured as a remote source as described herein. Elemental or molecular source 4010 can be an evaporation source such as a Knudsen cell that would be used in conventional MBE. In some cases, source 4010 can be a gas source such as a metal organic precursor source that would be used in conventional MOCVD or ALD. In some cases, one or more of the binary-oxide vapor sources 850 described herein can be used along with an active oxygen source 860 and an elemental or molecular source 4010 to form a multi-element oxide material (e.g., a binary, ternary, or quaternary oxide, or an oxide material with more than more than 4 elements) in a growth chamber of a deposition system.

In some cases, the binary-oxide precursors and sources described herein (e.g., as shown in FIGS. 6A, 8A-8B, 17, 18A-18C, 19-21, 26A-26C, 28A-28C, 30, or 40), can be used in combination with elemental or molecular source (e.g., as shown in FIG. 40) which can be an elemental atomic beam from a conventional source (e.g., a Knudsen cell), or a metal-containing organic precursor (e.g., in a MOCVD or ALD system configuration using a remote source). For example, Ga and/or Al containing binary-oxide precursor(s) and source(s) described herein can be used in combination with source(s) of Zn, Mg, and/or Ni, to form a (Zn,Mg,Ni)-(Ga,Al)-O containing material of a epitaxial layer. For example, the binary-oxide precursors and sources described herein can be used in combination with an active oxygen source and optionally an additional metal containing source to deposit epitaxial layers of: $Ga_2O_3$ (e.g., $\alpha$-phase or $\beta$-phase); $(Al_xGa_{1-x})_2O_3$ (e.g., $\alpha$-phase or $\beta$-phase) where $0 \leq x \leq 1$; $Mg_xGa_{2(1-x)}O_{3-2x}$ where $0 \leq x \leq 1$; $Mg_xAl_{2(1-x)}O_{3-2x}$ where $0 \leq x \leq 1$; $(Mg_xZn_{1-x})_z(Al_yGa_{1-y})_{2(1-z)}O_{3-2z}$ where $0 \leq x \leq 1$, $0 \leq y \leq 1$, and $0 \leq z \leq 1$; $Zn_xGa_yO_z$ where $0 \leq x \leq 1$, $0 \leq y \leq 1$, and $0 \leq z \leq 1$; $Zn_xAl_yO_z$ where $0 \leq x \leq 1$, $0 \leq y \leq 1$, and $0 \leq z \leq 1$; $Mg_xGa_yO_z$ where $0 \leq x \leq 1$, $0 \leq y \leq 1$, and $0 \leq z \leq 1$; $Mg_xAl_yO_z$ where $0 \leq x \leq 1$, $0 \leq y \leq 1$, and $0 \leq z \leq 1$; $Ni_xGa_yO_z$ where $0 \leq x \leq 1$, $0 \leq y \leq 1$, and $0 \leq z \leq 1$; $Ni_xAl_yO_z$ where $0 \leq x \leq 1$, $0 \leq y \leq 1$, and $0 \leq z \leq 1$; $(Ni_xMg_{1-x})_yGa_{2(1-y)}O_{3-2y}$ where $0<x<1$ and $0<y<1$; $(Mg_xNi_{1-x})_z(Al_yGa_{1-y})_{2(1-z)}O_{3-2z}$, where $0 \leq x \leq 1$, $0 \leq y \leq 1$, and $0 \leq z \leq 1$; $(Ni_zMg_xZn_{1-x-z})(Al_yGa_{1-y})_2O_4$ where $0 \leq (x, y, z) \leq 1$; or $(Zn_pMg_xNi_{1-x-p})_z(Al_yGa_{1-y})_{2(1-z)}O_{3-2z}$, where $0 \leq (p, x, y, z) \leq 1$.

In some cases, the binary-oxide precursors and sources described herein (e.g., as shown in FIGS. 6A, 8A-8B, 17, 18A-18C, 19-21, 26A-26C, 28A-28C, 30, or 40) can be used in combination with an active oxygen source (e.g., as shown in FIGS. 8A-8B and 40) and optionally an additional metal containing source (e.g., as shown in FIG. 40) to deposit epitaxial layers of: $(In_xB_{1-x})_{2y}O_{3z}$ where $0 \leq x \leq 1$, $0.8 \leq y \leq 1.2$, and $0.8 \leq z \leq 1.2$; $(In_xB_{1-x})_2O_3$ where $0 \leq x \leq 1$; $(In_xAl_{1-x})_{2y}O_{3z}$ where $0 \leq x \leq 1$, $0.8 \leq y \leq 1.2$, and $0.8 \leq z \leq 1.2$; $(In_xAl_{1-x})_2O_3$ where $0 \leq x \leq 1$; $(In_xGa_{1-x})_{2y}O_{3z}$ where $0 \leq x \leq 1$, $0.8 \leq y \leq 1.2$, and $0.8 \leq z \leq 1.2$; $(In_xGa_{1-x})_2O_3$ where $0 \leq x \leq 1$; $(In_aGa_bAl_cB_d)_2O_3$ where $0 \leq (a,b,c,d) \leq 1$, $a+b+c+d=1$; $Ni_xIn_{2(1-x)}O_{3-2x}$ where $0 \leq x \leq 1$; $Mg_xIn_{2(1-x)}O_{3-2x}$ where $0 \leq x \leq 1$; $(Ni_aMg_bZn_c)_xIn_{2(1-x)}O_{3-2x}$ where $0 \leq x \leq 1$, $0 \leq (a,b,c) \leq 1$, and $a+b+c=1$; $(Ni_aMg_bZn_c)_x(Ga_dAl_eB_fIn_g)_{2(1-x)}O_{3-2x}$ where $0 \leq x \leq 1$, $0 \leq (a,b,c,d,e,f,g) \leq 1$, $a+b+c=1$, and $d+e+f+g=1$. For example, a deposition system can include binary oxide sources to provide Ga, Al, B, and/or In, an active oxygen source, and one or more additional sources to provide Ni, Mg, and/or Zn, to epitaxially deposit $(Ni_aMg_bZn_c)_x(Ga_dAl_eB_fIn_g)_{2(1-x)}O_{3-2x}$ where $0 \leq x \leq 1$, $0 \leq (a,b,c,d,e,f,g) \leq 1$, $a+b+c=1$, and $d+e+f+g=1$.

In some cases, the binary-oxide precursors and sources described herein can be used in combination with an active oxygen source and optionally an additional metal containing source to deposit epitaxial layers of: $Li_{2x}Ga_{2(1-x)}O_{3-2x}$ where $0 \leq x \leq 1$; $Li(Al_xGa_{1-x})O_2$ where $0 \leq x \leq 1$; $(Al_xGa_{1-x})_2LiO_2$ where $0 \leq x \leq 1$; $Li_xNi_yO_z$ where $0 \leq x \leq 1$, $0 \leq y \leq 1$, and $0 \leq z \leq 1$; $LiAlO_2$ and $LiGaO_2$; $Li_2NiO_3$; $Li_2NiO_2$. For example, a deposition system can include binary oxide sources to provide Li, and also Ga and/or Al, and an active oxygen source, to epitaxially deposit $Li(Al_xGa_{1-x})O_2$ where $0 \leq x \leq 1$.

In some cases, the binary-oxide precursors and sources described herein can be used in combination with an active oxygen source to deposit epitaxial layers of: $Ge_xGa_{2(1-x)}O_{3-x}$ where $0 \leq x \leq 1$; $Ge_xAl_{2(1-x)}O_{3-x}$ where $0 \leq x \leq 1$; $Si_xGa_{2(1-x)}O_{3-x}$ where $0 \leq x \leq 1$; $Si_xAl_{2(1-x)}O_{3-x}$ where $0 \leq x \leq 1$; $(Mg_xZn_{1-x-y}Ni_y)_2GeO_4$ where $0 \leq x \leq 1$, $0 \leq y \leq 1$; or $(Al_xGa_{1-x})_2(Si_zGe_{1-z})O_5$ where $0 \leq x \leq 1$ and $0 \leq z \leq 1$. For example, a deposition system can include binary oxide sources to provide Ga and/ Al and also Ge and/or Si, and an active oxygen source, to epitaxially deposit $(Al_xGa_{1-x})_2(Si_zGe_{1-z})O_5$ where $0 \leq x \leq 1$ and $0 \leq z \leq 1$. Si can be incorporated into group III oxide materials in low concentrations (e.g., $x < 0.1$), and can act as a dopant in some cases. For example, Si can be added to $(In_aGa_bAl_cB_d)_2O_3$ (where $0 \leq (a,b,c,d) \leq 1$, $a+b+c+d=1$) in low concentrations (e.g., less than 10 mol% or 1 mol% of the total material). In some cases, one or more binary oxide source can be used in combination with an additional metal containing source to form the above materials.

In some cases, the binary-oxide precursors and sources described herein can be used in combination with an active oxygen source to deposit epitaxial layers including: one or more of Ga, Ge, Al, Si, B, Li, and In; and oxygen. For example, an epitaxial layer could include $(In_aGa_bAl_cB_d)_2O_3$ (where $0 \leq (a,b,c,d) \leq 1$, $a+b+c+d=1$), with or without Li, and with or without Si dopants.

In some cases, the binary-oxide precursors and sources described herein can be used in combination with an active oxygen source to deposit epitaxial layers including: one or more of Ga, Al, B, and In; one or more of Ge and Si; and oxygen. For example, an epitaxial layer could include $(Al_xGa_{1-x})_2(Si_zGe_{1-z})O_5$ where $0 \leq x \leq 1$ and $0 \leq z \leq 1$, where the Al and/or Ga, and the Si and/or Ge are provided to the growing epitaxial layer using two or more binary-oxide precursor sources.

In some cases, the binary-oxide precursors and sources described herein can be used in combination with an active oxygen source to deposit epitaxial layers including: one or more of Ga, Al, B, and In; Li; and oxygen. For example, an epitaxial layer could include $Li(Al_xGa_{1-x})O_2$ where $0 \leq x \leq 1$; or $(Al_xGa_{1-x})_2LiO_2$ where $0 \leq x \leq 1$, where the Al and/or Ga, and the Li are provided to the growing epitaxial layer using two or more binary-oxide precursor sources.

In some cases, the binary-oxide precursors and sources described herein can be used in combination with an active oxygen source and an additional metal containing source to deposit epitaxial layers including: one or more of Ga, Al, B, and In (from one or more binary-oxide precursors); one or more of Zn, Ni, and Mg; and oxygen. For example, an epitaxial layer could include $(Ni_zMg_xZn_{1-x-z})(Al_yGa_{1-y})_2O_4$ where $0 \leq (x, y, z) \leq 1$; or $(Zn_pMg_xNi_{1-x-p})_z(Al_yGa_{1-y})_{2(1-z)}O_{3-2z}$, where $0 \leq (p, x, y, z) \leq 1$, where the Al and/or Ga are provided to the growing epitaxial layer using one or more binary-oxide precursor sources, and the Zn, Mg, and/or Ni are provided to the growing epitaxial layer using one or more additional metal containing sources.

In some cases, the binary-oxide precursors and sources described herein can be used in combination with an active oxygen source and an additional metal containing source to deposit epitaxial layers including: one or more of Si and Ge (from one or more binary-oxide precursors); one or more of Zn, Ni, and Mg; and oxygen. For example, an epitaxial layer could include $(Mg_xZn_{1-x-y}Ni_y)_2GeO_4$ where $0 \leq x \leq 1$, $0 \leq y \leq 1$, where the Ge is provided to the growing epitaxial layer using a binary-oxide precursor source, and the Zn, Mg, and/or Ni are provided to the growing epitaxial layer using one or more additional metal containing sources.

In some cases, the binary-oxide precursors and sources described herein can be used in combination with an active oxygen source and optionally an additional metal containing source to deposit epitaxial layers of any of the Al, Ga, Ge, or Li containing materials in FIG. 28 described in U.S. Pat. No. 11,342,484, which is incorporated herein in its entirety. In some cases, the binary-oxide precursors and sources described herein can be used in combination with an active oxygen source and optionally an additional metal containing source to deposit epitaxial layers of any of the Al, Ga, Ge, or Li containing materials in FIGs. 76A-1, 76A-2, 76B, and 87-89A. described in U.S. Pat. No. 12,087,880, which is incorporated herein in its entirety.

## Growth of Ternary Oxides from Binary-Oxide Precursor Sources

The growth thermodynamics of ternary oxide semiconductors of the form $(Al_xGa_{1-x})_2O_3$, $(In_xGa_{1-x})_2O_3$, and $(Al_xIn_{1-x})_2O_3$, where $0 \leq x \leq 1$ or $0 < x < 1$, can be modelled. Modelling the growth of $\beta$-$Ga_2O_3$ using Ga metal and O-based growth is conventionally known (e.g., as described in Togashi et al.

(2023)). The following includes methods and examples for the growth of films using gas-phase (vapor) binary oxide sources, which are suboxide group-III sources ($Ga_2O$, $Al_2O$, $In_2O$), and atomic oxygen (O) as the oxidant. Systems that are capable of ultrahigh vacuum (UHV), such as MBE systems, and systems that use molecular organic precursors such as MOCVD and ALD, can be used to perform the following methods.

In some cases, a method includes using a set of gas-phase reactions between volatile suboxides and atomic oxygen to form a crystalline sesquioxide (i.e., an oxide in which oxygen is present in the ratio of three atoms to two of one or more other elements, such as in $Ga_2O_3$) films on a substrate. The fundamental reaction for each group-III element (e.g., M = Ga, Al, In) can be written as:

$$M_2O(g) + 2\ O(g) \rightarrow M_2O_3(s). \qquad \text{Equation 12}$$

These reactions are treated as equilibria with temperature-dependent equilibrium constants, modelled in the form:

$$\log_{10} K(T) = a + b/T + c \log_{10}(T) \qquad \text{Equation 13}$$

where K is the equilibrium constant, and a, b, c are species-specific fitting parameters derived from Gibbs free energy differences between the reactants and products.

For ternary oxide formation, two different suboxide sources ($M_2I$ and $M'_2O$) are introduced simultaneously. The relevant coupled reactions are:

$$Ga_2O(g) + 2\ O(g) \rightarrow Ga_2O_3(s) \qquad \text{Equation 14}$$

$$Al_2O(g) + 2\,O(g) \rightarrow Al_2O_3(s) \qquad \text{Equation 15}$$

$$In_2O(g) + 2\,O(g) \rightarrow In_2O_3(s) \qquad \text{Equation 16}$$

for the ternary systems:

$$(Al_xGa_{1-x})_2O_3\text{: Equation 14 + Equation 15} \qquad \text{Equation 17}$$

$$(In_xGa_{1-x})_2O_3\text{: Equation 14 + Equation 16} \qquad \text{Equation 18}$$

$$(Al_xIn_{1-x})_2O_3\text{: Equation 15 + Equation 16.} \qquad \text{Equation 19}$$

The ternary composition x is at least partially determined by the ratio of suboxide beam-equivalent pressures (BEPs) or molar fluxes:

$$x = \Phi M_2O / (\Phi M_2O + \Phi M'_2O). \qquad \text{Equation 20}$$

As part of a method to simulate ternary growth conditions, the following blocks can be performed:

1. Determine the molar fluxes $\Phi Ga_2O$, $\Phi Al_2O$, $\Phi In_2O$ from effusion cell temperatures and source vapor pressures.
2. Specify the atomic oxygen flux ($\Phi O$) from plasma power and geometry of the active oxygen source and the system.
3. For a given growth temperature T, compute $\log_{10} K(T)$ for Equation 14, Equation 15, Equation 16.
4. Solve the coupled equilibrium expressions:

$$\log_{10}(KGa) = \log_{10}(pGa_2O_3 / (pGa_2O \cdot pO^2)) \qquad \text{Equation 21}$$

$$\log_{10}(KAl) = \log_{10}(pAl_2O_3 / (pAl_2O \cdot pO^2)) \qquad \text{Equation 22}$$

$$\log_{10}(KIn) = \log_{10}(pIn_2O_2 / (pIn_2O \cdot pO^2)) \qquad \text{Equation 23}$$

5. Determine the fraction of each solid-phase oxide formed, and compute x for the ternary.

In Equations 21-23 above, "KGa" is the equilibrium constant of the reaction in Equation 14, "KAl" is the equilibrium constant of the reaction in Equation 15, "KIn" is the equilibrium constant of the reaction in Equation 16. Additionally, "$pGa_2O_3$," "$pGa_2O$," and "pO," are the respective partial pressures of $Ga_2O_3$, $Ga_2O$, and O, "$pAl_2O_3$" and "$pAl_2O$," are the respective partial pressures of $Al_2O_3$ and $Al_2O$, and "$pIn_2O_3$" and "$pIn_2O$," are the respective partial pressures of $In_2O_3$ and $In_2O$.

In addition to atomic oxygen, other oxidants such as carbon monoxide (CO), nitrous oxide ($N_2O$), and nitric oxide (NO) can also be used when growing ternary oxide films. These oxidants introduce additional complexity into the thermodynamic modelling but offer opportunities for functional doping. For example, CO and NO can oxidize $M_2O(g)$ to $M_2O_3(s)$ while incorporating C or N atoms into the film. In another example, $N_2O$ acts as a powerful oxidizer and nitrogen source simultaneously.

When these oxidants are used, the following general reaction forms apply:

$$M_2O(g) + 2\,N_2O(g) \rightarrow M_2O_3(s) + 2\,N_2(g) \qquad \text{Equation 24}$$

$$M_2O(g) + 2\,NO(g) \rightarrow M_2O_3(s) + N_2(g) \qquad \text{Equation 25}$$

$$M_2O(g) + 2\,CO(g) \rightarrow M_2O_3(s) + 2\,C(s) \qquad \text{Equation 26}$$

$$M_2O(g) + CO_2(g) \rightarrow M_2O_3(s) + C(s) \qquad \text{Equation 27}$$

The incorporation of nitrogen and carbon during growth provides an effective strategy to introduce deep acceptors. These acceptors compensate for oxygen vacancies (which otherwise contribute to n-type conductivity), enabling the realization of semi-insulating films.
This methodology provides a thermodynamic framework to model the equilibrium growth of ternary oxide systems using suboxide sources in an MBE environment. It is extensible to quaternary systems and can be calibrated using fitted K(T) values derived from NIST JANAF or NASA thermochemical data. The use of alternative oxidants such as $CO$, $N_2O$, and $NO$ opens additional pathways for doping control, enabling the synthesis of semi-insulating or compensated ternary $(Al,Ga,In)_2O_3$ materials.

CLAUSES

Clause 1. A method for generating a binary-oxide vapor precursor, comprising: containing an elemental component in an open-ended vessel comprising a closed end and a vessel wall that extends from the closed end to an open end; introducing solid binary-oxide members into the open-ended vessel to form a contained aggregate structure of the solid binary-oxide members within the vessel wall, wherein at least a portion of the solid binary-oxide members are between the elemental component and the open end of the open-ended vessel; and heating the elemental component to form an elemental vapor that travels towards the open end of the open-ended vessel, wherein on transiting towards the open end the elemental vapor reacts with the contained aggregate structure of the solid binary-oxide members to generate a binary-oxide vapor precursor.

Clause 2. The method of clause 1, wherein the elemental component corresponds to a non-oxide component of the binary-oxide vapor precursor, and wherein each of the solid binary-oxide members corresponds to a solid binary-oxide stoichiometric form of the binary-oxide vapor precursor.

Clause 3. The method of any one of clauses 1-2, further comprising emitting the binary-oxide vapor precursor from the open end of the open-ended vessel and depositing a solid oxide material on a heated substrate by reacting the binary-oxide vapor precursor with molecular oxygen to form the solid oxide material on the heated substrate.

Clause 4. The method of any one of clauses 1-3, further comprising selecting an amount of the solid binary-oxide members introduced into the open-ended vessel to satisfy a minimum amount required for the solid binary-oxide members to react completely with the elemental component to generate the binary-oxide vapor precursor.

Clause 5. The method of any one of clauses 1-4, wherein the contained aggregate structure is a close-packed column of the solid binary-oxide members extending along a portion of the open-ended vessel.

Clause 6. The method of any one of clauses 1-5, wherein the solid binary-oxide members are granules having a predetermined size distribution.

Clause 7. The method of any one of clauses 1-6, wherein the binary-oxide vapor precursor is $Ga_2O$(vapor), the elemental component is Ga, and the solid binary-oxide members are $Ga_2O_3$.

Clause 8. The method of any one of clauses 1-6, wherein the binary-oxide vapor precursor is GeO(vapor), the elemental component is Ge, and the solid binary-oxide members are $GeO_2$.

Clause 9. The method of any one of clauses 1-6, wherein the binary-oxide vapor precursor is Al2O(vapor), the elemental component is Al, and the solid binary-oxide members are $Al_2O_3$.

Clause 10. The method of any one of clauses 1-6, wherein the binary-oxide vapor precursor is SiO(vapor), the elemental component is Si, and the solid binary-oxide members are $SiO_2$.

Clause 11. The method of any one of clauses 1-6, wherein the binary-oxide vapor precursor is B2O(vapor), the elemental component is B, and the solid binary-oxide members are $B_2O_3$.

Clause 12. The method of any one of clauses 1-6, wherein the binary-oxide vapor precursor is In2O(vapor), the elemental component is In, and the solid binary-oxide members are $In_2O_3$.

Clause 13. The method of any one of clauses 1-6, wherein the binary-oxide vapor precursor is sLirO(vapor), the elemental component is Li, and the solid binary-oxide members are $Li_2O$.

Clause 14. A binary-oxide vapor source, comprising: a vessel having a closed end and an open end; a first region located adjacent to the closed end including or configured to include an elemental component; a first heater zone configured to heat the first region to produce an elemental vapor from the elemental component; and a second region located between the first region and the open end, the second region comprising or is configured to comprise: solid binary-oxide members; and spaces adjacent to the solid binary-oxide members through which the elemental vapor can pass, wherein a product of a reaction between the elemental vapor and the solid binary-oxide members is a binary-oxide vapor precursor, and wherein the solid binary-oxide members and the spaces are configured such that the binary-oxide vapor precursor formed in the spaces can exit the binary-oxide vapor source through the open end.

Clause 15. The binary-oxide vapor source of clause 14, wherein the second region comprises an aggregate structure of the solid binary-oxide members.

Clause 16. The binary-oxide vapor source of clause 15, wherein the second region of the binary-oxide vapor source comprises or is configured to comprise solid binary-oxide members comprising a plurality of members (e.g., particles, granules, spheres, rods, etc.) having a distribution of sizes, such as described by a Weibull distribution with a low b parameter, a bi-modal, or a multi-modal size distribution (i.e., smaller particles mixed with larger particles to improve packing density).

Clause 17. The binary-oxide vapor source of any one of clauses 14-16, further comprising a second heater zone configured to heat the second region.

Clause 18. The binary-oxide vapor source of any one of clauses 14-17, further comprising a third heater zone configured to heat a third region between the second region and the open end.

Clause 19. The binary-oxide vapor source of any one of clauses 14-18, wherein the solid binary-oxide members are (or an aggregate structure formed from the solid binary-oxide members is) less dense than the elemental component at an operating temperature of the binary-oxide vapor source.

Clause 20. The binary-oxide vapor source of any one of clauses 14-19, wherein the solid binary-oxide members are (or an aggregate structure formed from the solid binary-oxide members is) denser than the elemental component at an operating temperature of the binary-oxide vapor source, and wherein the first region further comprises the solid binary-oxide members.

Clause 21. The binary-oxide vapor source of any one of clauses 14-20, further comprising a first aperture located at the open end, wherein the first aperture comprises an aspect ratio and is configured to provide an emission distribution profile, an outlet working pressure, and/or an outlet working pressure difference across the first aperture.

Clause 22. The binary-oxide vapor source of any one of clauses 14-21, wherein the binary-oxide vapor precursor is $Ga_2O$(vapor), the elemental component is Ga, and the solid binary-oxide members are $Ga_2O_3$.

Clause 23. The binary-oxide vapor source of any one of clauses 14-21, wherein the binary-oxide vapor precursor is GeO(vapor), the elemental component is Ge, and the solid binary-oxide members are $GeO_2$.

Clause 24. The binary-oxide vapor source of any one of clauses 14-21, wherein the binary-oxide vapor precursor is $Al_2O$(vapor), the elemental component is Al, and the solid binary-oxide members are $Al_2O_3$.

Clause 25. The binary-oxide vapor source of any one of clauses 14-21, wherein the binary-oxide vapor precursor is SiO(vapor), the elemental component is Si, and the solid binary-oxide members are $SiO_2$.

Clause 26. The binary-oxide vapor source of any one of clauses 14-21, wherein the binary-oxide vapor precursor is $B_2O$(vapor), the elemental component is B, and the solid binary-oxide members are $B_2O_3$.

Clause 27. The binary-oxide vapor source of any one of clauses 14-21, wherein the binary-oxide vapor precursor is In2O(vapor), the elemental component is In, and the solid binary-oxide members are $In_2O_3$.

Clause 28. The binary-oxide vapor source of any one of clauses 14-21, wherein the binary-oxide vapor precursor is sLirO(vapor), the elemental component is Li, and the solid binary-oxide members are $Li_2O$.

Clause 29. A method for generating a binary-oxide vapor precursor for a deposition process, comprising: providing a binary-oxide vapor source including: a closed end and an open end; a first region located adjacent to the closed end including an elemental component; and a second region located between the first region and the open end, the second region including a contained aggregate structure comprising solid binary-oxide members and spaces through which a vapor can pass; heating the binary-oxide vapor source to form an elemental vapor from the elemental component; and reacting the elemental vapor with the solid binary-oxide members, as the elemental vapor passes through the spaces in the second region, to produce a binary-oxide vapor precursor that exits the binary-oxide vapor source through the open end.

Clause 30. The method of clause 29, wherein the elemental component corresponds to a non-oxide component of the binary-oxide vapor precursor, and wherein each of the solid binary-oxide members corresponds to a solid binary-oxide stoichiometric form of the binary-oxide vapor precursor.

Clause 31. The method of any one of clauses 29-30, further comprising depositing a solid oxide material on a heated substrate by reacting the binary-oxide vapor precursor with molecular oxygen to form the solid oxide material on the heated substrate.

Clause 32. The method of any one of clauses 29-31, wherein an amount of the solid binary-oxide members in the binary-oxide vapor source satisfies a minimum amount required for the solid binary-oxide members to react completely with the elemental component to generate the binary-oxide vapor precursor.

Clause 33. The method of any one of clauses 29-32, wherein the second region further comprises a close-packed column of the solid binary-oxide members extending along a portion of the binary-oxide vapor source.

Clause 34. The method of any one of clauses 29-33, wherein the solid binary-oxide members are granules having a predetermined size distribution.

Clause 35. The method of any one of clauses 29-34, wherein the binary-oxide vapor precursor is $Ga_2O$(vapor), the elemental component is Ga, and the solid binary-oxide members are $Ga_2O_3$.

Clause 36. The method of any one of clauses 29-34, wherein the binary-oxide vapor precursor is GeO(vapor), the elemental component is Ge, and the solid binary-oxide members are $GeO_2$.

Clause 37. The method of any one of clauses 29-34, wherein the binary-oxide vapor precursor is $Al_2O$(vapor), the elemental component is Al, and the solid binary-oxide members are $Al_2O_3$.

Clause 38. The method of any one of clauses 29-34, wherein the binary-oxide vapor precursor is SiO(vapor), the elemental component is Si, and the solid binary-oxide members are $SiO_2$.

Clause 39. The method of any one of clauses 29-34, wherein the binary-oxide vapor precursor is $B_2O$(vapor), the elemental component is B, and the solid binary-oxide members are $B_2O_3$.

Clause 40. The method of any one of clauses 29-34, wherein the binary-oxide vapor precursor is $In_2O(vapor)$, the elemental component is In, and the solid binary-oxide members are $In_2O_3$.

Clause 41. The method of any one of clauses 29-34, wherein the binary-oxide vapor precursor is $sLi_xO(vapor)$, the elemental component is Li, and the solid binary-oxide members are $Li_2O_3$.

Clause 42. A material deposition system, comprising: a binary-oxide vapor source, comprising: a closed end and an open end; a first region located adjacent to the closed end including or configured to include an elemental component; a first heater zone configured to heat the first region to produce an elemental vapor from the elemental component; and a second region located between the first region and the open end, the second region comprising or is configured to comprise solid binary-oxide members and spaces adjacent to the solid binary-oxide members through which the elemental vapor can pass, wherein a product of a reaction between the elemental vapor and the solid binary-oxide members is a binary-oxide vapor precursor; and a growth chamber coupled to the open end of the binary-oxide vapor source; wherein the binary-oxide vapor precursor can exit the open end of the binary-oxide vapor source and enter the growth chamber.

Clause 43. The material deposition system of clause 42, wherein the growth chamber comprises a partial pressure of molecular oxygen or an active oxygen species that can react with the binary-oxide vapor precursor that is below an amount that would cause a significant amount of oxide condensate to form at the open end of the binary-oxide vapor source for a given base temperature of the binary-oxide vapor source.

Clause 44. The material deposition system of any of clauses 42-43, further comprising a condensation reduction arrangement comprising an inlet to the binary-oxide vapor source, the inlet configured to introduce an inert carrier gas into the binary-oxide vapor source and form a curtain or region of the inert carrier gas at the open end of the binary-oxide vapor source to displace oxygen species that can react with the binary-oxide vapor precursor to form an oxide condensate at the open end of the binary-oxide vapor source.

Clause 45. The material deposition system of any of clauses 42-44, wherein a partial pressure of oxygen species is below $10^{-5}$ Torr or is below $10^{-4}$ Torr, for a vapor source base temperature from 500°C to 1100°C.

Clause 46. The material deposition system of any of clauses 42-45, further comprising a heater configured to radiatively heat a substrate, wherein the substrate is located inside the growth chamber.

Clause 47. The material deposition system of any of clauses 42-46, further comprising a pump coupled to the growth chamber.

Clause 48. The material deposition system of any of clauses 42-47, wherein the growth chamber is configured as a vacuum chamber, and wherein an open end of the binary-oxide vapor source is inside or at a boundary of the growth chamber.

Clause 49. The material deposition system of any of clauses 42-47, wherein the growth chamber is configured as a vacuum chamber, and wherein the binary-oxide vapor source is configured as a remote source that is coupled to the growth chamber through a conduit.

Clause 50. The material deposition system of any of clauses 42-47, wherein the growth chamber is configured as a tube and the material deposition system further comprises radiative heaters located outside of the tube, and wherein the binary-oxide vapor source is configured as a remote source that is coupled to the growth chamber through a conduit.

Clause 51. The material deposition system of any of clauses 49-50, further comprising a carrier gas inlet, wherein the carrier gas inlet is configured such that a carrier gas can be introduced into the binary-oxide vapor source and transport the binary-oxide vapor precursor from the binary-oxide vapor source to the growth chamber through the conduit.

Clause 52. The material deposition system of clause 50, further comprising a mixer, wherein the mixer is configured such that a carrier gas and the binary-oxide vapor precursor can be introduced into the mixer and a mixture of carrier gas and the binary-oxide vapor precursor be transported from the binary-oxide vapor source to the growth chamber through the conduit.

Clause 53. The material deposition system of any of clauses 42-52, further comprising a second binary-oxide vapor source coupled to the growth chamber.

Clause 54. The material deposition system of any of clauses 42-53, further comprising an elemental or molecular source coupled to the growth chamber.

In some cases, a single embodiment may, for succinctness and/or to assist in understanding the scope of the disclosure, combine multiple features. It is to be understood that in such a case, these multiple features may be provided separately (in separate embodiments), or in any other suitable combination. Alternatively, where separate features are described in separate embodiments, these separate features may be combined into a single embodiment unless otherwise stated or implied. This also applies to the claims which can be recombined in any combination. That is, a claim may be amended to include a feature defined in any other claim. Furthermore, a phrase referring to "at least one of" a list of items refers to any combination of those items, including single members. As an example, "at least one of: a, b, or c" is intended to cover: a, b, c, a-b, a-c, b-c, and a-b-c.

Reference has been made in detail to embodiments of the disclosed invention, one or more examples of which have been illustrated in the accompanying figures. Each example has been provided by way of explanation of the present technology, not as a limitation of the present technology. In fact, while the specification has been described in detail with respect to specific embodiments of the invention, it will be appreciated that those skilled in the art, upon attaining an understanding of the foregoing, may readily conceive of alterations to, variations of, and equivalents to these embodiments. For instance, features illustrated or described as part of one embodiment may be used with another embodiment to yield a still further embodiment. Thus, it is intended that the present subject matter covers all such modifications and variations within the scope of the appended claims and their equivalents. These and other modifications and variations to the present invention may be practiced by those of ordinary skill in the art, without departing from the scope of the present invention, which is more particularly set forth in the appended claims. Furthermore, those of ordinary skill in the art will appreciate that the foregoing description is by way of example only and is not intended to limit the invention.

**Claims**

1. A method for generating a binary-oxide vapor precursor for a deposition process, comprising:

   providing a binary-oxide vapor source including:

   a closed end and an open end;
   a first region located adjacent to the closed end including an elemental component; and
   a second region located between the first region and the open end, the second region including a contained aggregate structure comprising solid binary-oxide members and spaces through which a vapor can pass;

   heating the binary-oxide vapor source to form an elemental vapor from the elemental component; and
   reacting the elemental vapor with the solid binary-oxide members, as the elemental vapor passes through the spaces in the second region, to produce a binary-oxide vapor precursor that exits the binary-oxide vapor source through the open end.

2. The method of claim 1, wherein the elemental component corresponds to a non-oxide component of the binary-oxide vapor precursor, and wherein each of the solid binary-oxide members corresponds to a solid binary-oxide stoichiometric form of the binary-oxide vapor precursor.

3. The method of any one of claims 1-2, further comprising depositing a solid oxide material on a heated substrate by reacting the binary-oxide vapor precursor with molecular oxygen to form the solid oxide material on the heated substrate.

4. The method of any one of claims 1-3, wherein an amount of the solid binary-oxide members in the binary-oxide vapor source satisfies a minimum amount required for the solid binary-oxide members to react completely with the elemental component to generate the binary-oxide vapor precursor.

5. The method of any one of claims 1-4, wherein the second region further comprises a close-packed column of the solid binary-oxide members extending along a portion of the binary-oxide vapor source.

6. The method of any one of claims 1-5, wherein the solid binary-oxide members are granules having a predetermined size distribution.

7. The method of any one of claims 1-6, wherein the binary-oxide vapor precursor is $Ga_2O(vapor)$, the elemental component is Ga, and the solid binary-oxide members are $Ga_2O_3$.

8. The method of any one of claims 1-6, wherein the binary-oxide vapor precursor is $GeO(vapor)$, the elemental component is Ge, and the solid binary-oxide members are $GeO_2$.

9. The method of any one of claims 1-6, wherein the binary-oxide vapor precursor is $Al_2O(vapor)$, the elemental component is Al, and the solid binary-oxide members are $Al_2O_3$.

10. The method of any one of claims 1-6, wherein the binary-oxide vapor precursor is $SiO(vapor)$, the elemental component is Si, and the solid binary-oxide members are $SiO_2$.

11. The method of any one of claims 1-6, wherein the binary-oxide vapor precursor is $B_2O(vapor)$, the elemental

component is B, and the solid binary-oxide members are $B_2O_3$.

12. The method of any one of claims 1-6, wherein the binary-oxide vapor precursor is $In_2O(vapor)$, the elemental component is In, and the solid binary-oxide members are $In_2O_3$.

13. The method of any one of claims 1-6, wherein the binary-oxide vapor precursor is $sLi_rO(vapor)$, the elemental component is Li, and the solid binary-oxide members are $Li_2O_3$.

**FIG. 1**

200

**FIG. 2**

**FIG. 3**

**FIG. 4**

**FIG. 5A**

**FIG. 5B**

**FIG. 6A**

**FIG. 6B**

**FIG. 6C**

**FIG. 6D**

**FIG. 6E**

700

**FIG. 7**

**FIG. 8A**

**FIG. 8B**

FIG.9A

FIG. 9B

FIG. 9C

EP 4 663 809 A2

**FIG. 10A**   **FIG. 10B**   **FIG. 10C**

**FIG. 11A**    **FIG. 11B**    **FIG. 11C**

EP 4 663 809 A2

$\phi_{SiO}^{in}=2.5284e-08, T_{SiO}^{base}=850^{o}C$

$\phi_{SiO}^{in}=1.2802e-07, T_{SiO}^{base}=900^{o}C$

$\phi_{SiO}^{in}=5.6827e-07, T_{SiO}^{base}=950^{o}C$

1210

1230

1250

1215

1220

**FIG. 12A**

**FIG. 12B**

**FIG. 12C**

1310

$\phi_{B_2O_2}^{in} = 4.2431e-08, T_{B_2O_2}^{base} = 900^oC$

1315    1320

$B_2O_{2(g)}$
$B_2O_{(g)}$
$O_{2(g)}$

$P_i$ torr

Growth Chamber $\phi(O_{2(g)})$ torr

FIG. 13A

1330

$\phi_{B_2O_2}^{in} = 2.5771e-07, T_{B_2O_2}^{base} = 950^oC$

1315    1320

$B_2O_{2(g)}$
$B_2O_{(g)}$
$O_{2(g)}$

$P_i$ torr

Growth Chamber $\phi(O_{2(g)})$ torr

FIG. 13B

1350

$\phi_{B_2O_2}^{in} = 1.3632e-06, T_{B_2O_2}^{base} = 1000^oC$

1315    1320

$B_2O_{2(g)}$
$B_2O_{(g)}$
$O_{2(g)}$

$P_i$ torr

Growth Chamber $\phi(O_{2(g)})$ torr

FIG. 13C

**FIG. 14A**          **FIG. 14B**          **FIG. 14C**

**FIG. 15A**

**FIG. 15B**

**FIG. 15C**

FIG. 16A

EP 4 663 809 A2

1602

**F=0.4  $\phi(Ga_2O)_{in}$=1e-06torr  excess%=10000**

**FIG. 16B**

$$In_2O + xO_2 \rightarrow In_2O_3$$

FIG. 16C

EP 4 663 809 A2

$$Me_2O + xO_2 \rightarrow Me_2O_3$$

FIG. 16D

EP 4 663 809 A2

**FIG. 17**

**FIG. 18A**

1801

1820D

1820D

612

1820D

1820D

**FIG. 18B**

1805

1820I

1820G

1820E

1840

1820J

1842

1820H

1803

1820F

**FIG. 18C**

**FIG. 19**

EP 4 663 809 A2

**FIG. 20**

**FIG. 21**

2200

2210

Contain an elemental component in an open-ended vessel

2220

Introduce solid binary-oxide members into vessel

2230

Heat elemental component to generate the binary-oxide vapor

**FIG. 22**

tilt=40°, h$_{c0}$ fill=42.35mm, %fill=50%, R$_C$=12.5, L$_{Body}$=84.7mm, Vol=21cc

**FIG. 23A**

tilt=40°, h$_{c0}$ fill=42.35mm, %fill=50%, R$_C$=12.5, L$_{Body}$=84.7mm, Vol=21cc

**FIG. 23B**

tilt=0°, center line fill=30.8, %fill=23.993%, R$_C$=3.65 L$_{Body}$=61.6, Vol=3320.392:

**FIG. 23C**

2320

2326

tilt=0°, center line fill=30.8, %fill=23.993%, R$_C$=3.65 L$_{Body}$=61.6, Vol=3320.392:

**FIG. 23D**

2320

2326

$h_{body}$

$h_{fill} = 0.5 h_{body}$

FIG. 24

**FIG. 25**

FIG. 26A

FIG. 26B

FIG. 26C

**FIG. 27**

2800a

2810

2850

2860

2830

2840

2820

**FIG. 28A**

2800b

2810

2850

2860

2830

2840

2860

2820

**FIG. 28B**

**FIG. 28C**

2900

2910

Provide binary-oxide vapor source

2920

Heat binary-oxide vapor source

**FIG. 29**

3000c

3010

3080c        3080c

3020

3080b        3080b

2850

3080a        3080a

2830

X120

**FIG. 30**

**FIG. 31**

**FIG. 32**

**Ga$_2$O Flux $\phi$ versus Cell Temperature**

**FIG. 33**

**Ga$_2$O Cell Arrhenius Plot**

**FIG. 34**

FIG. 35

**Thickness (Å)**

3600

| Color | Range |
|---|---|
| | 15162.74 - 15259.31 |
| | 15066.18 - 15162.74 |
| | 14969.61 - 15066.18 |
| | 14873.04 - 14969.61 |
| | 14776.48 - 14873.04 |
| | 14679.91 - 14776.48 |
| | 14583.35 - 14679.91 |
| | 14486.78 - 14583.35 |
| | 14390.22 - 14486.78 |
| | 14293.65 - 14390.22 |
| | 14197.09 - 14293.65 |
| | 14100.52 - 14197.09 |

| | | | |
|---|---|---|---|
| Average = 14588.72 | Std. Dev = 306.16 | Minimum = 14100.52 | Maximum = 15259.31 |
| Median = 14625.12 | Q. Range = 489.77 | 10 % = 14150.69 | 90 % = 15004.33 |

**FIG. 36**

EP 4 663 809 A2

## Thickness (Å)

Legend (thickness ranges):
- 11270.52 – 11426.13
- 11114.91 – 11270.52
- 10959.30 – 11114.91
- 10803.69 – 10959.30
- 10648.08 – 10803.69
- 10492.47 – 10648.08
- 10336.87 – 10492.47
- 10181.26 – 10336.87
- 10025.65 – 10181.26
- 9870.04 – 10025.65
- 9714.43 – 9870.04
- 9558.82 – 9714.43

| Average = 10421.71 | Std. Dev = 478.16 | Minimum = 9558.82 | Maximum = 11426.13 |
| Median = 10438.97 | Q. Range = 838.78 | 10 % = 9752.98 | 90 % = 11052.89 |

**FIG. 37**

EP 4 663 809 A2

$x.Al_2O_{(g)} + (1-x).Ga_2O_{(g)} + yO^*$

FIG. 38

$x.Al_2O_{(g)} + (1-x).Ga_2O_{(g)} + yO^*$

FIG. 39

**FIG. 40**

**REFERENCES CITED IN THE DESCRIPTION**

**Patent documents cited in the description**

- US 20694225
- US 63651749
- US 11342484 B
- US 12087880 B